(19) Europäisches Patentamt
European Patent Office
Office européen des brevets

(11) EP 4 110 884 B1

(12) **EUROPÄISCHE PATENTSCHRIFT**

(45) Veröffentlichungstag und Bekanntmachung des Hinweises auf die Patenterteilung:
**20.11.2024 Patentblatt 2024/47**

(21) Anmeldenummer: **21706940.0**

(22) Anmeldetag: **22.02.2021**

(51) Internationale Patentklassifikation (IPC):
***C09K 11/06*** (2006.01) ***H10K 50/11*** (2023.01)
***H10K 50/16*** (2023.01) ***H10K 50/18*** (2023.01)
***H10K 85/60*** (2023.01) ***H10K 101/10*** (2023.01)
***H10K 101/00*** (2023.01)

(52) Gemeinsame Patentklassifikation (CPC):
**C09K 11/06; H10K 85/649;** C09K 2211/1011; C09K 2211/1014; C09K 2211/1029; C09K 2211/1044; C09K 2211/1059; C09K 2211/1066; C09K 2211/1088; C09K 2211/1092; C09K 2211/185; H10K 50/11; H10K 50/16; H10K 50/18; H10K 85/342; (Forts.)

(86) Internationale Anmeldenummer:
**PCT/EP2021/054276**

(87) Internationale Veröffentlichungsnummer:
**WO 2021/170522 (02.09.2021 Gazette 2021/35)**

(54) **VERWENDUNG VON HETEROCYCLISCHEN VERBINDUNGEN IN EINER ORGANISCHEN ELEKTRONISCHEN VORRICHTUNG**

USE OF HETEROCYCLIC COMPOUNDS IN AN ORGANIC ELECTRONIC DEVICE

UTILISATION DE COMPOSÉS HÉTÉROCYCLIQUES DANS UN DISPOSITIF ÉLECTRONIQUE ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.02.2020 EP 20159402**

(43) Veröffentlichungstag der Anmeldung:
**04.01.2023 Patentblatt 2023/01**

(73) Patentinhaber: **Merck Patent GmbH**
**64293 Darmstadt (DE)**

(72) Erfinder: **STOESSEL, Philipp**
**64293 Darmstadt (DE)**

(74) Vertreter: **Merck Patent Association**
**Merck Patent GmbH**
**64271 Darmstadt (DE)**

(56) Entgegenhaltungen:
**US-A- 4 539 507**

- **SCHÖBEL JAN-HENDRIK ET AL: "Mechanochemical Synthesis of 1,2,6-Thiadiazine 1-Oxides from Sulfonimidamides and the Fluorescence Properties of the Products", THE JOURNAL OF ORGANIC CHEMISTRY, vol. 85, no. 23, 4 December 2020 (2020-12-04), pages 15760 - 15766, XP055797737, ISSN: 0022-3263, DOI: 10.1021/acs.joc.0c02599**
- **BOHMANN REBEKKA ANNA ET AL: "1,2-Thiazines: One-Pot Syntheses Utilizing Mono and Diaza Analogs of Sulfones", CHEMISTRY - A EUROPEAN JOURNAL, vol. 22, no. 20, 10 May 2016 (2016-05-10), pages 6783 - 6786, XP055797732, ISSN: 0947-6539, Retrieved from the Internet <URL:https://api.wiley.com/onlinelibrary/tdm/v1/articles/10.1002%2Fchem.201600725> DOI: 10.1002/chem.201600725**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- **KONG Y C ET AL: "Reactions of (Aryl)(chloro)methyl p-Tolyl Sulfoxides with Tetrasulfur Tetranitride (S"4N"4): Formation and Characterization of 3,5-Diaryl-1,2,4,6-thiatriazine 1-Oxides", TETRAHEDRON, ELSEVIER SIENCE PUBLISHERS, AMSTERDAM, NL, vol. 56, no. 37, 8 September 2000 (2000-09-08), pages 7153 - 7161, XP004211826, ISSN: 0040-4020, DOI: 10.1016/S0040-4020(00)00632-3**
- **CHIVERS TRISTRAM ET AL: "Eight- and 16-Membered Cyanuric-Sulfanuric Ring Systems: C 2 N 4 S 2 -> C 2 N 3 S Ring Contraction", INORGANIC CHEMISTRY, vol. 39, no. 8, 1 April 2000 (2000-04-01), Easton , US, pages 1697 - 1704, XP055797743, ISSN: 0020-1669, DOI: 10.1021/ic991314u**
- **WILLIAMS TODD R. ET AL: "New ring systems of carbon, nitrogen, and chiral sulfur", JOURNAL OF THE AMERICAN CHEMICAL SOCIETY, vol. 93, no. 26, 1 December 1971 (1971-12-01), US, pages 7333 - 7335, XP055797752, ISSN: 0002-7863, DOI: 10.1021/ja00755a045**
- **GOERDELER J ET AL: "UEBER SULFINSAEUREAMIDINE, ÖII 2) DARSTELLUNG EINES 1H-1.2.4.6-THIATRIAZINS MIT TERTRIAERER AMINOGRUPPE", CHEMISCHE BERICHTE, VCH, DE, vol. 95, 1 January 1962 (1962-01-01), pages 154 - 157, XP000573909, ISSN: 0009-2940**


(52) Gemeinsame Patentklassifikation (CPC): (Forts.)
H10K 85/6572; H10K 85/6574; H10K 2101/10; H10K 2101/90; Y02E 10/549

## Beschreibung

Die vorliegende Erfindung beschreibt die Verwendung von heterocyclischen Verbindungen in einer organischen elektronischen Vorrichtung. Die Erfindung betrifft ferner neue heterocyclische Verbindungen und Verfahren zur Herstellung der erfindungsgemäßen Verbindungen sowie elektronische Vorrichtungen enthaltend diese Verbindungen.

Der Aufbau organischer Elektrolumineszenzvorrichtungen, in denen organische Halbleiter als funktionelle Materialien eingesetzt werden, ist beispielsweise in US 4539507, US 5151629, EP 0676461, WO 98/27136 und WO 2010/151006 A1 beschrieben. Als emittierende Materialien werden häufig metallorganische Komplexe eingesetzt, die Phosphoreszenz zeigen. Aus quantenmechanischen Gründen ist unter Verwendung metallorganischer Verbindungen als Phosphoreszenzemitter eine bis zu vierfache Energie- und Leistungseffizienz möglich. Generell gibt es bei Elektrolumineszenzvorrichtungen, insbesondere auch bei Elektrolumineszenzvorrichtungen, die Phosphoreszenz zeigen, immer noch Verbesserungsbedarf, beispielsweise im Hinblick auf Effizienz, Betriebsspannung und Lebensdauer.

Die Eigenschaften organischer elektrolumineszierender Vorrichtungen werden nicht nur durch die eingesetzten Emitter bestimmt. Hier sind insbesondere auch die anderen verwendeten Materialien, wie Host-/Matrixmaterialien, Lochblockiermaterialien, Elektronentransportmaterialien, Lochtransportmaterialien und Elektronen- bzw. Exzitonenblockiermaterialien von besonderer Bedeutung. Verbesserungen dieser Materialien können zu deutlichen Verbesserungen elektrolumineszierender Vorrichtungen führen.

US 4539507 beschreibt zum Beispiel die Verwendung von Benzoxazol- oder Benzothiazolderivaten als Elektronentransportverbindungen in organischen Elektrolumineszenzverbindungen.

Generell besteht bei diesen Materialien, beispielsweise für die Verwendung als Emitter, vorzugsweise als fluoreszreszierender Emitter, als Matrixmaterialien, Lochtransportmaterialien oder Elektronentransportmaterialien noch Verbesserungsbedarf, insbesondere in Bezug auf die Lebensdauer, aber auch in Bezug auf die Effizienz und die Betriebsspannung der Vorrichtung. Ferner sollten die Verbindungen eine hohe Farbreinheit aufweisen.

Aufgabe der vorliegenden Erfindung ist daher die Bereitstellung von Verbindungen, welche sich für den Einsatz in einer organischen elektronischen Vorrichtung, insbesondere in einer organischen Elektrolumineszenzvorrichtung, eignen und welche bei Verwendung in dieser Vorrichtung zu guten Device-Eigenschaften führen, sowie die Bereitstellung der entsprechenden elektronischen Vorrichtung.

Insbesondere ist es die Aufgabe der vorliegenden Erfindung, Verbindungen zur Verfügung zu stellen, die zu hoher Lebensdauer, guter Effizienz und geringer Betriebsspannung führen. Gerade auch die Eigenschaften der Matrixmaterialien, der Lochtransportmaterialien oder der Elektronentransportmaterialien haben einen wesentlichen Einfluss auf die Lebensdauer und die Effizienz der organischen Elektrolumineszenzvorrichtung.

Eine weitere Aufgabe der vorliegenden Erfindung kann darin gesehen werden, Verbindungen bereitzustellen, welche sich für den Einsatz in einer phosphoreszierenden oder fluoreszierenden Elektrolumineszenzvorrichtungen eignen, insbesondere als Matrixmaterial. Insbesondere ist es eine Aufgabe der vorliegenden Erfindung, Matrixmaterialien bereitzustellen, welche sich für rot, gelb und blau phosphoreszierende Elektrolumineszenzvorrichtungen eignen.

Weiterhin sollten die Verbindungen, insbesondere bei ihrem Einsatz als Matrixmaterialien, als Lochtransportmaterialien oder als Elektronentransportmaterialien in organischen Elektrolumineszenzvorrichtung zu Vorrichtungen führen, die eine ausgezeichnete Farbreinheit aufweisen.

Weiterhin sollten sich die Verbindungen möglichst einfach verarbeiten lassen, insbesondere eine gute Löslichkeit und Filmbildung zeigen. Beispielsweise sollten die Verbindungen eine erhöhte Oxidationsstabilität und eine verbesserte Glasübergangstemperatur zeigen.

Eine weitere Aufgabe kann darin gesehen werden, elektronische Vorrichtungen mit einer ausgezeichneten Leistungsfähigkeit möglichst kostengünstig und in konstanter Qualität bereitzustellen.

Weiterhin sollten die elektronischen Vorrichtungen für viele Zwecke eingesetzt oder angepasst werden können. Insbesondere sollte die Leistungsfähigkeit der elektronischen Vorrichtungen über einen breiten Temperaturbereich erhalten bleiben.

Überraschend wurde gefunden, dass bestimmte, nachfolgend näher beschriebene Verbindungen diese Aufgaben lösen und den Nachteil aus dem Stand der Technik beseitigen. Die Verwendung der Verbindungen führt zu sehr guten Eigenschaften organischer elektronischer Vorrichtungen, insbesondere von organischen Elektrolumineszenzvorrichtungen, insbesondere hinsichtlich der Lebensdauer, der Effizienz und der Betriebsspannung. Elektronische Vorrichtungen, insbesondere organische Elektrolumineszenzvorrichtungen, welche derartige Verbindungen enthalten, sowie die entsprechenden bevorzugten Ausführungsformen sind daher Gegenstand der vorliegenden Erfindung.

Gegenstand der vorliegenden Erfindung ist daher eine Verwendung einer Verbindung umfassend mindestens eine Struktur der Formel (I), vorzugsweise einer Verbindung gemäß Formel (I),

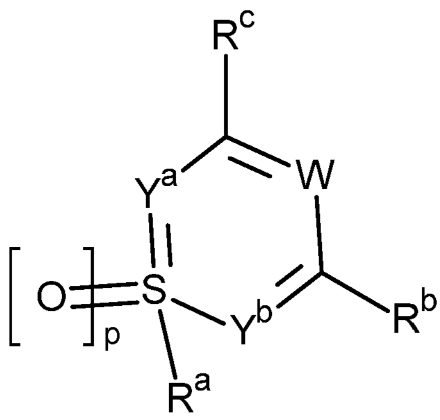

Formel (I)

wobei gilt:

W ist CR, N, $SR^a$ oder $S(=O)R^a$;

$Y^a$, $Y^b$ steht gleich oder verschieden für CR oder N;

p ist 0 oder 1, mit der Maßgabe, dass p=1 ist, falls die Gruppen W, $Y^a$, $Y^b$ jeweils für CR stehen;

$R^a$, $R^b$, $R^c$ ist gleich oder verschieden $N(Ar')_2$, $N(R^1)_2$ oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 60 aromatischen Ringatomen, die durch einen oder mehrere Reste $R^1$ substituiert sein kann; dabei können die Reste $R^a$, $R^b$, $R^c$ mit einer weiteren Gruppe ein Ringsystem bilden;

R ist bei jedem Auftreten gleich oder verschieden H, D, OH, F, Cl, Br, I, CN, $NO_2$, $N(Ar')_2$, $N(R^1)_2$, $C(=O)N(Ar')_2$, $C(=O)N(R^1)_2$, $C(Ar')_3$, $C(R^1)_3$, $Si(Ar')_3$, $Si(R^1)_3$, $B(Ar')_2$, $B(R^1)_2$, $C(=O)Ar'$, $C(=O)R^1$, $P(=O)(Ar')_2$, $P(=O)(R^1)_2$, $P(Ar')_2$, $P(R^1)_2$, $S(=O)Ar'$, $S(=O)R^1$, $S(=O)_2Ar'$, $S(=O)_2R^1$, $OSO_2Ar'$, $OSO_2R^1$, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten $R^1$ substituiert sein kann, wobei eine oder mehrere nicht benachbarte $CH_2$-Gruppen durch $R^1C=CR^1$, C=C, $Si(R^1)_2$, C=O, C=S, C=Se, $C=NR^1$, -C(=O)O-, $-C(=O)NR^1-$, $NR^1$, $P(=O)(R^1)$, -O-, -S-, SO oder $SO_2$ ersetzt sein können, oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 60 aromatischen Ringatomen, die durch einen oder mehrere Reste $R^1$ substituiert sein kann; dabei können zwei Reste R auch miteinander oder einer weiteren Gruppe, beispielsweise mit einem oder mehreren der Reste $R^a$, $R^b$, $R^c$ ein Ringsystem bilden;

Ar' ist bei jedem Auftreten gleich oder verschieden ein aromatisches oder heteroaromatisches Ringsystem mit 5 bis 60 aromatischen Ringatomen, das mit einem oder mehreren Resten $R^1$ substituiert sein kann, dabei können zwei Reste Ar', welche an dasselbe C-Atom, Si-Atom, N-Atom, P-Atom oder B-Atom binden, auch durch eine Einfachbindung oder eine Brücke, ausgewählt aus $B(R^1)$, $C(R^1)_2$, $Si(R^1)_2$, C=O, $C=NR^1$, $C=C(R^1)_2$, O, S, S=O, $SO_2$, $N(R^1)$, $P(R^1)$ und $P(=O)R^1$, miteinander verbrückt sein;

$R^1$ ist bei jedem Auftreten gleich oder verschieden H, D, F, Cl, Br, I, CN, $NO_2$, $N(Ar'')_2$, $N(R^2)_2$, $C(=O)Ar''$, $C(=O)R^2$, $P(=O)(Ar'')_2$, $P(Ar'')_2$, $B(Ar'')_2$, $B(R^2)_2$, $C(Ar'')_3$, $C(R^2)_3$, $Si(Ar'')_3$, $Si(R^2)_3$, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen oder eine Alkenylgruppe mit 2 bis 40 C-Atomen, die jeweils mit einem oder mehreren Resten $R^2$ substituiert sein kann, wobei eine oder mehrere nicht benachbarte $CH_2$-Gruppen durch - $R^2C=CR^2$-, -C=C-, $Si(R^2)_2$, C=O, C=S, C=Se, $C=NR^2$, -C(=O)O-, $-C(=O)NR^2-$, $NR^2$, $P(=O)(R^2)$, -O-, -S-, SO oder $SO_2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen

Ringatomen, die durch einen oder mehrere Reste $R^2$ substituiert sein kann, oder eine Aralkyl- oder Heteroaralkylgruppe mit 5 bis 60 aromatischen Ringatomen, die mit einem oder mehreren Resten $R^2$ substituiert sein kann, oder eine Kombination dieser Systeme; dabei können zwei oder mehrere, vorzugsweise benachbarte Reste $R^1$ miteinander ein Ringsystem bilden, dabei können einer oder mehrere Reste $R^1$ mit einem weiteren Teil der Verbindung ein Ringsystem bilden;

Ar" ist bei jedem Auftreten gleich oder verschieden ein aromatisches oder heteroaromatisches Ringsystem mit 5 bis 30 aromatischen Ringatomen, das mit einem oder mehreren Resten $R^2$ substituiert sein kann, dabei können zwei Reste Ar", welche an dasselbe C-Atom, Si-Atom, N-Atom, P-Atom oder B-Atom binden, auch durch eine Einfachbindung oder eine Brücke, ausgewählt aus $B(R^2)$, $C(R^2)_2$, $Si(R^2)_2$, C=O, $C=NR^2$, $C=C(R^2)_2$, O, S, S=O, $SO_2$, $N(R^2)$, $P(R^2)$ und $P(=O)R^2$, miteinander verbrückt sein;

$R^2$ ist bei jedem Auftreten gleich oder verschieden ausgewählt aus der Gruppe bestehend aus H, D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann, dabei können zwei oder mehrere, vorzugsweise benachbarte Substituenten $R^2$ miteinander ein Ringsystem bilden;

in einer organischen elektronischen Vorrichtung.

Vorzugsweise können die vorliegenden Verbindungen als aktive Verbindung in elektronischen Vorrichtungen eingesetzt werden. Aktive Verbindungen sind generell die organischen oder anorganischen Materialien, welche beispielsweise in einer organischen elektronischen Vorrichtung, insbesondere in einer organischen Elektrolumineszenzvorrichtung zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Hierbei sind organische Materialien bevorzugt.

Vorzugsweise ist eine erfindungsgemäß einzusetzende Verbindung eine rein organische Verbindung. Eine rein organische Verbindung ist eine Verbindung, die nicht mit einem Metallatom in Verbindung steht, also weder mit einem Metallatom eine Koordinationsverbindung bildet, noch mit einem Metallatom eine kovalente Bindung ausbildet. Hierbei umfasst eine rein organische Verbindung vorzugsweise kein Metallatom, welches in Phosphoreszenzemittern eingesetzt werden. Diese Metalle, wie Kupfer, Molybdän, usw. insbesondere Rhenium, Ruthenium, Osmium, Rhodium, Iridium, Palladium und Platin werden später ausführlich dargestellt.

Die Verbindung, die einer organischen elektronischen Vorrichtung als aktive Verbindung einsetzbar ist, kann bevorzugt ausgewählt sein aus der Gruppe bestehend aus fluoreszierenden Emittern, phosphoreszierenden Emittern, Emittern, die TADF (thermally activated delayed fluorescence) zeigen, Hostmaterialien, Elektronentransportmaterialien, Excitonenblockiermaterialien, Elektroneninjektionsmaterialien, Lochtransportmaterialien, Lochinjektionsmaterialien, n-Dotanden, p-Dotanden, Wide-Band-Gap-Materialien, Elektronenblockiermaterialien und/oder Lochblockiermaterialien. Hierbei sind fluoreszierende Emitter, Emitter, die TADF (thermally activated delayed fluorescence) zeigen, Hostmaterialien, Elektronentransportmaterialien, Excitonenblockiermaterialien, Elektroneninjektionsmaterialien, Lochtransportmaterialien, Lochinjektionsmaterialien, n-Dotanden, p-Dotanden, Wide-Band-Gap-Materialien, Elektronenblockiermaterialien und/oder Lochblockiermaterialien bevorzugt. Speziell bevorzugt wird die zuvor dargelegte Verbindung umfassend Strukturen gemäß Formel (I), bevorzugt Verbindungen gemäß Formel (I) als Hostmaterial, Elektronentransportmaterial und/oder Lochblockiermaterial eingesetzt, besonders bevorzugt als Hostmaterial für phosphoreszierende Emitter und speziell bevorzugt als Hostmaterial für blau phosphoreszierende Emitter. Benachbarte Kohlenstoffatome im Sinne der vorliegenden Erfindung sind Kohlenstoffatome, die direkt miteinander verknüpft sind. Weiterhin bedeutet "benachbarte Reste" in der Definition der Reste, dass diese Reste an dasselbe Kohlenstoffatom oder an benachbarte Kohlenstoffatome gebunden sind. Diese Definitionen gelten entsprechend unter anderem für die Begriffe "benachbarte Gruppen" und "benachbarte Substituenten".

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

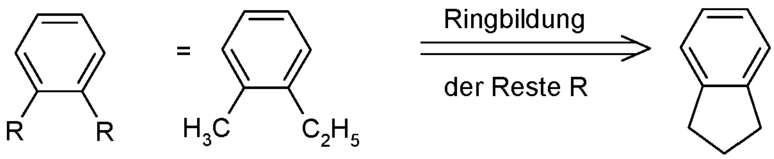


Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

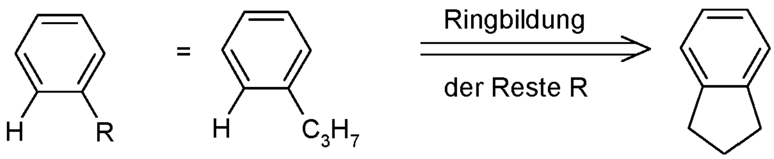


Eine kondensierte Arylgruppe, ein kondensiertes aromatisches Ringsystem oder ein kondensiertes heteroaromatisches Ringsystem im Sinne der vorliegenden Erfindung ist eine Gruppe, in der zwei oder mehr aromatische Gruppen über eine gemeinsame Kante aneinander ankondensiert, d. h. anelliert, sind, so dass beispielsweise zwei C-Atome zu den mindenstens zwei aromatischen oder heteroaromatischen Ringen zugehören, wie beispielsweise im Naphthalin. Dagegen ist beispielsweise Fluoren keine kondensierte Arylgruppe im Sinne der vorliegenden Erfindung, da im Fluoren die beiden aromatischen Gruppen keine gemeinsame Kante aufweisen. Entsprechende Definitionen gelten für Heteroarylgruppen sowie für kondensierte Ringsysteme, die auch Heteroatome enthalten können, jedoch nicht müssen.

Falls zwei oder mehrere, vorzugsweise benachbarte Reste R, $R^1$ und/oder $R^2$ miteinander ein Ringsystem bilden, so kann ein monocyclisches oder polycyclisches, aliphatisches, aromatisches oder heteroaromatisches Ringsystem entstehen.

Eine Arylgruppe im Sinne dieser Erfindung enthält 6 bis 60 C-Atome, vorzugsweise 6 bis 40 C-Atome, besonders bevorzugt 6 bis 30 C-Atome; eine Heteroarylgruppe im Sinne dieser Erfindung enthält 2 bis 60 C-Atome, vorzugsweise 2 bis 40 C-Atome, besonders bevorzugt 2 bis 30 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome, vorzugsweise 6 bis 40 C-Atome, besonders bevorzugt 6 bis 30 C-Atome im Ringsystem. Ein heteroaromatisches Ringsystem im Sinne dieser Erfindung enthält 1 bis 60 C, vorzugsweise 1 bis 40 C-Atome, besonders bevorzugt 1 bis 30 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer $C_1$- bis $C_{20}$-Alkylgruppe, in der auch einzelne H-Atome oder $CH_2$-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1 -Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer $C_1$- bis $C_{40}$-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 bis 60, vorzugsweise 5 - 40 aromatischen Ringatomen, besonders bevorzugt 5 bis 30 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

In einer bevorzugten Ausgestaltung kann vorgesehen sein, dass mindestens einer der Gruppen W, $Y^a$, $Y^b$ in Formel (I) N darstellt, vorzugsweise mindestens zwei der Gruppen W, $Y^a$, $Y^b$ in Formel (I) N darstellen und besonders bevorzugt alle Gruppen W, $Y^a$, $Y^b$ in Formel (I) N darstellen.

Ferner kann vorgesehen sein, dass mindestens einer der Gruppen W, $Y^a$, $Y^b$ in Formel (I) CR darstellt, vorzugsweise mindestens zwei der Gruppen W, $Y^a$, $Y^b$ in Formel (I) CR darstellen und besonders bevorzugt alle Gruppen W, $Y^a$, $Y^b$ in Formel (I) CR darstellen, wobei R die zuvor, insbesondere für Formel (I) dargelegte Bedeutung aufweist.

Weiterhin kann vorgesehen sein, dass mindestens einer der Gruppen $Y^a$, $Y^b$ in Formel (I) N darstellt, vorzugsweise beide Gruppen $Y^a$, $Y^b$ in Formel (I) N darstellen und die Gruppe W CR darstellt, wobei R die zuvor, insbesondere für Formel (I) dargelegte Bedeutung aufweist.

Darüber hinaus kann vorgesehen sein, dass die Gruppe $Y^a$ in Formel (I) N darstellt und die Gruppe $Y^b$ in Formel (I) CR darstellt, wobei R die zuvor, insbesondere für Formel (I) dargelegte Bedeutung aufweist.

In einer weiteren Ausführungsform kann vorgesehen sein, dass die Gruppen W und $Y^a$ in Formel (I) N darstellen und die Gruppe $Y^b$ in Formel (I) CR darstellt, wobei R die zuvor, insbesondere für Formel (I) dargelegte Bedeutung aufweist.

Des Weiteren kann vorgesehen sein, dass die Gruppe $Y^a$ in Formel (I) N darstellt und die Gruppen W und $Y^b$ in Formel (I) CR darstellen, wobei R die zuvor, insbesondere für Formel (I) dargelegte Bedeutung aufweist.

In einer bevorzugten Ausgestaltung kann die erfindungsgemäß einzusetzende Verbindung mindestens eine Struktur der Formeln (II-1), (II-2), (II-3), (II-4), (II-5), (II-6), (II-7), (II-8), (II-9), (II-10) und (II-11) umfassen, vorzugsweise ausgewählt sein aus den Verbindungen der Formeln (II-1), (II-2), (II-3), (II-4), (II-5), (II-6), (II-7), (II-8), (II-9), (II-10) und (II-11)

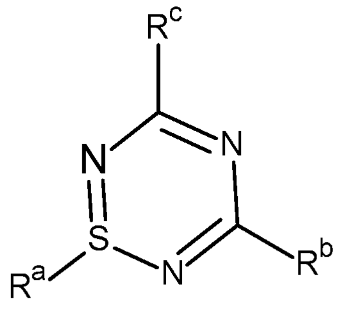

Formel (II-1)

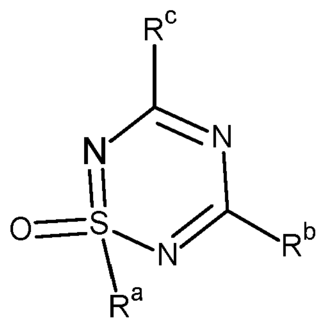

Formel (II-2)

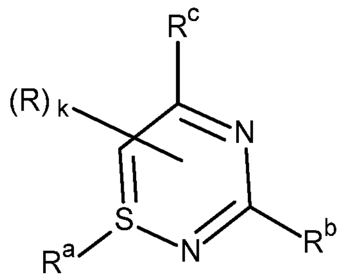

Formel (II-3)

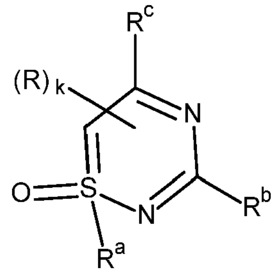

Formel (II-4)

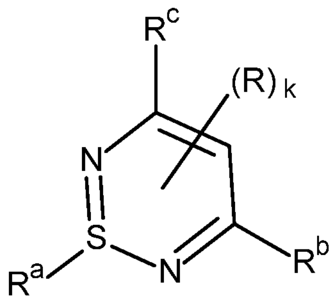

Formel (II-5)

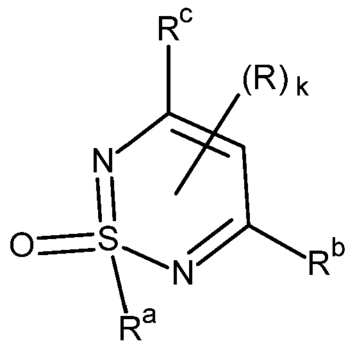

Formel (II-6)

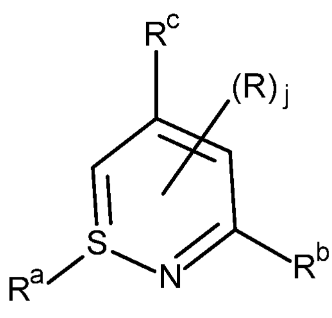

Formel (II-7)

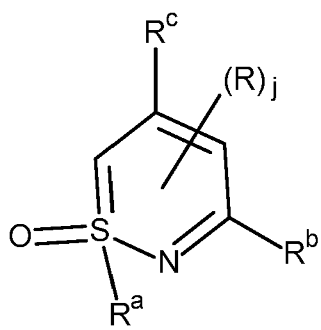

Formel (II-8)

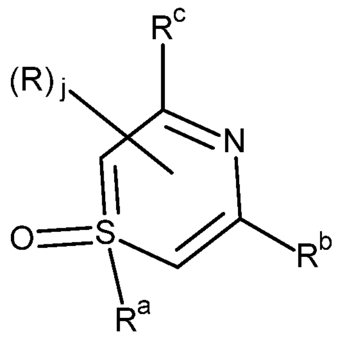

Formel (II-9)

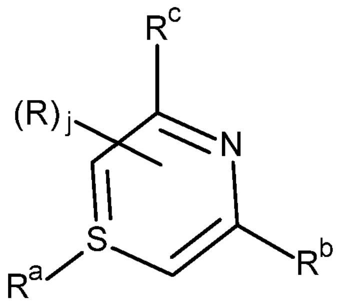

Formel (II-10)

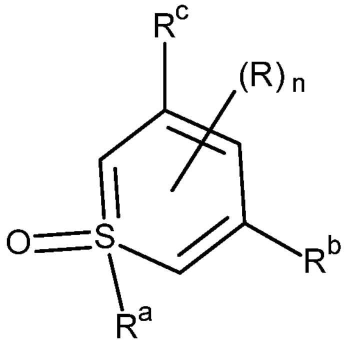

Formel (II-11)

wobei die Reste $R^a$, $R^b$, $R^c$ und R die zuvor, insbesondere für Formel (I) genannte Bedeutung haben, der Index n 0, 1, 2 oder 3, vorzugsweise 0, 1 oder 2 ist, der Index j 0, 1 oder 2 ist und der Index k 0 oder 1 ist.

Vorzugsweise ist mindestens einer der einer der Reste $R^a$, $R^b$, $R^c$ und/oder R ausgewählt ist aus der Gruppe der Phenyle, Fluorene, Indenofluorene, Spirobifluorene, Carbazole, Indenocarbazole, Indolocarbazole, Spirocarbazole, Pyrimidine, Triazine, Chinazoline, Chinoxaline, Pyridine, Chinoline, iso-Chinoline, Lactame, Triarylamine, Dibenzofurane, Dibenzothiene, Imidazole, Benzimidazole, Benzoxazole, Benzthiazole, 5-Aryl-phenanthridin-6-one, 9,10-Dehydrophenanthrene, Fluoranthene, Naphthaline, Phenanthrene, Anthracene, Benzanthracene, Fluoradene, Pyrene, Perylene, Chrysene, Borazine, Boroxine, Borole, Borazole, Azaborole, Ketone, Phosphinoxide, Arylsilane, Siloxane und deren Kombinationen.

Ferner kann vorgesehen sein, dass mindestens einer der Reste $R^a$, $R^b$, $R^c$ und/oder R ausgewählt ist aus der Gruppe bestehend aus Phenyl, ortho-, meta- oder para-Biphenyl, Terphenyl, insbesondere verzweigtes Terphenyl, Quaterphenyl, insbesondere verzweigtes Quaterphenyl, 1-, 2-, 3- oder 4-Fluorenyl, 9,9'-Diaryl-Fluorenyl 1-, 2-, 3- oder 4-Spirobifluorenyl, Pyridyl, Pyrimidinyl, 1-, 2-, 3- oder 4-Dibenzofuranyl, 1-, 2-, 3- oder 4-Dibenzothienyl, Pyrenyl, Triazinyl, Imidazolyl, Benzimidazolyl, Benzoxazolyl, Benzthiazolyl, 1-, 2-, 3-, 4- oder 9-Carbazolyl, 1- oder 2-Napthyl, Anthracenyl, vorzugsweise 9-Anthracenyl, Trans- und cis-Indenofluorenyl, Indenocarbazolyl, Indolocarbazolyl, Spirocarbazolyl, 5-Aryl-Phenanthridin-6-on-yl, 9,10-Dehydrophenanthrenyl, Fluoranthenyl, Tolyl, Mesityl, Phenoxytolulyl, Anisolyl, Triarylaminyl, Bis-triarylaminyl, Tristriarylaminyl, Hexamethylindanyl, Tetralinyl, Monocycloalkyl, Biscycloalkyl, Tricycloalkyl, Alkyl, wie z.B. tert-Butyl, Methyl, Propyl, Alkoxyl, Alkylsulfanyl, Alkylaryl, Triarylsilyl, Trialkylsilyl, Xanthenyl, 10-Aryl-Phenoxazinyl, Phenanthrenyl und/oder Triphenylenyl, die jeweils durch einen oder mehrere Reste substituiert sein können, bevorzugt aber unsubstituiert sind, wobei Phenyl, Spirobifluoren-, Fluoren-, Dibenzofuran-, Dibenzothiophen-, Anthracen-, Phenanthren-, Triphenylen- Gruppen besonders bevorzugt sind.

Wenn die zuvor und nachfolgend dargelegten Strukturen durch Substituenten R substituiert sind, dann sind diese Substituenten R bevorzugt gewählt aus der Gruppe bestehend aus H, D, F, CN, $N(Ar')_2$, C(=O) Ar', P(=O)( $Ar')_2$, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen oder einer Alkenylgruppe mit 2 bis 10 C-Atomen, die jeweils mit einem oder mehreren Resten $R^1$ substituiert sein kann, wobei eine oder mehrere nicht-benachbarte $CH_2$-Gruppen durch O ersetzt sein können und wobei ein oder mehrere H-Atome durch D oder F ersetzt sein können, einem aromatischen oder heteroaromatischen Ringsystem mit 5 bis 24 aromatischen Ringatomen, das jeweils mit einem oder mehreren Resten $R^1$ substituiert sein kann, bevorzugt aber unsubstituiert ist, oder einer Aralkyl- oder Heteroaralkylgruppe mit 5 bis 25

aromatischen Ringatomen, die mit einem oder mehreren Resten $R^1$ substituiert sein kann; dabei können optional zwei Substituenten R, die vorzugsweise an benachbarte Kohlenstoffatome gebunden sind, ein monocyclisches oder polycyclisches, aliphatisches, aromatisches oder heteroaromatisches Ringsystem bilden, das mit einem oder mehreren Resten $R^1$ substituiert sein kann, wobei die Gruppe Ar die zuvor, insbesondere für Formel (I) genannte Bedeutung aufweist.

Besonders bevorzugt sind diese Substituenten R ausgewählt aus der Gruppe bestehend aus H, D, F, CN, $N(Ar')_2$, einer geradkettigen Alkylgruppe mit 1 bis 8 C-Atomen, bevorzugt mit 1, 2, 3 oder 4 C-Atomen, oder einer verzweigten oder cyclischen Alkylgruppe mit 3 bis 8 C-Atomen, bevorzugt mit 3 oder 4 C-Atomen, oder einer Alkenylgruppe mit 2 bis 8 C-Atomen, bevorzugt mit 2, 3 oder 4 C-Atomen, die jeweils mit einem oder mehreren Resten $R^1$ substituiert sein kann, bevorzugt aber unsubstituiert ist, oder einem aromatischen oder heteroaromatischen Ringsystem mit 5 bis 24 aromatischen Ringatomen, bevorzugt mit 6 bis 18 aromatischen Ringatomen, besonders bevorzugt mit 6 bis 13 aromatischen Ringatomen, das jeweils mit einem oder mehreren nicht-aromatischen Resten $R^1$ substituiert sein kann, bevorzugt aber unsubstituiert ist; dabei können optional zwei Substituenten $R^1$, vorzugsweise die an benachbarte Kohlenstoffatome gebunden sind, ein monocyclisches oder polycyclisches, aliphatisches Ringsystem bilden, das mit einem oder mehreren Resten $R^2$ substituiert sein kann, bevorzugt aber unsubstituiert ist, wobei Ar die zuvor dargelegte Bedeutung aufweisen kann.

Besonders bevorzugt sind die Substituenten R ausgewählt aus der Gruppe bestehend aus H oder einem aromatischen oder heteroaromatischen Ringsystem mit 6 bis 18 aromatischen Ringatomen, bevorzugt mit 6 bis 13 aromatischen Ringatomen, das jeweils mit einem oder mehreren nicht-aromatischen Resten $R^1$ substituiert sein kann, bevorzugt aber unsubstituiert ist. Beispiele für geeignete Substituenten R sind ausgewählt aus der Gruppe bestehend aus Phenyl, ortho-, meta- oder para-Biphenyl, Terphenyl, insbesondere verzweigtes Terphenyl, Quaterphenyl, insbesondere verzweigtes Quaterphenyl, 1-, 2-, 3- oder 4-Fluorenyl, 1-, 2-, 3- oder 4-Spirobifluorenyl, Pyridyl, Pyrimidinyl, Triazinyl, Chinazolinyl, Chinoxalinyl, Chinolinyl, 1-, 2-, 3- oder 4-Dibenzofuranyl, 1-, 2-, 3- oder 4-Dibenzothienyl, 1-, 2-, 3- oder 4-Carbazolyl und Indenocarbazolyl, die jeweils durch einen oder mehrere Reste $R^1$ substituiert sein können, bevorzugt aber unsubstituiert sind.

Weiterhin kann vorgesehen sein, dass die Substitutenten $R^a$, $R^b$, $R^c$ und/oder R der zuvor und nachfolgend dargelegten Strukturen, vorzugsweise Strukturen gemäß den Formeln (I) und/oder (II-1) bis (II-11) untereinander kein kondensiertes aromatisches oder heteroaromatisches Ringsystem, vorzugsweise kein kondensiertes Ringsystem bilden. Dies schließt die Bildung eines kondensierten Ringsystems mit möglichen Substituenten $R^1$ und $R^2$ ein, die an die Reste $R^a$, $R^b$, $R^c$ und/oder R beziehungsweise an $R^1$ gebunden sein können.

Gemäß einer weiteren Ausführungsform kann vorgesehen sein, dass die erfindungsgemäß einzusetzende Verbindung eine Lochtransportgruppe umfasst, wobei vorzugsweise mindestens einer der zuvor dargelegten Reste $R^a$, $R^b$, $R^c$ und/oder R, die unter anderem in einer Struktur gemäß den Formeln (I) und/oder (II-1) bis (II-11) enthalten sein können, eine Lochtransportgruppe umfasst, vorzugsweise darstellt. Lochtransportgruppen sind in der Fachwelt bekannt, wobei diese vorzugsweise Triarylamin- oder Carbazolgruppen umfassen.

Vorzugsweise kann vorgesehen sein, dass die Lochtransportgruppe eine Gruppe umfasst, bevorzugt für eine Gruppe steht, die ausgewählt ist aus den Formeln (H-1) bis (H-3),

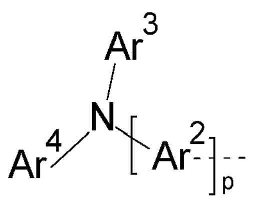

Formel (H-1)

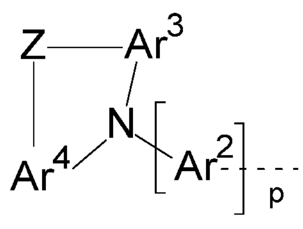

Formel (H-2)

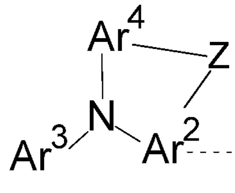

wobei die gestrichelte Bindung die Anbindungsposition markiert und die Symbole die folgende Bedeutung aufweisen;

$Ar^2$, $Ar^3$, $Ar^4$ ist jeweils unabhängig ein aromatisches Ringsystem mit 6 bis 40 C-Atomen oder ein heteroaromatisches Ringsystem mit 3 bis 40 C-Atomen, welches jeweils durch einen oder mehrere Reste $R^1$ substituiert

sein kann;

p ist 0 oder 1 ;

Z steht für eine Bindung oder $C(R^1)_2$, $Si(R^1)_2$, C=O, $NR^1$, $NAr^1$, $BR^1$, $PR^1$, $PO(R^1)$, SO, $SO_2$, Se, O oder S, vorzugsweise für eine Bindung oder $C(R^1)_2$, $NAr^1$, O oder S;

wobei $Ar^1$ ein aromatisches Ringsystem mit 6 bis 40 C-Atomen oder ein heteroaromatisches Ringsystem mit 3 bis 40 C-Atomen ist, welches durch einen oder mehrere Reste $R^1$ substituiert sein kann, und der Rest $R^1$ die zuvor, insbesondere für Formel (I) dargelegte Bedeutung aufweist. Hierbei ist das Vorhandensein einer N-N-Bindung vorzugsweise ausgeschlossen.

Weiterhin kann vorgesehen sein, dass die Lochtransportgruppe eine Gruppe umfasst, bevorzugt für eine Gruppe steht, die ausgewählt ist aus den Formeln (H-4) bis (H-26),

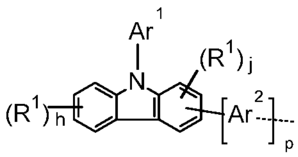

Formel (H-4)

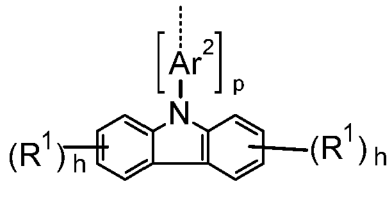

Formel (H-5)

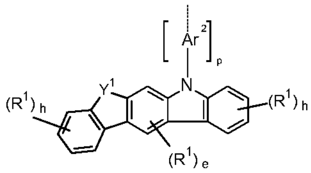

Formel (H-6)

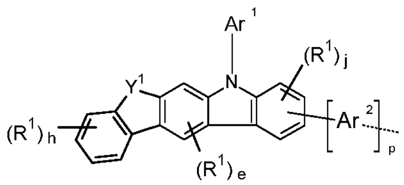

Formel (H-7)

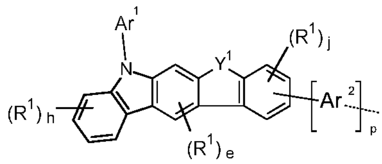

Formel (H-8)

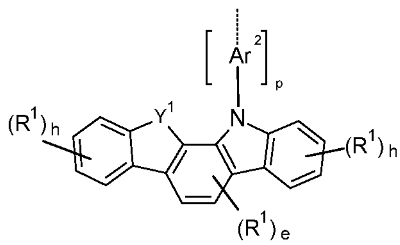

Formel (H-9)

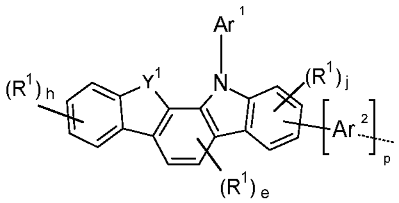

Formel (H-10)

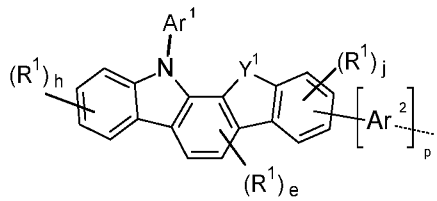

Formel (H-11)

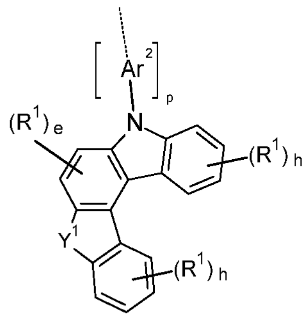

Formel (H-12)

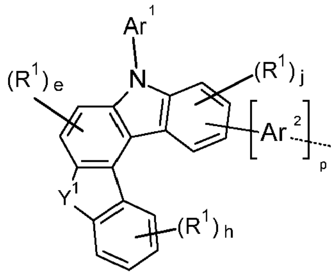

Formel (H-13)

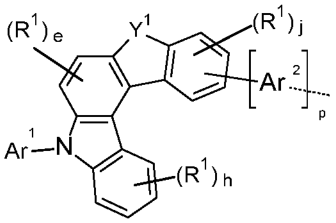

Formel (H-14)

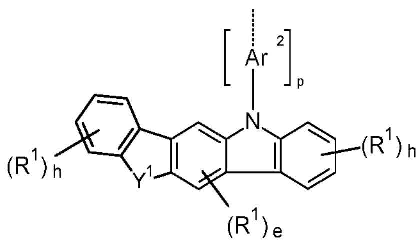

Formel (H-15)

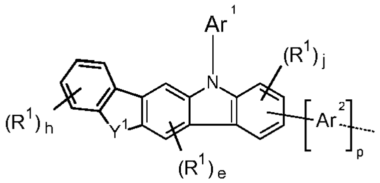

Formel (H-16)

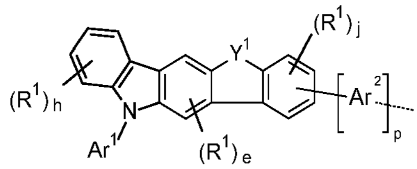

Formel (H-17)

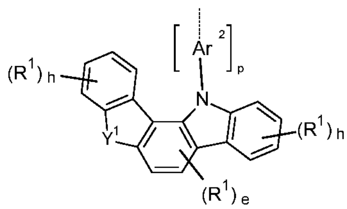

Formel (H-18)

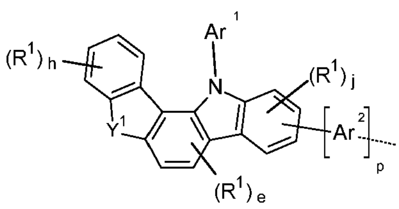

Formel (H-19)

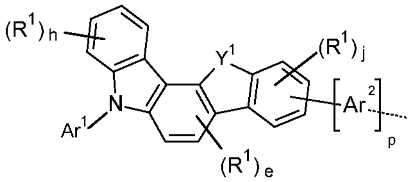

Formel (H-20)

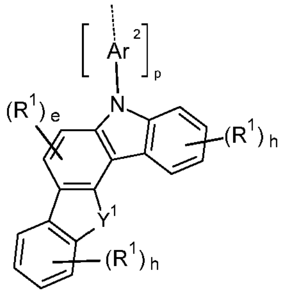

Formel (H-21)

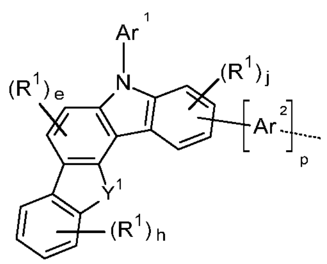

Formel (H-22)

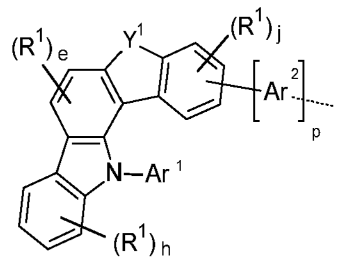

Formel (H-23)

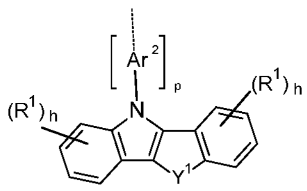

Formel (H-24)

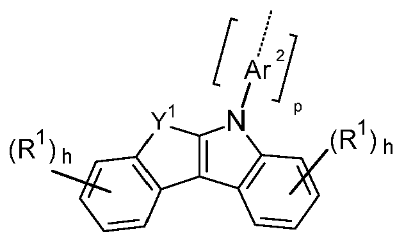

Formel (H-25)

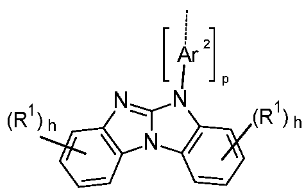

Formel (H-26)

wobei $Y^1$ O, S, $C(R^1)_2$ oder $NAr^1$ darstellt, die gestrichelte Bindung die Anbindungsposition markiert, e 0, 1 oder 2 ist, j 0, 1, 2 oder 3 ist, h 0, 1, 2, 3 oder 4 ist, p 0 oder 1 ist, $R^1$ die zuvor, insbesondere für Formel (I) genannten Bedeutungen aufweist und $Ar^1$ und $Ar^2$ die zuvor, insbesondere für Formel (H-1) oder (H-2) genannten Bedeutungen aufweisen. Hierbei ist das Vorhandensein einer N-N-Bindung vorzugsweise ausgeschlossen.

Aus der obigen Formulierung ist ersichtlich, dass, falls der Index p = 0 ist, die entsprechende Gruppe $Ar^2$ nicht vorhanden ist und eine Bindung gebildet wird.

Bevorzugt kann die Gruppe $Ar^2$ mit dem aromatischen oder heteroaromatischen Rest oder dem Stickstoffatom, an den die Gruppe $Ar^2$ gemäß den Formeln (H-1) bis (H-26) gebunden sein kann, eine durchgängige Konjugation ausbilden.

In einer weiteren bevorzugten Ausführungsform der Erfindung steht $Ar^2$ für ein aromatisches oder heteroaromatisches Ringsystem mit 5 bis 14 aromatischen oder heteroaromatischen Ringatomen, vorzugsweise ein aromatisches Ringsystem mit 6 bis 12 Kohlenstoffatomen, welches durch einen oder mehrere Reste $R^1$ substituiert sein kann, bevorzugt aber unsubstituiert ist, wobei $R^1$ die zuvor, insbesondere für Formel (I) genannte Bedeutung aufweisen kann. Besonders bevorzugt steht $Ar^2$ für ein aromatisches Ringsystem mit 6 bis 10 aromatischen Ringatomen oder ein heteroaromatisches Ringsystem mit 6 bis 13 heteroaromatischen Ringatomen, das jeweils durch einen oder mehrere Reste $R^1$ substituiert sein kann, bevorzugt aber unsubstituiert ist, wobei $R^1$ die zuvor, insbesondere für Formel (I) genannte Bedeutung aufweisen kann.

Weiterhin bevorzugt steht das unter anderem in Formeln (H-1) bis (H-26) dargelegte Symbol $Ar^2$ für einen Aryl- oder Heteroarylrest mit 5 bis 24 Ringatomen, vorzugsweise 6 bis 13 Ringatomen, besonders bevorzugt 6 bis 10 Ringatomen, so dass eine aromatische oder heteroaromatische Gruppe eines aromatischen oder heteroaromatische Ringsystems direkt, d.h. über ein Atom der aromatischen oder heteroaromatische Gruppe, an das jeweilige Atom der weiteren Gruppe gebunden ist.

Weiterhin kann vorgesehen sein, dass die in Formeln (H-1) bis (H-26) dargelegte Gruppe $Ar^2$ ein aromatisches Ringsystem mit höchstens zwei kondensierten aromatischen und/oder heteroaromatischen 6-Ringen, vorzugsweise kein kondensiertes aromatisches oder heteroaromatisches Ringsystem mit kondensierten 6-Ringen umfasst. Demgemäß sind Naphthylstrukturen gegenüber Anthracenstrukturen bevorzugt. Weiterhin sind Fluorenyl-, Spirobifluorenyl-, Dibenzofuranyl- und/oder Dibenzothienyl-Strukturen gegenüber Naphthylstrukturen bevorzugt. Besonders bevorzugt sind Strukturen, die keine Kondensation aufweisen, wie beispielsweise Phenyl-, Biphenyl-, Terphenyl- und/oder Quaterphenyl-Strukturen.

Ferner kann vorgesehen sein, dass die unter anderem in Formeln (H-1) bis (H-26) dargelegte Gruppe $Ar^2$ höchstens 1 Stickstoffatom, bevorzugt höchstens 2 Heteroatome, insbesondere bevorzugt höchstens ein Heteroatom und besonders bevorzugt kein Heteroatom aufweist.

In einer weiteren bevorzugten Ausführungsform der Erfindung steht $Ar^3$ und/oder $Ar^4$ gleich oder verschieden bei jedem Auftreten für ein aromatisches oder heteroaromatisches Ringsystem mit 6 bis 24 aromatischen Ringatomen, bevorzugt mit 6 bis 18 aromatischen Ringatomen, besonders bevorzugt für ein aromatisches Ringsystem mit 6 bis 12 aromatischen Ringatomen bzw. ein heteroaromatisches Ringsystem mit 6 bis 13 aromatischen Ringatomen, das jeweils durch einen oder mehrere Reste $R^1$ substituiert sein kann, bevorzugt aber unsubstituiert ist, wobei $R^1$ die zuvor, insbesondere in Formel (I) dargestellte Bedeutung aufweisen kann.

Gemäß einer weiteren Ausführungsform kann vorgesehen sein, dass die erfindungsgemäß einzusetzende Verbindung einen Elektronentransportgruppe-umfassenden Rest umfasst, wobei vorzugsweise mindestens eine der zuvor dargelegten Gruppen $R^a$, $R^b$, $R^c$ und/oder R, die unter anderem in einer Struktur gemäß den Formeln (I) und/oder (II-1) bis (II-11) enthalten sein können, einen Elektronentransportgruppe-umfassenden Rest umfasst, vorzugsweise darstellt. Elektronentransportgruppen sind in der Fachwelt weithin bekannt und fördern die Fähigkeit von Verbindungen, Elektronen zu transportieren und/oder zu leiten.

Weiterhin zeigen erfindungsgemäß einzusetzende Verbindungen überraschende Vorteile, die mindestens eine Struktur umfassen, die aus der Gruppe Pyridine, Pyrimidine, Pyrazine, Pyridazine, Triazine, Chinazoline, Chinoxaline, Chinoline, Isochinoline, Imidazole und/oder Benzimidazole ausgewählt ist, wobei Pyrimidine, Triazine und Chinazoline besonders bevorzugt sind. Diese Strukturen fördern im Allgemeinen die Fähigkeit von Verbindungen, Elektronen zu transportieren und/oder zu leiten.

In einer bevorzugten Ausgestaltung der vorliegenden Erfindung kann vorgesehen sein, dass der Elektronentransportgruppe-umfassende Rest für eine Gruppe steht, die durch die Formel (QL) darstellbar ist,

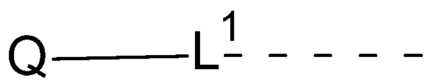

Formel (QL)

worin L’ eine Bindung oder ein aromatisches oder heteroaromatisches Ringsystem mit 5 bis 40, bevorzugt 5 bis 30 aromatischen Ringatomen darstellt, welches durch einen oder mehrere Reste $R^1$ substituiert sein kann, und Q eine Elektronentransportgruppe ist, wobei $R^1$ die zuvor, insbesondere für Formel (I) genannte Bedeutung aufweist, und die gestrichelte Bindung die Anbindungsposition markiert.

Bevorzugt kann die Gruppe L’ mit der Gruppe Q und dem Atom, bevorzugt dem Kohlen- oder Stickstoffatom, an den die Gruppe L’ gemäß Formel (QL) gebunden ist, eine durchgängige Konjugation ausbilden. Eine durchgängige Konjugation der aromatischen beziehungsweise heteroaromatischen Systeme wird ausgebildet, sobald direkte Bindungen zwischen benachbarten aromatischen oder heteroaromatischen Ringen gebildet werden. Eine weitere Verknüpfung zwischen den zuvor genannten konjugierten Gruppen, die beispielsweise über ein S-, N- oder O-Atom oder eine Carbonylgruppe erfolgt, schadet einer Konjugation nicht. Bei einem Fluorensystem sind die beiden aromatischen Ringe unmittelbar gebunden, wobei das $sp^3$ hybridisierte Kohlenstoffatom in Position 9 zwar eine Kondensation dieser Ringe unterbindet, jedoch eine Konjugation erfolgen kann, da dieses $sp^3$ hybridisierte Kohlenstoffatom in Position 9 nicht zwingend zwischen der elektronentransportierenden Gruppe Q und dem Atom, über das die Gruppe der Formel (QL) an weitere Strukturelemente einer Verbindung bindet, liegt. Im Gegensatz hierzu kann bei einer zweiten Spirobifluorenstruktur eine durchgängige Konjugation ausgebildet werden, falls die Verbindung zwischen der Gruppe Q und dem aromatischen oder heteroaromatischen Rest, an den die Gruppe L’ gemäß Formel (QL) gebunden ist, über die gleiche Phenylgruppe der Spirobifluorenstruktur oder über Phenylgruppen der Spirobifluorenstruktur, die unmittelbar aneinander gebunden sind und in einer Ebene liegen, erfolgt. Falls die Verbindung zwischen der Gruppe Q und dem aromatischen oder heteroaromatischen Rest, an den die Gruppe L’ gemäß Formel (QL) gebunden ist, über verschiedene Phenylgruppen der zweiten Spirobifluorenstruktur erfolgt, die über das $sp^3$ hybridisierte Kohlenstoffatom in Position 9 verbunden sind, ist die Konjugation unterbrochen.

In einer weiteren bevorzugten Ausführungsform der Erfindung steht L’ für eine Bindung oder für ein aromatisches oder heteroaromatisches Ringsystem mit 5 bis 14 aromatischen oder heteroaromatischen Ringatomen, vorzugsweise

ein aromatisches Ringsystem mit 6 bis 12 Kohlenstoffatomen, welches durch einen oder mehrere Reste $R^1$ substituiert sein kann, bevorzugt aber unsubstituiert ist, wobei $R^1$ die zuvor, insbesondere für Formel (I) genannte Bedeutung aufweisen kann. Besonders bevorzugt steht L' für ein aromatisches Ringsystem mit 6 bis 10 aromatischen Ringatomen oder ein heteroaromatisches Ringsystem mit 6 bis 13 heteroaromatischen Ringatomen, das jeweils durch einen oder mehrere Reste $R^2$ substituiert sein kann, bevorzugt aber unsubstituiert ist, wobei $R^2$ die zuvor, insbesondere für Formel (I) genannte Bedeutung aufweisen kann.

Weiterhin bevorzugt steht das unter anderem in Formel (QL) dargelegte Symbol L' gleich oder verschieden bei jedem Auftreten für eine Bindung oder einen Aryl- oder Heteroarylrest mit 5 bis 24 Ringatomen, vorzugsweise 6 bis 13 Ringatomen, besonders bevorzugt 6 bis 10 Ringatomen, so dass eine aromatische oder heteroaromatische Gruppe eines aromatischen oder heteroaromatische Ringsystems direkt, d.h. über ein Atom der aromatischen oder heteroaromatische Gruppe, an das jeweilige Atom der weiteren Gruppe gebunden ist.

Weiterhin kann vorgesehen sein, dass die in Formel (QL) dargelegte Gruppe L' ein aromatisches Ringsystem mit höchstens zwei kondensierten aromatischen und/oder heteroaromatischen 6-Ringen, vorzugsweise kein kondensiertes aromatisches oder heteroaromatisches Ringsystem umfasst. Demgemäß sind Naphthylstrukturen gegenüber Anthracenstrukturen bevorzugt. Weiterhin sind Fluorenyl-, Spirobifluorenyl-, Dibenzofuranyl- und/oder Dibenzothienyl-Strukturen gegenüber Naphthylstrukturen bevorzugt.

Besonders bevorzugt sind Strukturen, die keine Kondensation aufweisen, wie beispielsweise Phenyl-, Biphenyl-, Terphenyl- und/oder Quaterphenyl-Strukturen.

Beispiele für geeignete aromatische oder heteroaromatische Ringsysteme L' sind ausgewählt aus der Gruppe bestehend aus ortho-, meta- oder para-Phenylen, ortho-, meta- oder para-Biphenylen, Terphenylen, insbesondere verzweigtes Terphenylen, Quaterphenylen, insbesondere verzweigtes Quaterphenylen, Fluorenylen, Spirobifluorenylen, Dibenzofuranylen, Dibenzothienylen und Carbazolylen, die jeweils durch einen oder mehrere Reste $R^1$ substituiert sein können, bevorzugt aber unsubstituiert sind.

Ferner kann vorgesehen sein, dass die unter anderem in Formel (QL) dargelegte Gruppe L' höchstens 1 Stickstoffatom, bevorzugt höchstens 2 Heteroatome, insbesondere bevorzugt höchstens ein Heteroatom und besonders bevorzugt kein Heteroatom aufweist.

Vorzugsweise kann die unter anderem in den Formel (QL) dargelegte Gruppe Q beziehungsweise die Elektronentransportgruppe ausgewählt sein aus Strukturen der Formeln (Q-1), (Q-2), (Q-4), (Q-4), (Q-5), (Q-6), (Q-7), (Q-8), (Q-9) und/oder (Q-10)

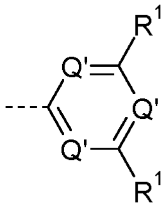

Formel (Q-1)

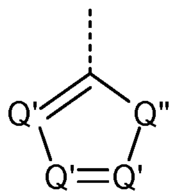

Formel (Q-2)

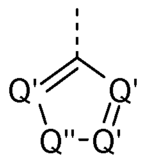

Formel (Q-3)

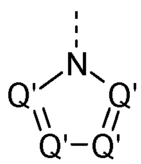

Formel (Q-4)

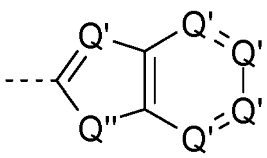

Formel (Q-5)

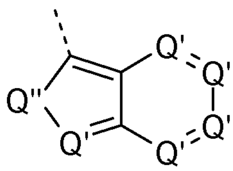

Formel (Q-6)

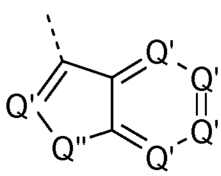

Formel (Q-7)

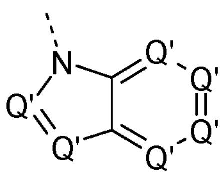

Formel (Q-8)

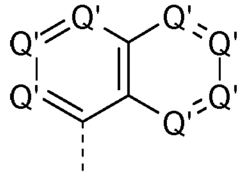

Formel (Q-9)

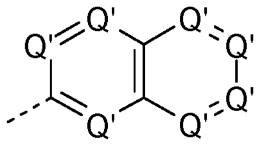

Formel (Q-10),

wobei die gestrichelte Bindung die Anbindungsposition markiert,
Q' bei jedem Auftreten gleich oder verschieden $CR^1$ oder N darstellt, und
Q" $NR^1$, O oder S darstellt;
wobei wenigstens ein Q' gleich N und
$R^1$ wie zuvor, insbesondere in Formel (I) definiert ist.

Weiterhin kann die unter anderem in den Formel (QL) dargelegte Gruppe Q beziehungsweise die Elektronentransportgruppe vorzugsweise ausgewählt sein aus einer Struktur der Formeln (Q-11), (Q-12), (Q-13), (Q-14) und/oder (Q-15)

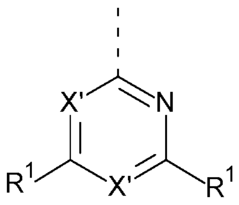

Formel (Q-11)

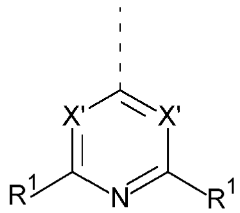

Formel (Q-12)

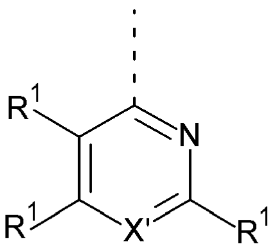

Formel (Q-13)

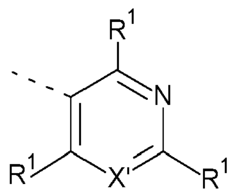

Formel (Q-14)

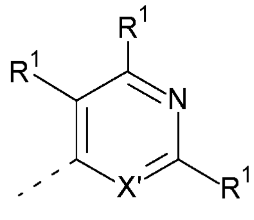

Formel (Q-15)

wobei das Symbol $R^1$ die zuvor unter anderem für Formel (I) genannte Bedeutung aufweist, X' N oder $CR^1$ ist und die gestrichelte Bindung die Anbindungsposition markiert, wobei X' vorzugsweise ein Stickstoffatom darstellt.

In einer weiteren Ausführungsform kann die unter anderem in den Formel (QL) dargelegte Gruppe Q beziehungsweise die Elektronentransportgruppe ausgewählt sein aus Strukturen der Formeln (Q-16), (Q-17), (Q-18), (Q-19), (Q-20), (Q-21) und/oder (Q-22)

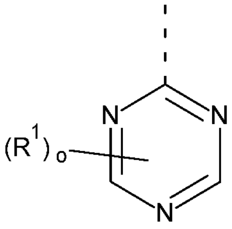

Formel (Q-16)

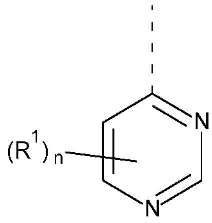

Formel (Q-17)

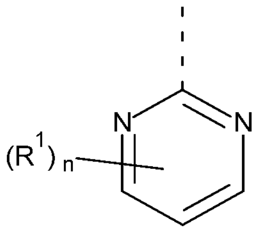

Formel (Q-18)

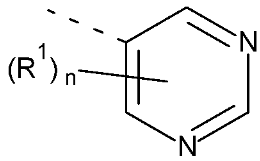

Formel (Q-19)

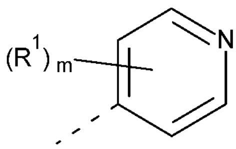

Formel (Q-20)

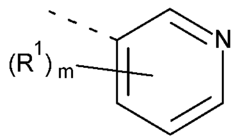

Formel (Q-21)

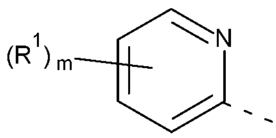

Formel (Q-22)

worin das Symbol $R^1$ die zuvor unter anderem für Formel (I) dargelegte Bedeutung aufweist, die gestrichelte Bindung die Anbindungsposition markiert und m 0, 1, 2, 3 oder 4, vorzugsweise 0, 1 oder 2, n 0, 1, 2 oder 3, vorzugsweise 0, 1 oder 2 und o 0, 1 oder 2, vorzugsweise 1 oder 2 ist. Hierbei sind die Strukturen der Formeln (Q-16), (Q-17), (Q-18) und (Q-19) bevorzugt.

In einer weiteren Ausführungsform kann die unter anderem in den Formel (QL) dargelegte Gruppe Q beziehungsweise die Elektronentransportgruppe ausgewählt sein aus Strukturen der Formeln (Q-23), (Q-24) und/oder (Q-25),

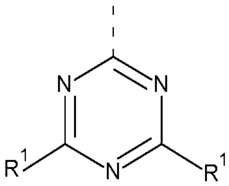

Formel (Q-23)

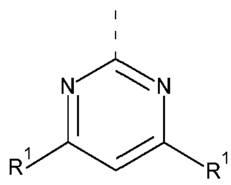

Formel (Q-24)

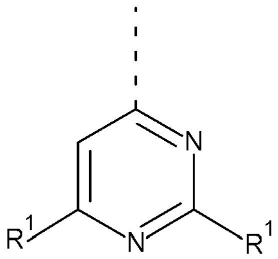

Formel (Q-25)

worin das Symbol $R^1$ die zuvor unter anderem für Formel (I) dargelegte Bedeutung aufweist und die gestrichelte Bindung die Anbindungsposition markiert.

In einer weiteren Ausführungsform kann die unter anderem in den Formel (QL) dargelegte Gruppe Q beziehungsweise die Elektronentransportgruppe ausgewählt sein aus Strukturen der Formeln (Q-26), (Q-27), (Q-28), (Q-29) und/oder (Q-30),

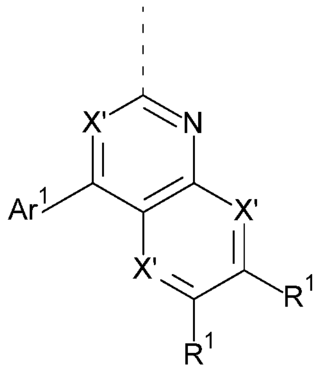

Formel (Q-26)

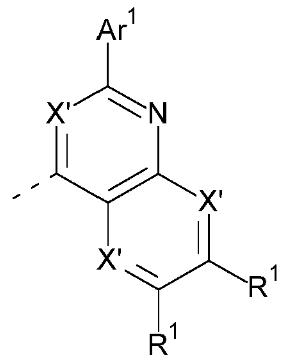

Formel (Q-27)

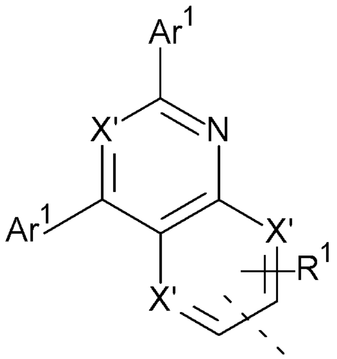

Formel (Q-28)

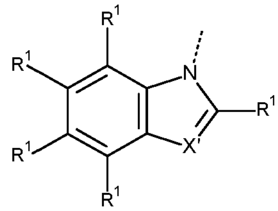

Formel (Q-29)

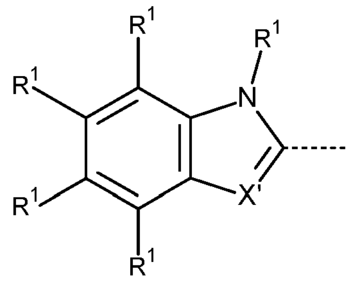

Formel (Q-30)

wobei Symbole $Ar^1$ und $R^1$ die zuvor zuvor unter anderem für Formel (I) und/oder (H-2), (H-3) genannte Bedeutung aufweisen, X‘ N oder $CR^1$ ist und die gestrichelte Bindung die Anbindungsposition markiert. Vorzugsweise stellt in den Strukturen der Formeln (Q-26), (Q-27) und (Q-28) genau ein X‘ ein Stickstoffatom dar.

Vorzugsweise kann die unter anderem in den Formel (QL) dargelegte Gruppe Q beziehungsweise die Elektronentransportgruppe ausgewählt sein aus Strukturen der Formeln (Q-31), (Q-32), (Q-33), (Q-34), (Q-35), (Q-36), (Q-37), (Q-38), (Q-39), (Q-40), (Q-41), (Q-42), (Q-43) und/oder (Q-44),

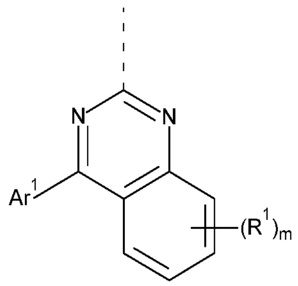

Formel (Q-31)

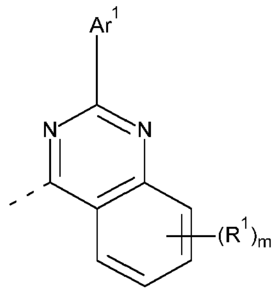

Formel (Q-32)

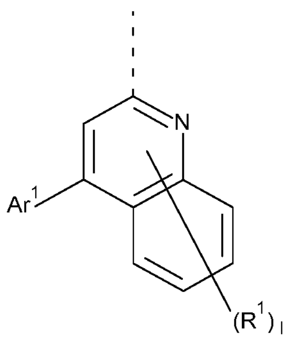

Formel (Q-33)

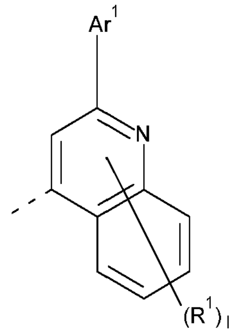

Formel (Q-34)

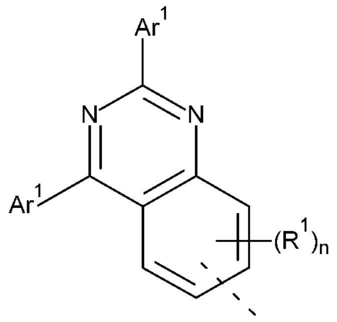

Formel (Q-35)

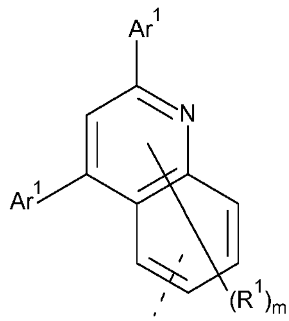

Formel (Q-36)

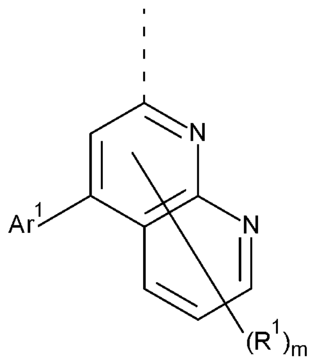

Formel (Q-37)

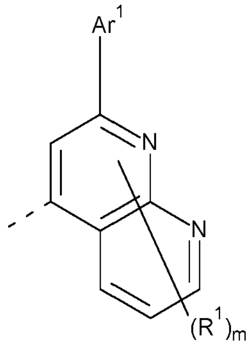

Formel (Q-38)

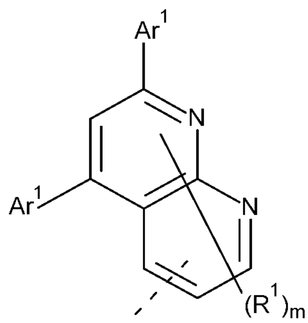

Formel (Q-39)

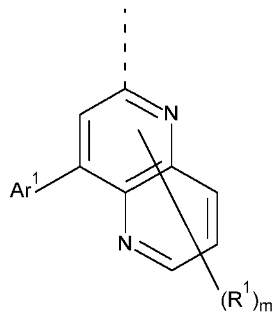

Formel (Q-40)

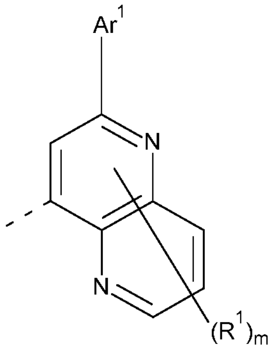

Formel (Q-41)

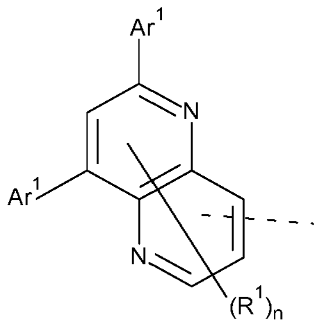

Formel (Q-42)

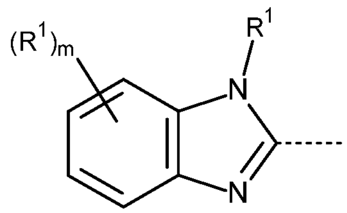

Formel (Q-43)

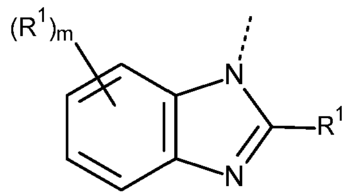

Formel (Q-44)

worin die Symbole $Ar^1$ und $R^1$ die zuvor unter anderem für Formel (I) und/oder (H-2) oder (H-3) dargelegte Bedeutung aufweisen, die gestrichelte Bindung die Anbindungsposition markiert und m 0, 1, 2, 3 oder 4, vorzugsweise 0, 1 oder 2, n 0, 1, 2 oder 3, vorzugsweise 0 oder 1, n 0, 1, 2 oder 3, vorzugsweise 0, 1 oder 2 und I 1, 2, 3, 4 oder 5, vorzugsweise 0, 1 oder 2 ist.

In einer weiteren bevorzugten Ausführungsform der Erfindung steht $Ar^1$ gleich oder verschieden bei jedem Auftreten für ein aromatisches oder heteroaromatisches Ringsystem, vorzugsweise einen Aryl- oder Heteroarylrest mit 5 bis 24 aromatischen Ringatomen, bevorzugt mit 6 bis 18 aromatischen Ringatomen, besonders bevorzugt für ein aromatisches Ringsystem, vorzugsweise einen Arylrest mit 6 bis 12 aromatischen Ringatomen bzw. ein heteroaromatisches Ringsystem, vorzugsweise eine Heteroarylgruppe mit 5 bis 13 aromatischen Ringatomen, das jeweils durch einen oder mehrere Reste $R^1$ substituiert sein kann, bevorzugt aber unsubstituiert ist, wobei $R^1$ die zuvor, insbesondere in Formel (I) dargestellte Bedeutung aufweisen kann.

Vorzugsweise steht das Symbol $Ar^1$ für einen Aryl- oder Heteroarylrest, so dass eine aromatische oder heteroaromatische Gruppe eines aromatischen oder heteroaromatischen Ringsystems direkt, d.h. über ein Atom der aromatischen oder heteroaromatischen Gruppe, an das jeweilige Atom der weiteren Gruppe gebunden ist, beispielweise ein C- oder N-Atom der zuvor dargestellten Gruppen (H-1) bis (H-26) oder (Q-26) bis (Q-44).

Mit Vorteil stellt $Ar^1$ in den Formeln (H-1) bis (H-26) oder (Q-26) bis (Q-44) ein aromatisches Ringsystem mit 6 bis 12 aromatischen Ringatomen dar, welches mit einem oder mehreren Resten $R^1$ substituiert sein kann, vorzugsweise aber unsubstituiert ist, wobei $R^1$ die zuvor, insbesondere für Formel (I) dargestellte Bedeutung aufweisen kann.

Bevorzugt bilden die Reste $R^1$ oder $R^2$ in den Formeln (H-1) bis (H-26) oder (Q-1) bis (Q-44) mit den Ringatomen der Arylgruppe oder Heteroarylgruppe $Ar^1$, $Ar^2$, $Ar^3$ und/oder $Ar^4$, an die die Reste $R^1$ oder $R^2$ gebunden sind, kein kondensiertes Ringsystem. Dies schließt die Bildung eines kondensierten Ringsystems mit möglichen Substituenten $R^2$ ein, die an die Reste $R^1$ gebunden sein können.

Ferner kann vorgesehen sein, dass die Gruppe Ar', $Ar^1$, $Ar^2$, $Ar^3$ und/oder $Ar^4$ ausgewählt ist aus der Gruppe bestehend aus Phenyl, ortho-, meta- oder para-Biphenyl, Terphenyl, insbesondere verzweigtes Terphenyl, Quaterphenyl, insbesondere verzweigtes Quaterphenyl, 1-, 2-, 3- oder 4-Fluorenyl, 1-, 2-, 3- oder 4-Spirobifluorenyl, Pyridyl, Pyrimidinyl, 1-, 2-, 3- oder 4-Dibenzofuranyl, 1-, 2-, 3- oder 4-Dibenzothienyl, Pyrenyl, Triazinyl, Imidazolyl, Benzimidazolyl, Benzoxazolyl, Benzthiazolyl, 1-, 2-, 3- oder 4-Carbazolyl, 1- oder 2-Napthyl, Anthracenyl, vorzugsweise 9-Anthracenyl, Phenanthrenyl und/oder Triphenylenyl, die jeweils durch einen oder mehrere Reste $R^1$ substituiert sein können, bevorzugt aber unsubstituiert sind, wobei Phenyl, Spirobifluoren-, Fluoren-, Dibenzofuran-, Dibenzothiophen-, Anthracen-, Phenanthren-, Triphenylen- Gruppen besonders bevorzugt sind, wobei der Rest $R^1$ die zuvor, insbesondere in Formel (I) genannte Bedeutung aufweist.

In einer bevorzugten Ausführungsform kann vorgesehen sein, dass mindestens zwei Reste $R^a$, $R^b$, $R^c$ und/oder R in einer Struktur gemäß den Formeln (I) und/oder (II-1) bis (II-11) jeweils eine Lochtransportgruppe umfassen, vorzugsweise darstellen.

Ferner kann vorgesehen sein, dass mindestens einer der Reste $R^a$, $R^b$, $R^c$ und/oder R in einer Struktur gemäß den Formeln (I) und/oder (II-1) bis (II-11) zwei Lochtransportgruppen umfasst. Hierbei kann eine Lochtransportgruppe als Rest $R^1$ angesehen werden, wobei in diesem Fall die in den Strukturen der Formeln (H-1) bis (H-26) dargelegten Substituenten $R^1$ durch Reste $R^2$ zu ersetzen sind.

In einer bevorzugten Ausführungsform kann vorgesehen sein, dass mindestens zwei Reste $R^a$, $R^b$, $R^c$ und/oder R in einer Struktur gemäß den Formeln (I) und/oder (II-1) bis (II-11) jeweils einen Elektronentransportgruppe-umfassenden Rest umfassen, vorzugsweise darstellen.

Ferner kann vorgesehen sein, dass mindestens einer der Reste $R^a$, $R^b$, $R^c$ und/oder R in einer Struktur gemäß den Formeln (I) und/oder (II-1) bis (II-11) zwei Elektronentransportgruppe-umfassende Reste umfasst. Hierbei kann ein Elektronentransportgruppe-umfassender Rest als Rest $R^1$ angesehen werden, wobei in diesem Fall die in den Strukturen der Formeln (QL) und/oder (Q-1) bis (Q-44) dargelegten Substituenten $R^1$ durch Reste $R^2$ zu ersetzen sind.

In einer weiteren Ausgestaltung kann vorgesehen sein, dass mindestens einer der Reste $R^a$, $R^b$, $R^c$ und/oder R in einer Struktur gemäß den Formeln (I) und/oder (II-1) bis (II-11) eine Lochtransportgruppe umfasst, vorzugsweise

darstellt, und mindestens einer der Reste R und/oder Ar einen Elektronentransportgruppe-umfassenden Rest umfasst, vorzugsweise darstellt.

Ferner kann vorgesehen sein, dass mindestens einer der Reste $R^a$, $R^b$, $R^c$ und/oder R in einer Struktur gemäß den Formeln (I) und/oder (II-1) bis (II-11) sowohl einen Elektronentransportgruppe-umfassenden Rest umfasst als auch eine Lochtransportgruppe. Hierbei kann ein Elektronentransportgruppe-umfassender Rest oder eine Lochtransportgruppe als Rest $R^1$ angesehen werden, wobei in diesem Fall die in den Strukturen der Formeln (QL), (Q-1) bis (Q-44) oder (H-1) bis (H-26) dargelegten Substituenten $R^1$ durch Reste $R^2$ zu ersetzen sind.

In einer weiteren Ausgestaltung kann vorgesehen sein, dass mindestens einer der Reste $R^a$, $R^b$, $R^c$ und/oder R mindestens eine Gruppe umfasst, die zu mit Wide-Band-Gap -Materialien führt. Der Begriff "Gruppe, die zu mit Wide-Band-Gap -Materialien führt" legt dar, dass die Verbindungen als Wide-Band-Gap-Materialien eingesetzt werden können, so dass die Verbindungen entsprechende Gruppen aufweisen. Wide-Band-Gap-Materialien werden später ausführlicher dargelegt.

Ferner kann vorgesehen sein, dass mindestens einer der Reste $R^a$, $R^b$, $R^c$ und/oder R mindestens eine Gruppe umfasst, die zu Materialien führt, die als Hostmaterial eingesetzt werden. Der Begriff "Gruppe, die zu Materialien führt, die als Hostmaterial eingesetzt werden" legt dar, dass die Verbindungen als Hostmaterialien eingesetzt werden können, so dass die Verbindungen entsprechende Gruppen aufweisen. Hostmaterialien werden später ausführlicher dargelegt.

In einer weiteren Ausgestaltung kann vorgesehen sein, dass die Verbindung ein kondensiertes aromatisches oder heteroaromatisches Ringsystem mit mindestens 2, vorzugsweise drei kondensierten Ringen umfasst, welches gegebenenfalls substituiert sein kann.

Vorzugsweise umfasst mindestens einer der Reste $R^a$, $R^b$, $R^c$ und/oder R in Strukturen der Formeln (I) und/oder (II-1) bis (II-11) mindestens ein aromatisches oder heteroaromatisches Ringsystem mit zwei, vorzugsweise mit drei kondensierten aromatischen oder heteroaromatischen Ringen.

Bevorzugt kann vorgesehen sein, dass das aromatisches oder heteroaromatisches Ringsystem mit zwei, vorzugsweise mit drei kondensierten aromatischen oder heteroaromatischen Ringen ausgewählt ist aus den Gruppen der Formeln (Ar-1) bis (Ar-17)

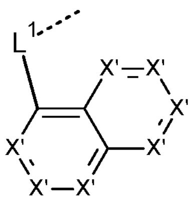

(Ar-1)

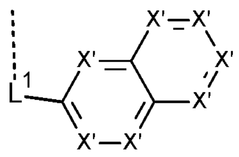

(Ar-2)

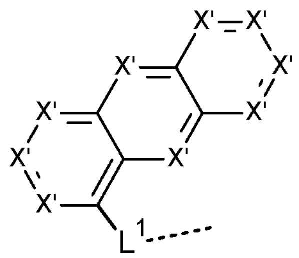

(Ar-3)

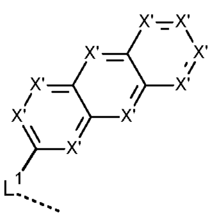

(Ar-4)

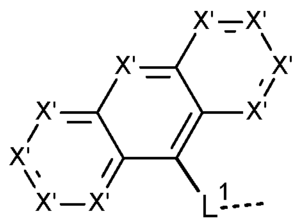

(Ar-5)

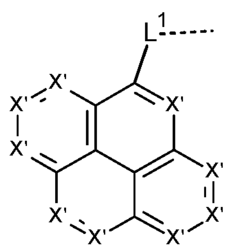

(Ar-6)

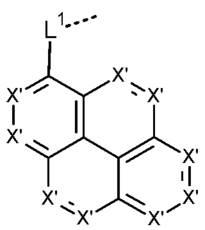

(Ar-7)

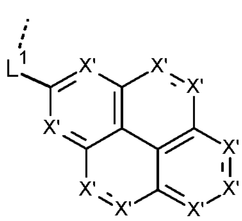

(Ar-8)

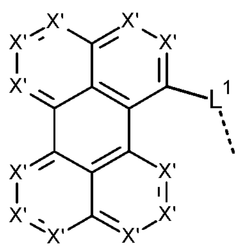

(Ar-9)

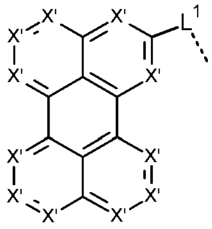

(Ar-10)

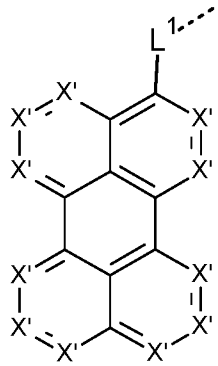

(Ar-11)

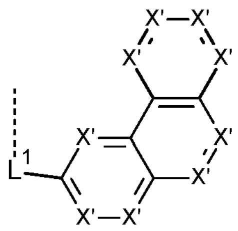

(Ar-12)

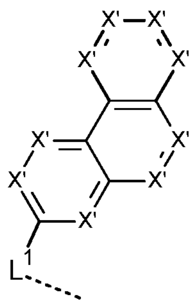

(Ar-13)

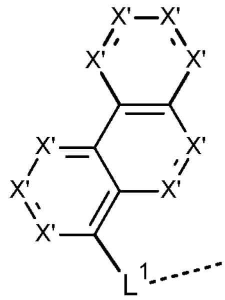

(Ar-14)

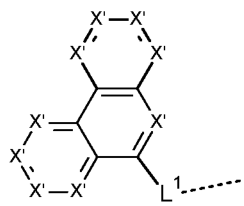

(Ar-15)

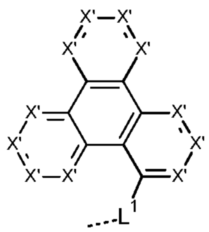

(Ar-16)

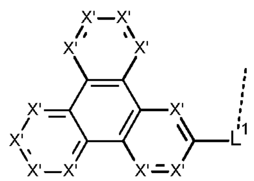

(Ar-17)

wobei X' N oder $CR^1$, vorzugsweise $CR^1$ ist, L' eine Bindung oder ein aromatisches oder heteroaromatisches Ringsystem mit 5 bis 40, bevorzugt 5 bis 30 aromatischen Ringatomen darstellt, welches durch einen oder mehrere Reste $R^1$ substituiert sein kann, wobei $R^1$ die zuvor, insbesondere für Formel (I) dargelegte Bedeutung hat und die gestrichelte Bindung die Anbindungsposition markiert.

Ganz besonders bevorzugt kann vorgesehen sein, dass das aromatisches oder heteroaromatisches Ringsystem mit zwei, vorzugsweise mit drei kondensierten aromatischen oder heteroaromatischen Ringen ausgewählt ist aus den Gruppen der Formeln (Ar'-1) bis (Ar'-17)

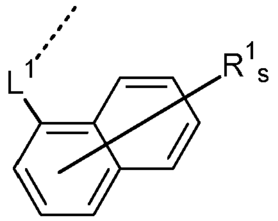
(Ar'-1)

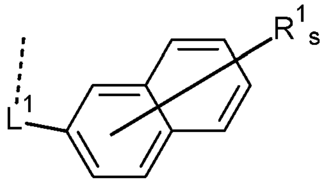
(Ar'-2)

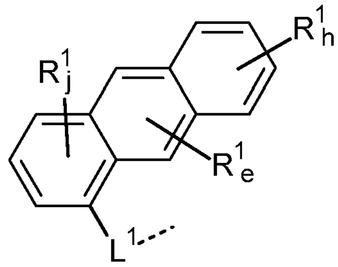
(Ar'-3)

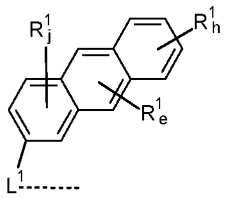
(Ar'-4)

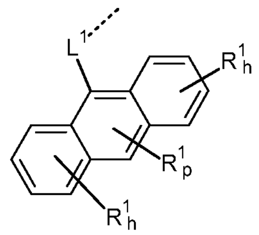
(Ar'-5)

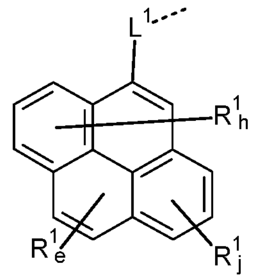
(Ar'-6)

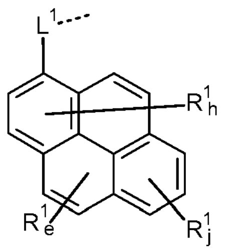
(Ar'-7)

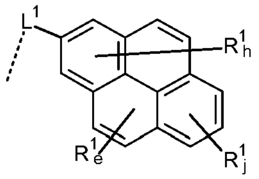
(Ar'-8)

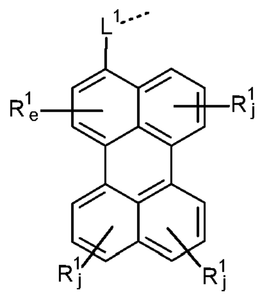
(Ar'-9)

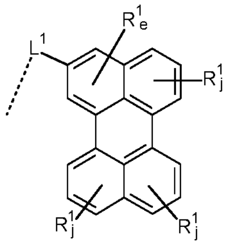
(Ar'-10)

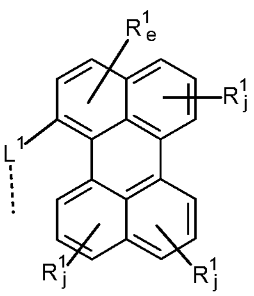
(Ar'-11)

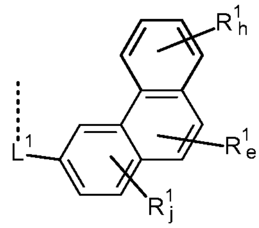
(Ar'-12)

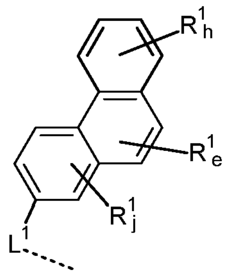

(Ar'-13)

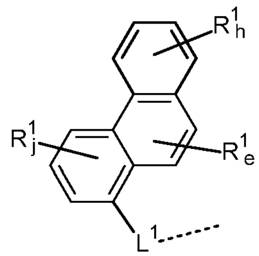

(Ar'-14)

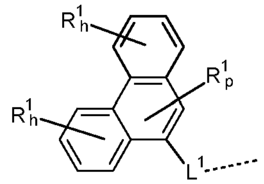

(Ar'-15)

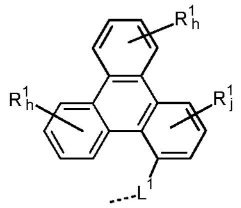

(Ar'-16)

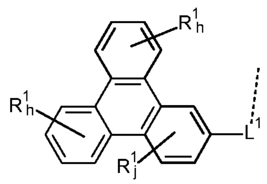

(Ar'-17)

wobei L' eine Bindung oder ein aromatisches oder heteroaromatisches Ringsystem mit 5 bis 40, bevorzugt 5 bis 30 aromatischen Ringatomen darstellt, welches durch einen oder mehrere Reste $R^1$ substituiert sein kann, wobei $R^1$ die zuvor, insbesondere für Formel (I) dargelegte Bedeutung hat, die gestrichelte Bindung die Anbindungsposition markiert und für die Indices gilt:

p ist 0 oder 1 ;

e ist 0, 1 oder 2, vorzugsweise 0 oder 1;

j ist bei jedem Auftreten unabhängig 0, 1, 2 oder 3, vorzugsweise 0,1 oder 2, besonders bevorzugt vorzugsweise 0 oder 1;

h ist bei jedem Auftreten unabhängig 0, 1, 2, 3 oder 4, vorzugsweise 0,1 oder 2, besonders bevorzugt vorzugsweise 0 oder 1;

s ist eine ganze Zahl im Bereich von 0 bis 7, vorzugsweise 0, 1, 2, 3, 4, 5 oder 6, besonders bevorzugt 0, 1, 2, 3 oder 4, speziell bevorzugt 0, 1 oder 2.

Vorzugsweise beträgt die Summe der Indices p, e, j, h und s in den Strukturen der Formel (Ar'-1) bis (Ar'-17) jeweils höchstens 3, vorzugsweise höchstens 2 und besonders bevorzugt höchstens 1.

Die zuvor dargelegten Strukturen der Formeln (Ar-1) bis (Ar-17) und/oder (Ar'-1) bis (Ar'-17) sind insbesondere bevorzugte Reste für Verbindungen, die sich zur Verwendung als fluoreszierender Emitter oder als blaue OLED-Materialien eignen.

In einer weiterhin bevorzugten Ausführungsform der vorliegenden Erfindung stellt die Gruppe L' in den zuvor dargelegten Strukturen der Formeln (Ar-1) bis (Ar-17) und/oder (Ar'-1) bis (Ar'-17) ein aromatisches oder heteroaromatisches Ringsystem mit 5 bis 40, bevorzugt 5 bis 30 aromatischen Ringatomen dar, welches durch einen oder mehrere Reste $R^1$ substituiert sein kann, wobei $R^1$ die zuvor, insbesondere für Formel (I) dargelegte Bedeutung hat.

Bevorzugt kann vorgesehen sein, dass die erfindungsgemäß einzusetzende Verbindung mindestens eine verbindende Gruppe umfasst, die ausgewählt ist aus den Formeln ($L^1$-1) bis ($L^1$-76), vorzugsweise in der Struktur gemäß Formeln (H-1) bis (H-26) die Gruppe $Ar^2$ ausgewählt ist aus den Formeln ($L^1$-1) bis ($L^1$-76) oder die Elektronentransportgruppe mit weiteren Strukturelementen über eine verbindende Gruppe verbunden ist, die ausgewählt ist aus den Formeln ($L^1$-1) bis ($L^1$-76) oder der Rest L' in Formeln (QL), (Ar-1) bis (Ar-17) und/oder (Ar'-1) bis (Ar'-17) für eine Gruppe steht, die ausgewählt ist aus den Formeln ($L^1$-1) bis ($L^1$-76),

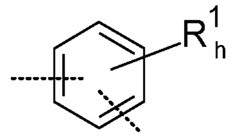

Formel ($L^1$-1)

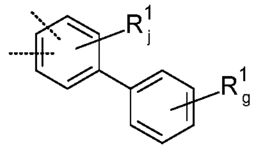

Formel ($L^1$-2)

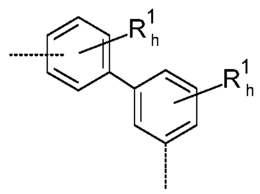

Formel ($L^1$-3)

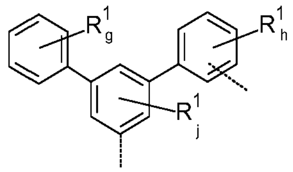

Formel ($L^1$-4)

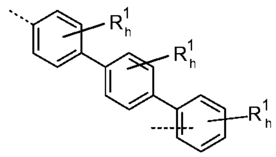

Formel ($L^1$-5)

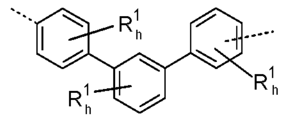

Formel ($L^1$-6)

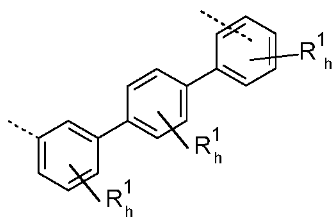

Formel ($L^1$-7)

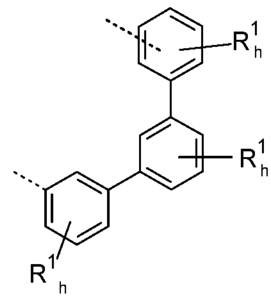

Formel ($L^1$-8)

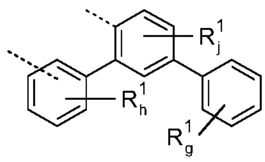

Formel ($L^1$-9)

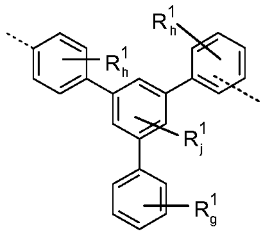

Formel ($L^1$-10)

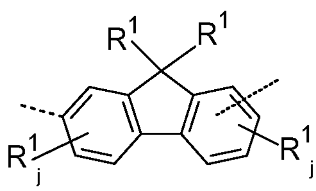

Formel ($L^1$-11)

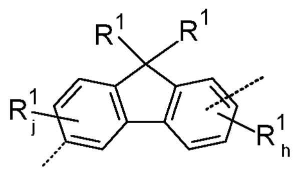

Formel ($L^1$-12)

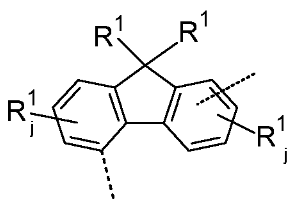

Formel ($L^1$-13)

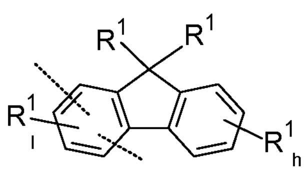

Formel ($L^1$-14)

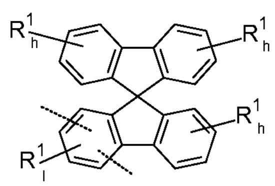

Formel ($L^1$-15)

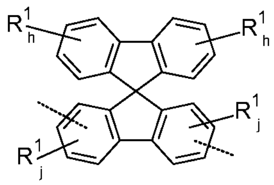

Formel ($L^1$-16)

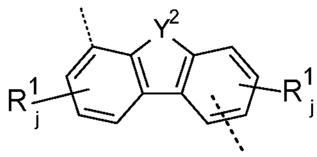

Formel ($L^1$-17)

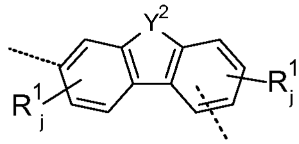

Formel ($L^1$-18)

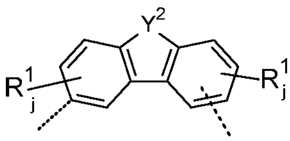

Formel ($L^1$-19)

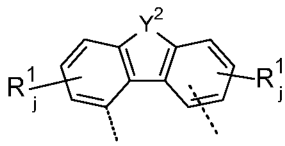

Formel ($L^1$-20)

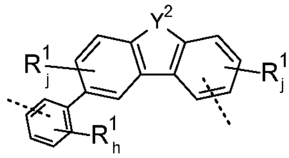

Formel ($L^1$-21)

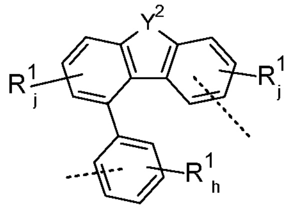

Formel ($L^1$-22)

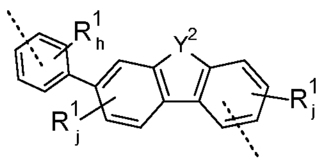

Formel ($L^1$-23)

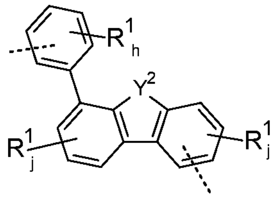

Formel ($L^1$-24)

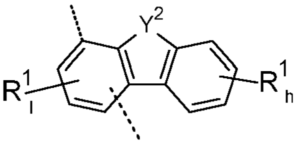

Formel ($L^1$-25)

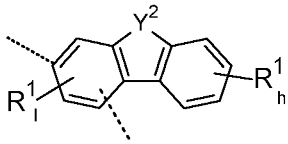

Formel ($L^1$-26)

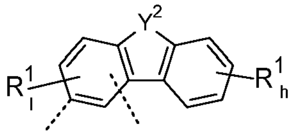

Formel ($L^1$-27)

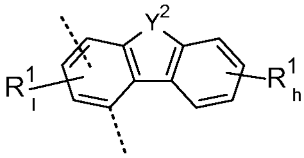

Formel ($L^1$-28)

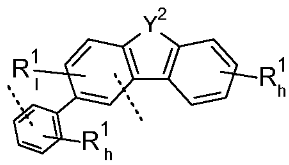

Formel ($L^1$-29)

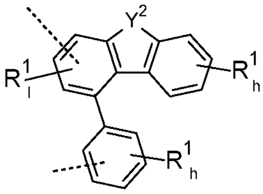

Formel ($L^1$-30)

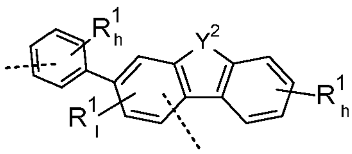

Formel ($L^1$-31)

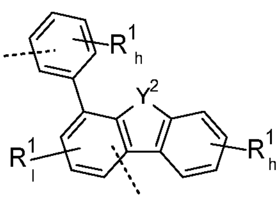

Formel ($L^1$-32)

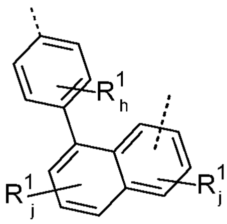

Formel ($L^1$-33)

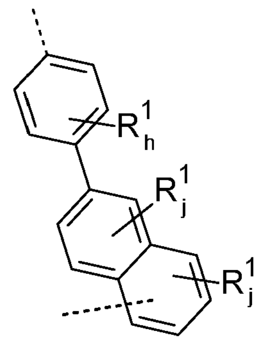
Formel ($L^1$-34)

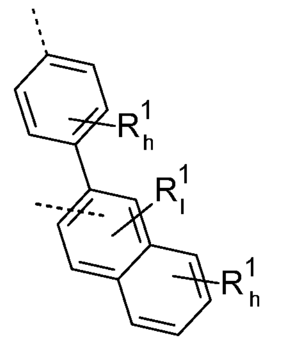
Formel ($L^1$-35)

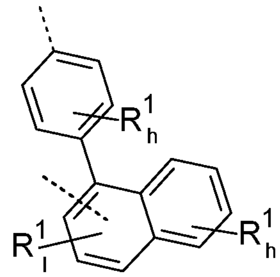
Formel ($L^1$-36)

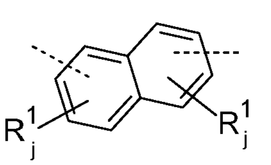
Formel ($L^1$-37)

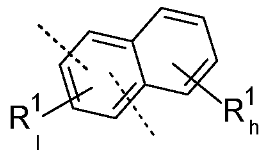
Formel ($L^1$-38)

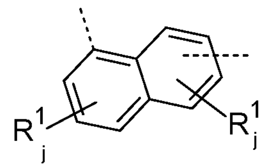
Formel ($L^1$-39)

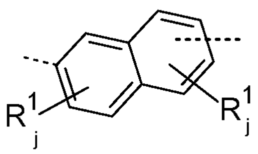
Formel ($L^1$-40)

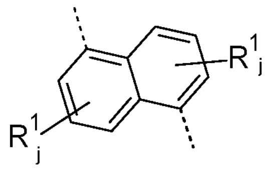
Formel ($L^1$-41)

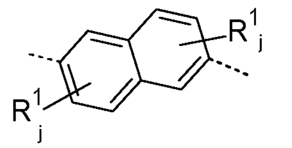
Formel ($L^1$-42)

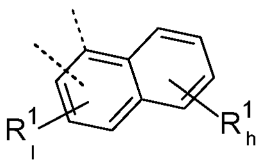
Formel ($L^1$-43)

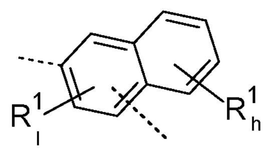
Formel ($L^1$-44)

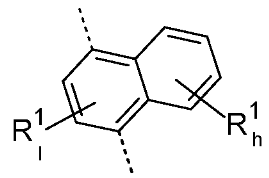
Formel ($L^1$-45)

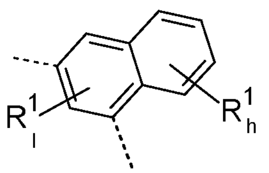
Formel ($L^1$-46)

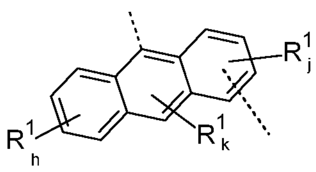
Formel ($L^1$-47)

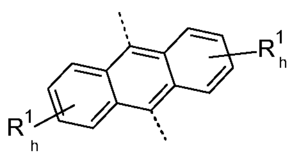
Formel ($L^1$-48)

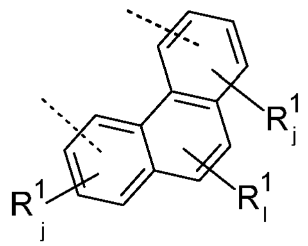

Formel ($L^1$-49)

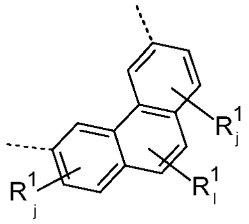

Formel ($L^1$-50)

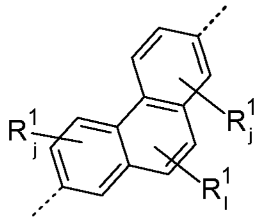

Formel ($L^1$-51)

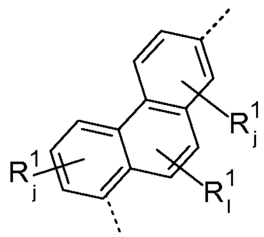

Formel ($L^1$-52)

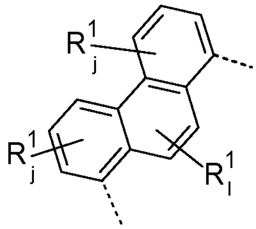

Formel ($L^1$-53)

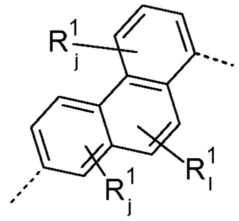

Formel ($L^1$-54)

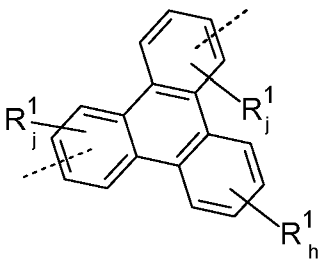

Formel ($L^1$-55)

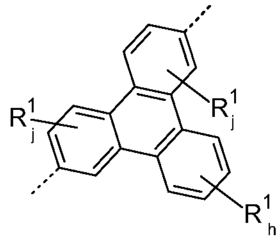

Formel ($L^1$-56)

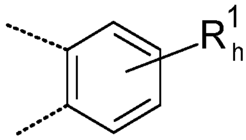

Formel ($L^1$-57)

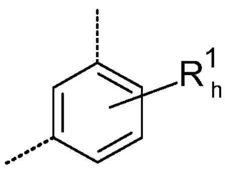

Formel ($L^1$-58)

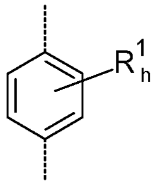

Formel ($L^1$-59)

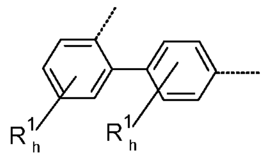

Formel ($L^1$-60)

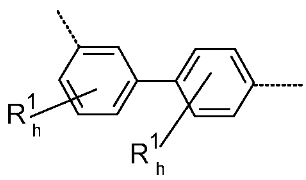

Formel ($L^1$-61)

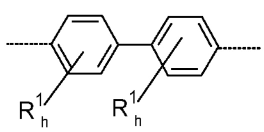

Formel ($L^1$-62)

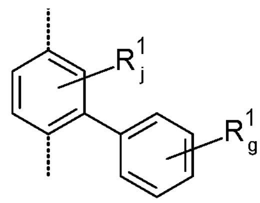

Formel ($L^1$-63)

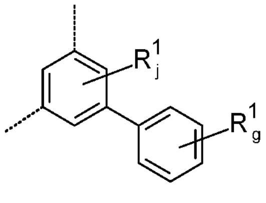

Formel ($L^1$-64)

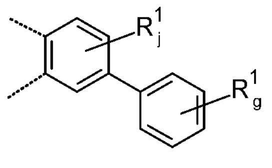

Formel ($L^1$-65)

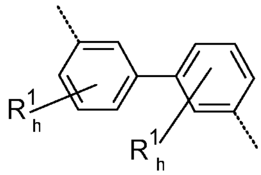

Formel ($L^1$-66)

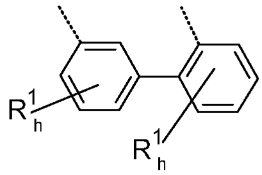

Formel ($L^1$-67)

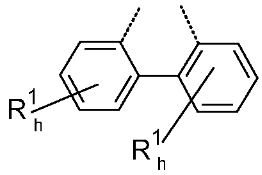

Formel ($L^1$-68)

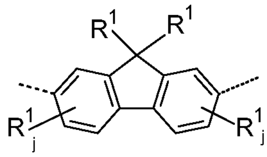

Formel ($L^1$-69)

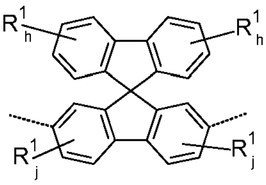

Formel ($L^1$-70)

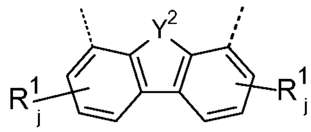

Formel ($L^1$-71)

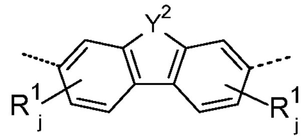

Formel ($L^1$-72)

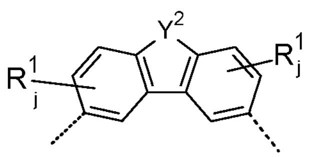

Formel ($L^1$-73)

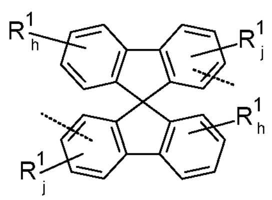

Formel ($L^1$-74)

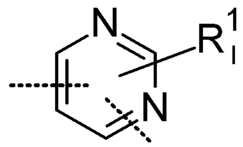

Formel ($L^1$-75)

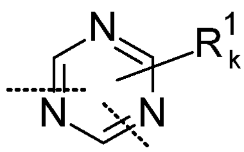

Formel ($L^1$-76)

wobei die gestrichelten Bindungen jeweils die Anbindungspositionen markieren, der Index k 0 oder 1 ist, der Index l 0, 1 oder 2 ist, der Index j bei jedem Auftreten unabhängig 0, 1, 2 oder 3 ist; der Index h bei jedem Auftreten unabhängig 0, 1, 2, 3 oder 4 ist, der Index g 0, 1, 2, 3, 4 oder 5 ist; das Symbol $Y^2$ O, S, $BR^1$ oder $NR^1$, vorzugsweise O oder S ist; und das Symbol $R^1$ die zuvor, insbesondere für Formel (I) genannte Bedeutung aufweist.

Vorzugsweise kann vorgesehen sein, dass die Summe der Indices k, l, g, h und j in den Strukturen der Formel ($L^1$-1) bis ($L^1$-76) jeweils höchstens 3, vorzugsweise höchstens 2 und besonders bevorzugt höchstens 1 beträgt.

Bevorzugte Verbindungen mit einer Gruppe der Formeln (H-1) bis (H-26) umfassen eine Gruppe $Ar^2$, die ausgewählt ist aus einer der Formeln ($L^1$-1) bis ($L^1$-46) und/oder ($L^1$-57) bis ($L^1$-76), bevorzugt der Formel ($L^1$-1) bis ($L^1$-32) und/oder ($L^1$-57) bis ($L^1$-76), speziell bevorzugt der Formel ($L^1$-1) bis ($L^1$-10) und/oder ($L^1$-57) bis ($L^1$-68). Mit Vorteil kann die Summe der Indices k, l, g, h und j in den Strukturen der Formeln ($L^1$-1) bis ($L^1$-46) und/oder ($L^1$-57) bis ($L^1$-76), bevorzugt der Formel ($L^1$-1) bis ($L^1$-32) und/oder ($L^1$-57) bis ($L^1$-76), speziell bevorzugt der Formel ($L^1$-1) bis ($L^1$-10) und/oder ($L^1$-57) bis ($L^1$-68) jeweils höchstens 3, vorzugsweise höchstens 2 und besonders bevorzugt höchstens

1 betragen.

Bevorzugte Verbindungen mit einer Gruppe der Formel (QL) umfassen eine Gruppe L', die eine Bindung darstellt oder die ausgewählt ist aus einer der Formeln ($L^1$-1) bis ($L^1$-46) und/oder ($L^1$-57) bis ($L^1$-76), bevorzugt der Formel ($L^1$-1) bis ($L^1$-32) und/oder ($L^1$-57) bis ($L^1$-76), speziell bevorzugt der Formel ($L^1$-1) bis ($L^1$-10) und/oder ($L^1$-57) bis ($L^1$-68). Mit Vorteil kann die Summe der Indices k, l, g, h und j in den Strukturen der Formeln ($L^1$-1) bis ($L^1$-46) und/oder ($L^1$-57) bis ($L^1$-76), bevorzugt der Formel ($L^1$-1) bis ($L^1$-32) und/oder ($L^1$-57) bis ($L^1$-76), speziell bevorzugt der Formel ($L^1$-1) bis ($L^1$-10) und/oder ($L^1$-57) bis ($L^1$-68) jeweils höchstens 3, vorzugsweise höchstens 2 und besonders bevorzugt höchstens 1 betragen.

Bevorzugte Verbindungen mit einer Gruppe der Formeln (Ar-1) bis (Ar-17) und/oder (Ar'-1) bis (Ar'-17) umfassen eine Gruppe $L^1$, die eine Bindung darstellt oder die ausgewählt ist aus einer der Formeln ($L^1$-1) bis ($L^1$-46) und/oder ($L^1$-57) bis ($L^1$-76), bevorzugt der Formel ($L^1$-1) bis ($L^1$-32) und/oder ($L^1$-57) bis ($L^1$-76), speziell bevorzugt der Formel ($L^1$-1) bis ($L^1$-10) und/oder ($L^1$-57) bis ($L^1$-68). Mit Vorteil kann die Summe der Indices k, l, g, h und j in den Strukturen der Formeln ($L^1$-1) bis ($L^1$-46) und/oder ($L^1$-57) bis ($L^1$-76), bevorzugt der Formel ($L^1$-1) bis ($L^1$-32) und/oder ($L^1$-57) bis ($L^1$-76), speziell bevorzugt der Formel ($L^1$-1) bis ($L^1$-10) und/oder ($L^1$-57) bis ($L^1$-68) jeweils höchstens 3, vorzugsweise höchstens 2 und besonders bevorzugt höchstens 1 betragen.

Bevorzugt bilden die Reste $R^1$ in den Formeln ($L^1$-1) bis ($L^1$-76) mit den Ringatomen der Arylgruppe oder Heteroarylgruppe, an die die Reste $R^1$ gebunden sind, kein kondensiertes aromatisches oder heteroaromatisches Ringsystem, vorzugsweise kein kondensiertes Ringsystem.

Wenn die aromatische und/oder heteroaromatische Gruppen durch Substituenten $R^1$ substituiert sind, dann sind diese Substituenten $R^1$ bevorzugt gewählt aus der Gruppe bestehend aus H, D, F, CN, $N(Ar'')_2$, C(=O) Ar'', P(=O)( Ar'')$_2$, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen oder einer Alkenylgruppe mit 2 bis 10 C-Atomen, die jeweils mit einem oder mehreren Resten $R^2$ substituiert sein kann, wobei eine oder mehrere nicht-benachbarte $CH_2$-Gruppen durch O ersetzt sein können und wobei ein oder mehrere H-Atome durch D oder F ersetzt sein können, einem aromatischen oder heteroaromatischen Ringsystem mit 5 bis 24 aromatischen Ringatomen, das jeweils mit einem oder mehreren Resten $R^2$ substituiert sein kann, bevorzugt aber unsubstituiert ist, oder einer Aralkyl- oder Heteroaralkylgruppe mit 5 bis 25 aromatischen Ringatomen, die mit einem oder mehreren Resten $R^2$ substituiert sein kann; dabei können optional zwei Substituenten $R^1$, die vorzugsweise an benachbarte Kohlenstoffatome gebunden sind, ein monocyclisches oder polycyclisches, aliphatisches, aromatisches oder heteroaromatisches Ringsystem bilden, das mit einem oder mehreren Resten $R^1$ substituiert sein kann, wobei die Gruppe Ar'' die zuvor, insbesondere für Formel (I) genannte Bedeutung aufweist.

Besonders bevorzugt sind diese Substituenten $R^1$ ausgewählt aus der Gruppe bestehend aus H, D, F, CN, $N(Ar'')_2$, einer geradkettigen Alkylgruppe mit 1 bis 8 C-Atomen, bevorzugt mit 1, 2, 3 oder 4 C-Atomen, oder einer verzweigten oder cyclischen Alkylgruppe mit 3 bis 8 C-Atomen, bevorzugt mit 3 oder 4 C-Atomen, oder einer Alkenylgruppe mit 2 bis 8 C-Atomen, bevorzugt mit 2, 3 oder 4 C-Atomen, die jeweils mit einem oder mehreren Resten $R^2$ substituiert sein kann, bevorzugt aber unsubstituiert ist, oder einem aromatischen oder heteroaromatischen Ringsystem mit 5 bis 24 aromatischen Ringatomen, bevorzugt mit 6 bis 18 aromatischen Ringatomen, besonders bevorzugt mit 6 bis 13 aromatischen Ringatomen, das jeweils mit einem oder mehreren nicht-aromatischen Resten $R^1$ substituiert sein kann, bevorzugt aber unsubstituiert ist; dabei können optional zwei Substituenten $R^1$, vorzugsweise die an benachbarte Kohlenstoffatome gebunden sind, ein monocyclisches oder polycyclisches, aliphatisches Ringsystem bilden, das mit einem oder mehreren Resten $R^2$ substituiert sein kann, bevorzugt aber unsubstituiert ist, wobei $Ar^1$ die zuvor dargelegte Bedeutung aufweisen kann.

Ganz besonders bevorzugt sind die Substituenten $R^1$ ausgewählt aus der Gruppe bestehend aus H oder einem aromatischen oder heteroaromatischen Ringsystem mit 6 bis 18 aromatischen Ringatomen, bevorzugt mit 6 bis 13 aromatischen Ringatomen, das jeweils mit einem oder mehreren nicht-aromatischen Resten $R^2$ substituiert sein kann, bevorzugt aber unsubstituiert ist. Beispiele für geeignete Substituenten $R^1$ sind ausgewählt aus der Gruppe bestehend aus Phenyl, ortho-, meta- oder para-Biphenyl, Terphenyl, insbesondere verzweigtes Terphenyl, Quaterphenyl, insbesondere verzweigtes Quaterphenyl, 1-, 2-, 3- oder 4-Fluorenyl, 1-, 2-, 3- oder 4-Spirobifluorenyl, Pyridyl, Pyrimidinyl, 1-, 2-, 3- oder 4-Dibenzofuranyl, 1-, 2-, 3- oder 4-Dibenzothienyl, 1-, 2-, 3- oder 4-Carbazolyl und Indenocarbazolyl, die jeweils durch einen oder mehrere Reste $R^2$ substituiert sein können, bevorzugt aber unsubstituiert sind.

Weiterhin kann vorgesehen sein, dass die Substitutenten $R^1$ eines aromatischen oder heteroaromatischen Ringssystems mit weiteren Ringatomen des aromatischen oder heteroaromatischen Ringssystems kein kondensiertes aromatisches oder heteroaromatisches Ringsystem, vorzugsweise kein kondensiertes Ringsystem bilden. Dies schließt die Bildung eines kondensierten Ringsystems mit möglichen Substituenten $R^2$ ein, die an die Reste $R^1$ gebunden sein können.

Weiterhin kann vorgesehen sein, dass in einer Struktur gemäß Formel Formeln (I) und/oder (II-1) bis (II-11) mindestens ein Rest $R^1$ oder Ar'' für eine Gruppe steht, die ausgewählt ist aus den Formeln ($R^1$-1) bis ($R^1$-43), beziehungsweise in einer Struktur gemäß Formel (H-1) bis (H-26), (QL), (Q-1) bis (Q-44), (Ar-1) bis (Ar-17) und/oder (Ar'-1)

bis (Ar'-17) mindestens ein $R^1$ für eine Gruppe steht, die ausgewählt ist aus den Formeln ($R^1$-1) bis ($R^1$- 43)

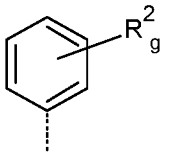

Formel ($R^1$-1)

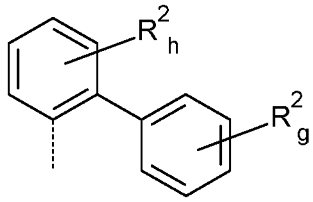

Formel ($R^1$-2)

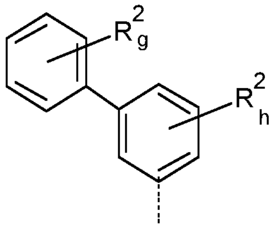

Formel ($R^1$-3)

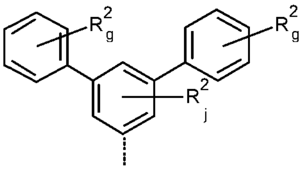

Formel ($R^1$-4)

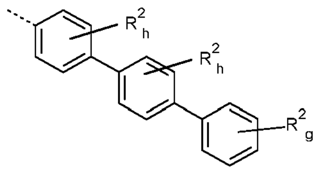

Formel ($R^1$-5)

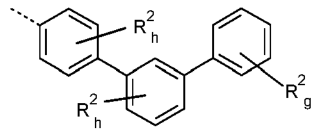

Formel ($R^1$-6)

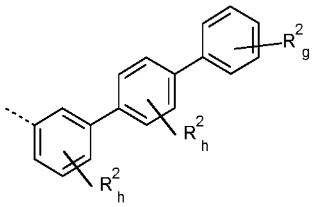

Formel ($R^1$-7)

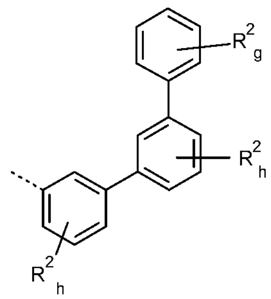

Formel ($R^1$-8)

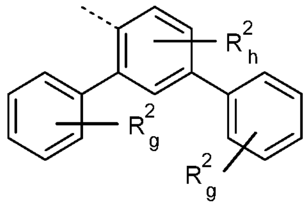

Formel ($R^1$-9)

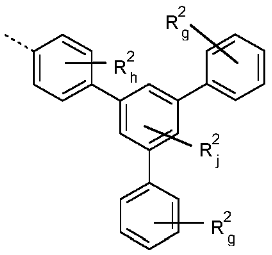

Formel ($R^1$-10)

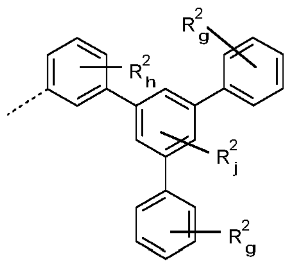

Formel ($R^1$-11)

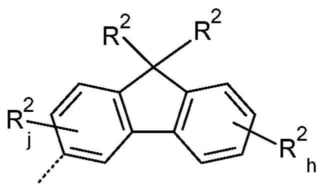

Formel ($R^1$-12)

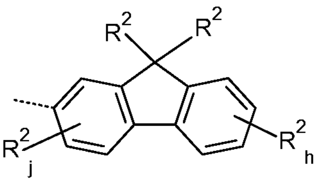

Formel ($R^1$-13)

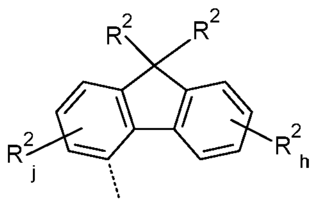

Formel ($R^1$-14)

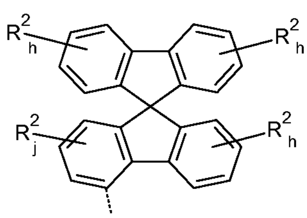

Formel ($R^1$-15)

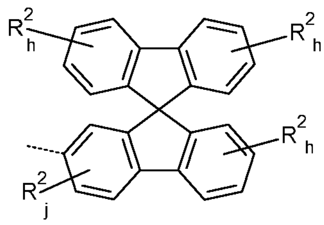

Formel ($R^1$-16)

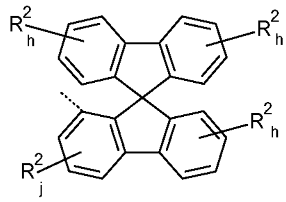

Formel ($R^1$-17)

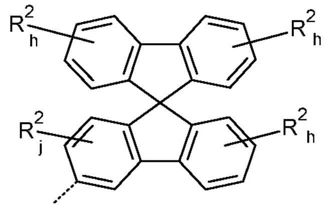

Formel ($R^1$-18)

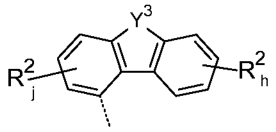

Formel ($R^1$-19)

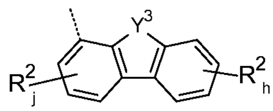

Formel ($R^1$-20)

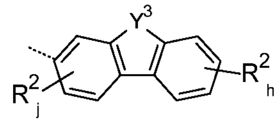

Formel ($R^1$-21)

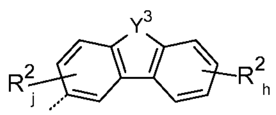

Formel ($R^1$-22)

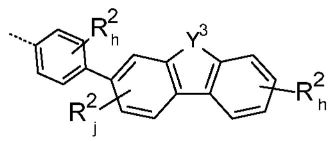

Formel ($R^1$-23)

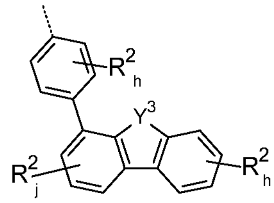

Formel ($R^1$-24)

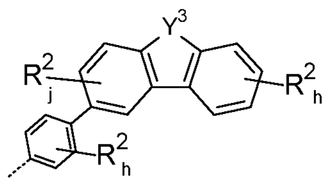

Formel ($R^1$-25)

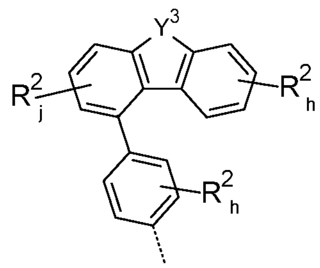

Formel ($R^1$-26)

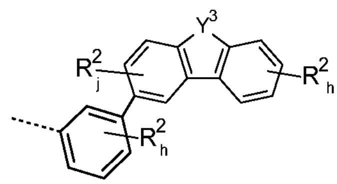

Formel ($R^1$-27)

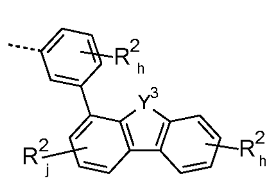

Formel ($R^1$-28)

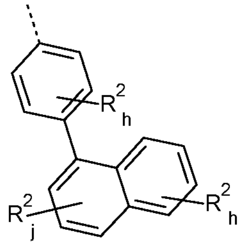

Formel ($R^1$-29)

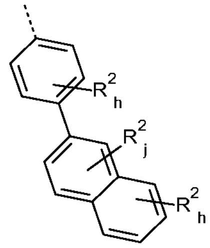

Formel ($R^1$-30)

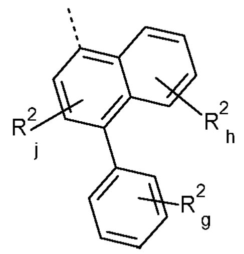

Formel ($R^1$-31)

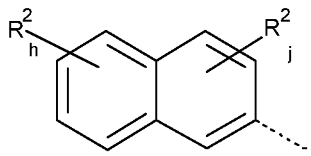

Formel ($R^1$-32)

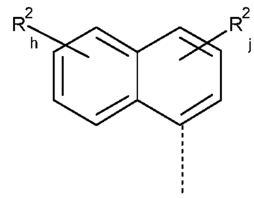

Formel ($R^1$-33)

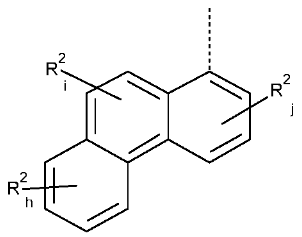

Formel ($R^1$-34)

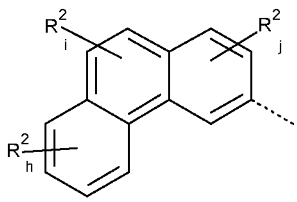

Formel ($R^1$-35)

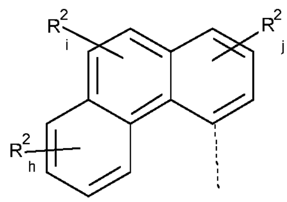

Formel ($R^1$-36)

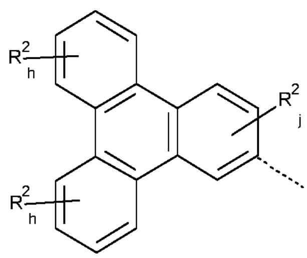

Formel ($R^1$-37)

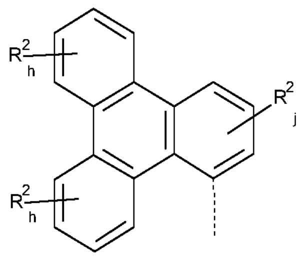

Formel ($R^1$-38)

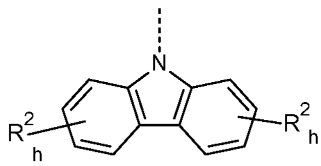

Formel ($R^1$-39)

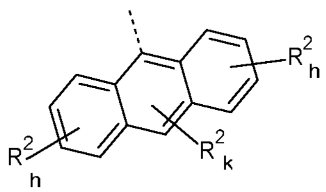

Formel ($R^1$-40)

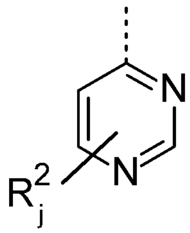

Formel ($R^1$-41)

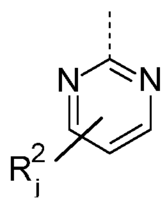

Formel ($R^1$-42)

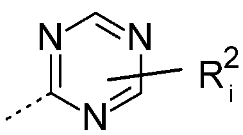

Formel ($R^1$-43)

wobei für die verwendeten Symbole gilt:

$Y^3$ ist O, S oder $NR^2$, vorzugsweise O oder S;

k ist bei jedem Auftreten unabhängig 0 oder 1 ;

i ist bei jedem Auftreten unabhängig 0, 1 oder 2;

j ist bei jedem Auftreten unabhängig 0, 1, 2 oder 3;
h ist bei jedem Auftreten unabhängig 0, 1, 2, 3 oder 4;
g ist bei jedem Auftreten unabhängig 0, 1, 2, 3, 4 oder 5;
$R^2$ kann die zuvor genannte, insbesondere für Formel (I) genannte Bedeutung aufweisen und

die gestrichelte Bindung markiert die Anbindungsposition.

Hierbei sind die Gruppen der Formeln $R^1$-1 bis $R^1$-28 bevorzugt, wobei die Gruppen $R^1$-1, $R^1$-3, $R^1$-4, $R^1$-10, $R^1$-11, $R^1$-12, $R^1$-13, $R^1$-14, $R^1$-16, $R^1$-17, $R^1$-18, $R^1$-19, $R^1$-20, $R^1$-21 und/oder $R^1$-22 besonders bevorzugt sind. Vorzugsweise kann vorgesehen sein, dass die Summe der Indices k, i, j, h und g in den Strukturen der Formel ($R^1$-1) bis ($R^1$-43) jeweils höchstens 3, vorzugsweise höchstens 2 und besonders bevorzugt höchstens 1 beträgt.

Bevorzugt bilden die Reste $R^2$ in den Formeln ($R^1$-1) bis ($R^1$-43) mit den Ringatomen der Arylgruppe oder Heteroarylgruppe, an die die Reste $R^2$ gebunden sind, kein kondensiertes aromatisches oder heteroaromatisches Ringsystem, vorzugsweise kein kondensiertes Ringsystem.

Die zuvor dargelegten Reste der Formeln ($R^1$-1) bis ($R^1$-43) stellen bevorzugte Reste Ar gemäß Formel (I) beziehungsweise $Ar^3$, $Ar^4$ gemäß Formeln (H-1) bis (H-3) oder bevorzugte Ausführungsformen dieser Formeln dar, wobei in diesem Fall die in den Formeln ($R^1$-1) bis ($R^1$-43) dargelegten Gruppen $R^2$ durch Reste $R^1$ zu ersetzen sind. Die zuvor dargelegten Bevorzugungen hinsichtlich der Formeln ($R^1$-1) bis ($R^1$-43) gelten entsprechend.

Gemäß einer bevorzugten Ausgestaltung ist eine erfindungsgemäß einsetzbare Verbindung durch mindestens eine der Strukturen gemäß Formel (I) und/oder (II-1) bis (II-11) darstellbar. Vorzugsweise weisen Verbindungen, umfassend Strukturen gemäß Formel (I) und/oder (II-1) bis (II-11), ein Molekulargewicht von kleiner oder gleich 5000 g/mol, bevorzugt kleiner oder gleich 4000 g/mol, insbesondere bevorzugt kleiner oder gleich 3000 g/mol, speziell bevorzugt kleiner oder gleich 2000 g/mol und ganz besonders bevorzugt kleiner oder gleich 1200 g/mol auf.

Weiterhin zeichnen sich bevorzugte erfindungsgemäß einsetzbare Verbindungen dadurch aus, dass diese sublimierbar sind. Diese Verbindungen weisen im Allgemeinen eine Molmasse von weniger als ca. 1200 g/mol auf.

Wenn die erfindungsgemäße Verbindung mit aromatischen oder heteroaromatischen Gruppen $R^1$ bzw. $R^2$ substituiert ist, so ist es bevorzugt, wenn diese keine Aryl- oder Heteroarylgruppen mit mehr als zwei direkt aneinander kondensierten aromatischen Sechsringen aufweisen.

Besonders bevorzugt weisen die Substituenten überhaupt keine Aryl- oder Heteroarylgruppen mit direkt aneinander kondensierten Sechsringen auf. Diese Bevorzugung ist mit der geringen Triplettenergie derartiger Strukturen zu begründen. Kondensierte Arylgruppen mit mehr als zwei direkt aneinander kondensierten aromatischen Sechsringen, die dennoch auch erfindungsgemäß geeignet sind, sind Phenanthren und Triphenylen, da auch diese ein hohes Triplettniveau aufweisen.

Bei Ausgestaltung der erfindungsgemäßen Verbindungen zur Verwendung als fluoreszierender Emitter oder als blaue OLED-Materialien können bevorzugte Verbindungen entsprechende Gruppen, beispielsweise Fluoren-, Anthracen- und/oder Pyren-Gruppen enthalten, die mit Gruppen $R^1$ oder $R^2$ substituiert sein können oder die durch entsprechende Substituition der Gruppen ($L^1$-1) bis ($L^1$-76) oder ($R^1$-1) bis ($R^1$-43) mit den Substituenten $R^1$ oder $R^2$ gebildet werden.

In einer weiteren bevorzugten Ausführungsform der Erfindung ist $R^2$, beispielsweise bei einer Struktur gemäß Formeln (I) und/oder (II-1) bis (II-11) sowie bevorzugten Ausführungsformen dieser Struktur oder den Strukturen, bei denen Bezug auf diese Formeln genommen wird, bei jedem Auftreten gleich oder verschieden ausgewählt aus der Gruppe bestehend aus H, D, F, CN, einem aliphatischen Kohlenwasserstoffrest mit 1 bis 10 C-Atomen, bevorzugt mit 1, 2, 3 oder 4 C-Atomen, oder einem aromatischen oder heteroaromatischen Ringsystem mit 5 bis 30 aromatischen Ringatomen, bevorzugt mit 5 bis 24 aromatischen Ringatome, besonders bevorzugt mit 5 bis 13 aromatischen Ringatomen, das durch ein oder mehrere Alkylgruppen mit jeweils 1 bis 4 Kohlenstoffatomen substituiert sein kann, bevorzugt aber unsubstituiert ist.

Bevorzugt bilden die Reste $R^2$ mit den Ringatomen der Arylgruppe oder Heteroarylgruppe, an die die Reste $R^2$ gebunden sind, kein kondensiertes aromatisches oder heteroaromatisches Ringsystem, vorzugsweise kein kondensiertes Ringsystem.

Ferner kann vorgesehen sein, dass die erfindungsgemäße Verbindung nicht in unmittelbaren Kontakt mit einem Metallatom steht, vorzugsweise kein Ligand für einen Metallkomplex darstellt.

Nochmals ein weiterer Gegenstand der vorliegenden Erfindung ist eine Verbindung umfassend mindestens eine Struktur der Formel (III), vorzugsweise Verbindung gemäß der Formel (III),

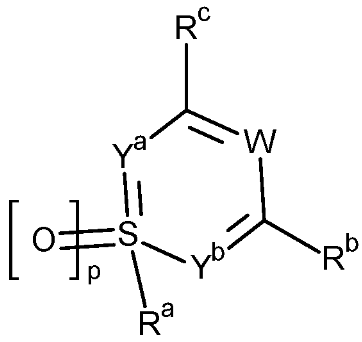

Formel (III)

wobei die Symbole p, $R^a$, $R^b$, $R^c$, $Y^a$, $Y^b$ und W die zuvor, insbesondere für Formel (I) genannten Bedeutungen aufweisen und mindestens einer der Reste $R^a$, $R^b$, $R^c$, $Y^a$, $Y^b$ und Weine Gruppe HetAr umfasst oder darstellt, wobei HetAr für eine Gruppe steht, die ausgewählt ist aus den oben dargestellten Formeln (H-1) bis (H-26) oder (Q-11) bis (Q-30) , wobei die Gruppe HetAr mit einem Rest R, einer Gruppe $R^a$, $R^b$, $R^c$, $Y^a$, $Y^b$ oder einer weiteren Gruppe ein Ringsystem bilden kann.

In einer bevorzugten Ausgestaltung kann die erfindungsgemäße Verbindung mindestens eine Struktur der Formel (IIIa) umfassen, vorzugsweise ausgewählt sein aus den Verbindungen der Formel (IIIa),

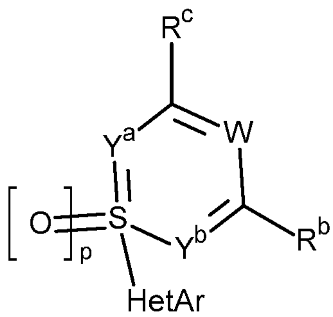

Formel (IIIa)

wobei die Symbole p, $R^b$, $R^c$, $Y^a$, $Y^b$ und W die zuvor, insbesondere für Formel (I) genannten Bedeutungen aufweisen und HetArfür eine Gruppe steht, die ausgewählt ist aus den oben dargestellten Formeln (H-1) bis (H-26) oder (Q-11) bis (Q-30) , wobei die Gruppe HetAr mit einem Rest R, einer Gruppe $R^a$, $R^b$, $R^c$, $Y^a$, $Y^b$ oder einer weiteren Gruppe ein Ringsystem bilden kann.

In einer weiterhin bevorzugten Ausgestaltung kann vorgesehen sein, dass die erfindungsgemäßen Verbindungen eine Struktur der Formel (IV-1) bis (IV-14) umfassen, wobei die erfindungsgemäßen Verbindungen besonders bevorzugt ausgewählt sind aus den Verbindungen der Formel (IV-1) bis (IV-14),

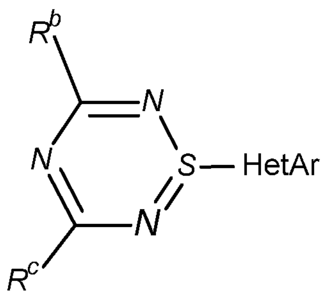

Formel (IV-1)

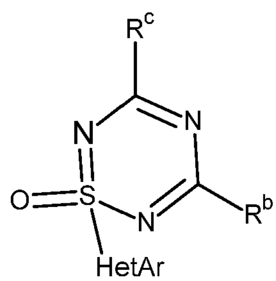

Formel (IV-2)

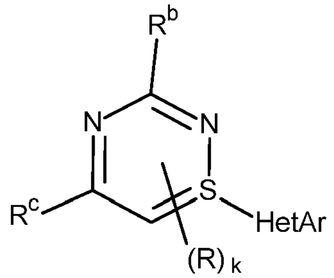

Formel (IV-3)

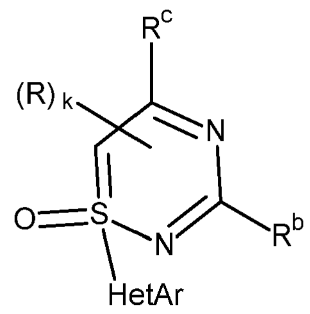

Formel (IV-4)

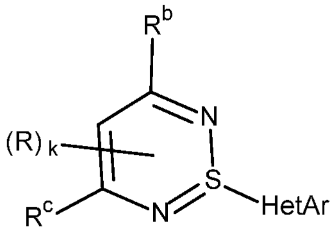

Formel (IV-5)

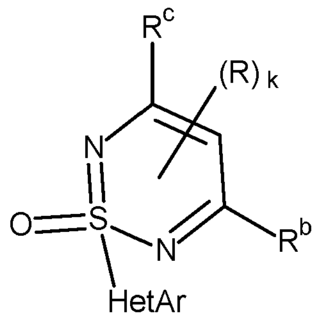

Formel (IV-6)

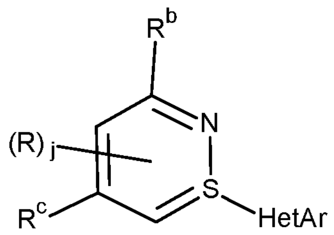

Formel (IV-7)

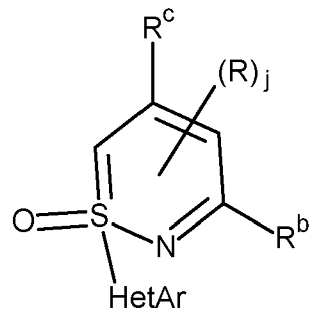

Formel (IV-8)

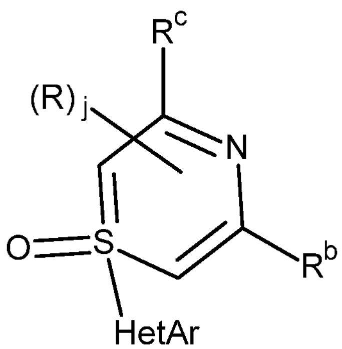

Formel (IV-9)

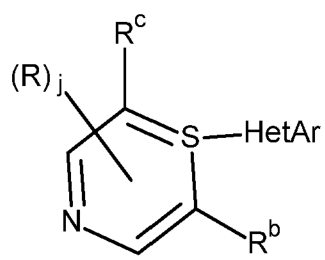

Formel (IV-10)

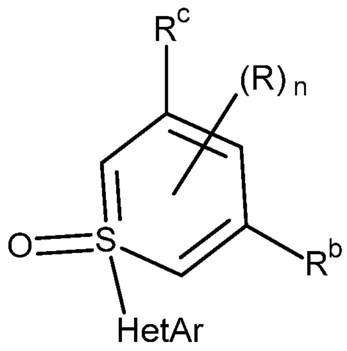

Formel (IV-11)

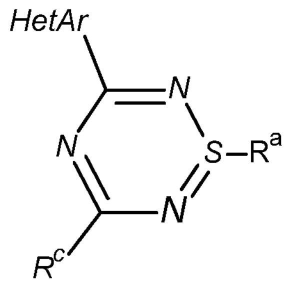

Formel (IV-12)

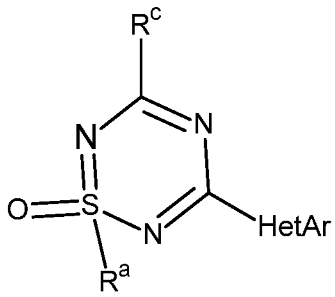

Formel (IV-13)

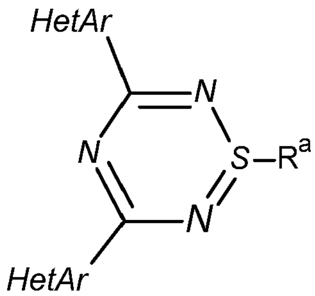

Formel (IV-14)

wobei die Symbole $R^a$, $R^b$, $R^c$, und R die zuvor, insbesondere für Formel (I) genannten Bedeutungen aufweisen, der Index n 0, 1, 2 oder 3, vorzugsweise 0, 1 oder 2 ist, der Index j 0, 1 oder 2 ist, der Index k 0 oder 1 ist und HetAr die zuvor für Formel (III) genannte Bedeutung aufweist, vorzugsweise für eine Gruppe steht, die ausgewählt ist aus den zuvor definierten Formeln (H-1) bis (H-26) oder die ausgewählt ist aus den zuvor definierten Formeln (QL) und (Q-1) bis (Q-44).

Besonders bevorzugt sind weiterhin erfindungsgemäße Verbindungen mit Strukturen der Formel (IV-1), (IV-2), (IV-3), (IV-4), (IV-5), (IV-6), (IV-7), (IV-8), (IV-9), (IV-10), (IV-11), (IV-12), (IV-13) und/oder (IV-14), welche die folgenden Eigenschaften aufweisen:

| HetAr umfasst eine der Gruppen | vorzugsweise | besonders bevorzugt | ganz besonders bevorzugt |
|---|---|---|---|
| H-1 bis H-26 | H-1 - H-11 und H-15 bis H-17 | H-1 bis H-11 | H-1 |
| H-1 bis H-26 | H-4 bis H-26 | H-4 bis H-11 und H-15 bis H-17 | H4, H-5 |
| QL | Q-11 bis Q-25, | Q-16 bis 19 und Q-23 bis Q-25 | Q-23 |
| QL | Q-26 bis Q44 | Q-33 bis Q-42 | Q-35 |

Hierbei umfassen die Gruppen der Formeln Q-11 bis Q-25 der in der zuvor dargelegten Tabelle dargelegten Verbindungen mit Strukturen der Formel (IV-1) bis (IV-14) Reste $R^1$, die vorzugsweise ein aromatisches oder heteroaromatisches Ringsystem mit 6 bis 18 aromatischen Ringatomen, bevorzugt mit 6 bis 13 aromatischen Ringatomen darstellen, das jeweils mit einem oder mehreren nicht-aromatischen Resten $R^2$ substituiert sein kann; vorzugsweise weisen die Gruppen der Formeln Q-11 bis Q-25 der in der zuvor dargelegten Tabelle dargelegten Verbindungen mit Strukturen der Formel (IV-1) bis (IV-14) mindestens einen Rest $R^1$, bevorzugt mindestens zwei Reste $R^1$ auf, der/die ausgewählt ist/sind aus aus den Formeln ($R^1$-1) bis ($R^1$- 43), vorzugsweise Gruppen der Formeln $R^1$-1 bis $R^1$-28 und $R^1$-34 bis $R^1$-38, insbesondere bevorzugt Gruppen der Formeln $R^1$-1 , $R^1$-3 , $R^1$-4 , $R^1$-10, $R^1$-11, $R^1$-12 , $R^1$-13, $R^1$-

14, $R^1$-16, $R^1$-17 , $R^1$-18, $R^1$-19, $R^1$-20, $R^1$-21, $R^1$-22, $R^1$-24 und/oder $R^1$-37.

Besonders bevorzugt sind weiterhin erfindungsgemäße Verbindungen mit Strukturen der Formel (IV-1), (IV-2), (IV-3), (IV-4), (IV-5), (IV-6), (IV-7), (IV-8), (IV-9), (IV-10), (IV-11), (IV-12), (IV-13) und/oder (IV-14), bei denen die Gruppe HetAr mindestens eine Gruppe QL aufweist, vorzugsweise darstellt, wobei Q ausgewählt ist aus Q-16 bis 19 und Q-23 bis Q-25, vorzugsweise Q-23 bis Q-25, besonders bevorzugt Q-23, welche die folgenden Eigenschaften aufweisen:

| $L^1$ | vorzugsweise | Mindestens ein Rest, vorzugsweise zwei Reste $R^1$ (Substituent von Q-23 bis Q-25) | vorzugsweise |
|---|---|---|---|
| Bindung oder $L^1$-1 bis $L^1$-76 | Bindung oder $L^1$-1 bis $L^1$-4 | $R^1$-1 bis $R^1$- 43 | $R^1$-1 bis $R^1$-38 |
| Bindung oder $L^1$-1 bis $L^1$-4 | Bindung oder L 1-1 | $R^1$-1 bis $R^1$-38 | $R^1$-1 bis $R^1$-10 und $R^1$-19 bis $R^1$-38 |

Besonders bevorzugt sind weiterhin erfindungsgemäße Verbindungen mit Strukturen der Formel (IV-1), (IV-2), (IV-3), (IV-4), (IV-5), (IV-6), (IV-7), (IV-8), (IV-9), (IV-10), (IV-11), (IV-12), (IV-13) und/oder (IV-14), bei denen die Gruppe HetAr mindestens eine Lochtransportgruppe aufweist, vorzugsweise darstellt, wobei die Lochtransportgruppe ausgewählt ist aus H-1 bis H-3, welche die folgenden Eigenschaften aufweisen:

| $Ar^2$ | $Ar^1$ (falls vorhanden) | $Ar^3$ | $Ar^4$ |
|---|---|---|---|
| Nicht vorhanden (p=0) oder $L^1$-1 bis $L^1$-76 | $R^1$-1 bis $R^1$- 43 | $R^1$-1 bis $R^1$- 43 | $R^1$-1 bis $R^1$- 43 |
| Nicht vorhanden (p=0) oder $L^1$-1 bis $L^1$-4 | $R^1$-1 | $R^1$-1 bis $R^1$-39 | $R^1$-1 bis $R^1$-11 |

Besonders bevorzugt sind weiterhin erfindungsgemäße Verbindungen mit Strukturen der Formel (IV-1), (IV-2), (IV-3), (IV-4), (IV-5), (IV-6), (IV-7), (IV-8), (IV-9), (IV-10), (IV-11), (IV-12), (IV-13) und/oder (IV-14), bei denen die Gruppe HetAr mindestens eine Lochtransportgruppe aufweist, vorzugsweise darstellt, wobei die Lochtransportgruppe ausgewählt ist aus H-4 bis H-26, welche die folgenden Eigenschaften aufweisen:

| $Ar^2$ | vorzugsweise | $Ar^1$ | vorzugsweise |
|---|---|---|---|
| Bindung oder $L^1$-1 bis $L^1$-76 | $L^1$-1 bis $L^1$-4 | $R^1$-1 bis $R^1$-43 | $R^1$-1 bis $R^1$-38 |
| $L^1$-1 bis $L^1$-4 | $L^1$-1 | $R^1$-1 bis $R^1$-38 | $R^1$-1 bis $R^1$-10 und $R^1$-19 bis $R^1$-38 |

In einer bevorzugten Ausführungsform kann vorgesehen sein, dass der Rest HetAr und mindestens einer der Reste $R^a$, $R^b$, $R^c$ und/oder R in einer Struktur gemäß den Formeln (III), (IIIa) und/oder (IV-1) bis (IV-14) jeweils eine Lochtransportgruppe umfassen, vorzugsweise darstellen.

Ferner kann vorgesehen sein, dass der Rest HetAr in einer Struktur gemäß den Formeln (III), (IIIa) und/oder (IV-1) bis (IV-14) zwei Lochtransportgruppen umfasst. Hierbei kann eine Lochtransportgruppe als Rest $R^1$ angesehen werden, wobei in diesem Fall die in den Strukturen der Formeln (H-1) bis (H-26) dargelegten Substituenten $R^1$ durch Reste $R^2$ zu ersetzen sind.

In einer bevorzugten Ausführungsform kann vorgesehen sein, dass der Rest HetAr und mindestens einer der Reste $R^a$, $R^b$, $R^c$ und/oder R in einer Struktur gemäß den Formeln (III), (IIIa) und/oder (IV-1) bis (IV-14) jeweils einen Elektronentransportgruppe-umfassenden Rest umfassen, vorzugsweise darstellen.

Ferner kann vorgesehen sein, dass der Rest HetAr in einer Struktur gemäß den Formeln (III), (IIIa) und/oder (IV-1) bis (IV-14) zwei Elektronentransportgruppe-umfassende Reste umfasst. Hierbei kann ein Elektronentransportgruppe-umfassender Rest als Rest $R^1$ angesehen werden, wobei in diesem Fall die in den Strukturen der Formeln (QL) und/oder (Q-1) bis (Q-44) dargelegten Substituenten $R^1$ durch Reste $R^2$ zu ersetzen sind.

In einer weiteren Ausgestaltung kann vorgesehen sein, dass mindestens einer der Reste HetAr, $R^a$, $R^b$, $R^c$ und/oder R in einer Struktur gemäß den Formeln (III), (IIIa) und/oder (IV-1) bis (IV-14) eine Lochtransportgruppe umfasst, vorzugsweise darstellt, und mindestens einer der Reste HetAr, $R^a$, $R^b$, $R^c$ und/oder R einen Elektronentransportgruppe-umfassenden Rest umfasst, vorzugsweise darstellt.

Ferner kann vorgesehen sein, dass der Rest HetAr in einer Struktur gemäß den Formeln (III), (IIIa) und/oder

(IV-1) bis (IV-14) sowohl einen Elektronentransportgruppe-umfassenden Rest umfasst als auch eine Lochtransportgruppe. Hierbei kann ein Elektronentransportgruppe-umfassender Rest oder eine Lochtransportgruppe als Rest $R^1$ angesehen werden, wobei in diesem Fall die in den Strukturen der Formeln (QL), (Q-1) bis (Q-44) oder (H-1) bis (H-26) dargelegten Substituenten $R^1$ durch Reste $R^2$ zu ersetzen sind.

Nochmals ein weiterer Gegenstand der vorliegenden Erfindung ist eine Verbindung umfassend mindestens eine Struktur der Formel (V), vorzugsweise Verbindung gemäß der Formel (V),

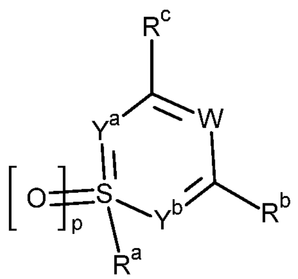

Formel (V)

wobei die Symbole p, $R^a$, $R^b$, $R^c$, $Y^a$, $Y^b$ und W die zuvor, insbesondere für Formel (I) genannten Bedeutungen aufweisen und mindestens einer der Reste $R^a$, $R^b$, $R^c$, $Y^a$, $Y^b$ und Weine Gruppe KonAr umfasst oder darstellt, wobei KonAr für eine Gruppe steht, die ausgewählt ist aus den obgen genannten Formeln (Ar-3) bis (Ar-17)wobei KonAr mit einem oder mehreren Resten $R^1$ substituiert sein kann, wobei die Gruppe KonAr mit einem Rest R, einer Gruppe $R^a$, $R^b$, $R^c$, $Y^a$, $Y^b$ oder einer weiteren Gruppe ein Ringsystem bilden kann, wobei KonAr vorzugsweise für eine Gruppe steht, die ausgewählt ist aus den zuvor definierten Formeln (Ar'-1) bis (Ar'-17), besonders bevorzugt für eine Gruppe steht, die ausgewählt ist aus den zuvor definierten Formeln (Ar-3) bis (Ar-17) und (Ar'-3) bis (Ar'-17).

In einer bevorzugten Ausgestaltung kann die erfindungsgemäße Verbindung mindestens eine Struktur der Formel (Va) umfassen, vorzugsweise ausgewählt sein aus den Verbindungen der Formel (Va),

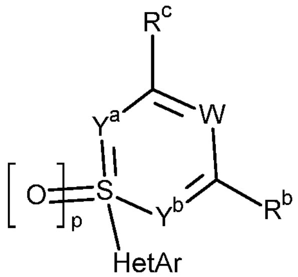

Formel (Va)

wobei die Symbole p, $R^b$, $R^c$, $Y^a$, $Y^b$ und W die zuvor, insbesondere für Formel (I) genannten Bedeutungen aufweisen und KonAr für eine Gruppe steht, die ausgewählt ist aus den oben definierten Formeln (Ar-3) bis (Ar-17), wobei die Gruppe KonAr mit einem Rest R, einer Gruppe $R^a$, $R^b$, $R^c$, $Y^a$, $Y^b$ oder einer weiteren Gruppe ein Ringsystem bilden kann, wobei KonAr vorzugsweise für eine Gruppe steht, die ausgewählt ist aus den zuvor definierten Formeln (Ar-1) bis (Ar-17) und (Ar'-1) bis (Ar'-17), besonders bevorzugt für eine Gruppe steht, die ausgewählt ist aus den zuvor definierten Formeln (Ar-3) bis (Ar-17) und (Ar'-3) bis (Ar'-17).

In einer weiterhin bevorzugten Ausgestaltung kann vorgesehen sein, dass die erfindungsgemäßen Verbindungen eine Struktur der Formel (VI-1), bis (VI-14) umfassen, wobei die erfindungsgemäßen Verbindungen besonders bevorzugt ausgewählt sind aus den Verbindungen der Formel (VI-1), bis (VI-14),

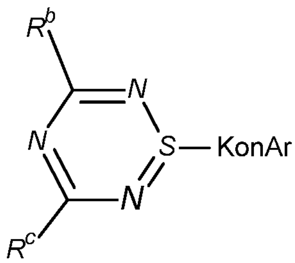

Formel (VI-1)

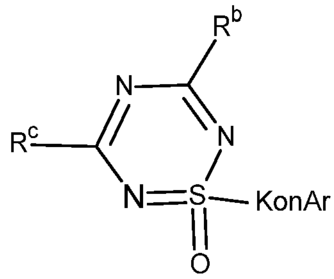

Formel (VI-2)

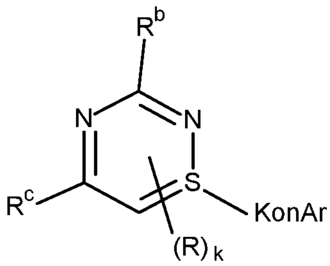

Formel (VI-3)

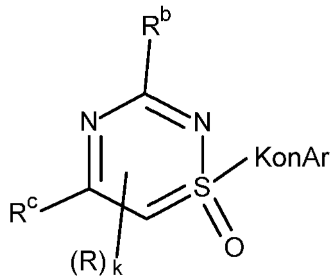

Formel (VI-4)

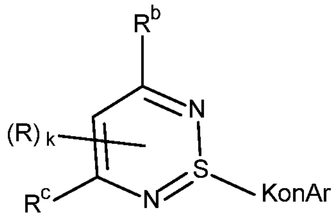

Formel (VI-5)

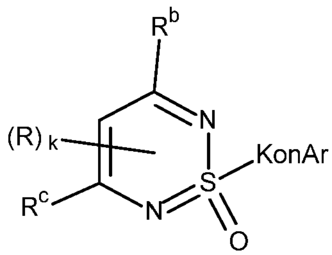

Formel (VI-6)

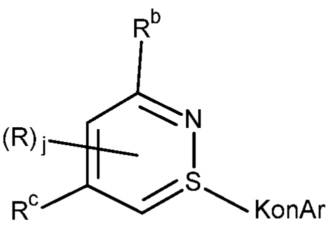

Formel (VI-7)

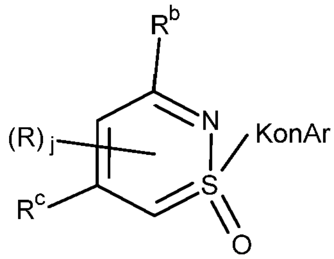

Formel (VI-8)

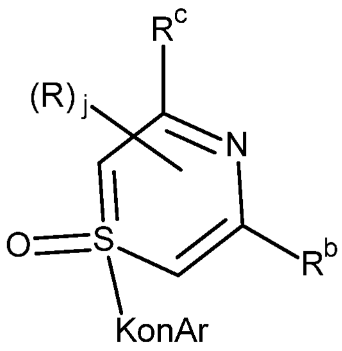

Formel (VI-9)

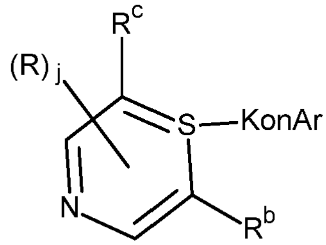

Formel (VI-10)

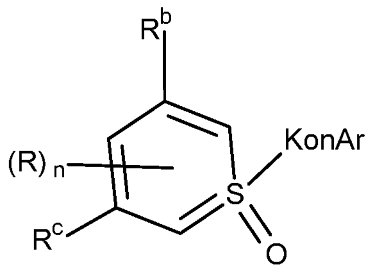

Formel (VI-11)

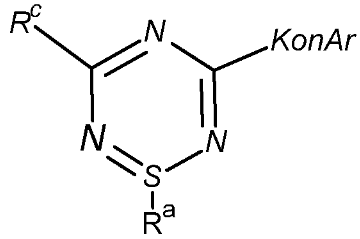

Formel (VI-12)

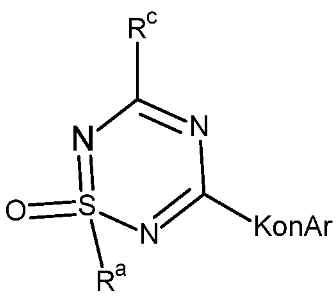

Formel (VI-13)

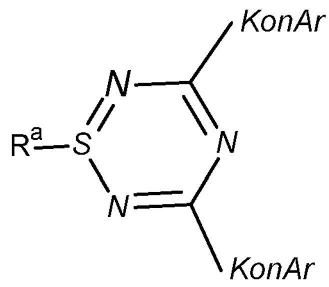

Formel (VI-14)

wobei die Symbole $R^a$, $R^b$, $R^c$, und R die zuvor, insbesondere für Formel (I) genannten Bedeutungen aufweisen, der Index n 0, 1, 2 oder 3, vorzugsweise 0, 1 oder 2 ist, der Index j 0, 1 oder 2 ist, der Index k 0 oder 1 ist und KonAr die zuvor für Formel (V) genannte Bedeutung aufweist, vorzugsweise für eine Gruppe steht, die ausgewählt ist aus den zuvor definierten Formeln (Ar-1) bis (Ar-17) und (Ar’-1) bis (Ar’-17), besonders bevorzugt für eine Gruppe steht, die ausgewählt ist aus den zuvor definierten Formeln (Ar-3) bis (Ar-17) und (Ar‘-3) bis (Ar’-17).

Besonders bevorzugt sind weiterhin erfindungsgemäße Verbindungen mit Strukturen der Formeln (V), (Va), (VI-1), (VI-2), (VI-3), (VI-4), (VI-5), (VI-6), (VI-7), (VI-8), (VI-9), (VI-10), (VI-11), (VI-12), (VI-13) und/oder (VI-14), welche die folgenden Eigenschaften aufweisen:

| KonAr umfasst eine der Gruppen | vorzugsweise | Mit $L^1$ | vorzugsweise |
|---|---|---|---|
| (Ar-1) bis (Ar-17) | (Ar-4) bis (Ar-8) und (Ar-12) bis (Ar-16) | Bindung oder $L^1$-1 bis $L^1$-76 | Bindung oder L’-1 bis $L^1$-4 |
| (Ar’-1) bis (Ar‘-17) | (Ar’-4) bis (Ar’-8) und (Ar’-12) bis (Ar’-16) | Bindung oder $L^1$-1 bis $L^1$-76 | Bindung oder $L^1$-1 bis $L^1$-4 |

Hierbei umfassen die Gruppen der Formeln Ar-5 oder Ar'-5 der in der zuvor dargelegten Tabelle dargelegten Verbindungen mit Strukturen der Formeln (V), (Va) und/oder , (VI-1) bis (VI-14) Reste $R^1$, die vorzugsweise ein aromatisches oder heteroaromatisches Ringsystem mit 6 bis 18 aromatischen Ringatomen darstellen, bevorzugt mit 6 bis 13 aromatischen Ringatomen, das jeweils mit einem oder mehreren nicht-aromatischen Resten $R^2$ substituiert sein kann; vorzugsweise weisen die Gruppen der Formeln Ar-5 und Ar'-5 der in der zuvor dargelegten Tabelle dargelegten Verbindungen mit Strukturen der Formeln (V), (Va) und/oder , (VI-1) bis (VI-14) mindestens einen Rest $R^1$ auf, der ausgewählt ist aus den Formeln ($R^1$-1) bis ($R^1$- 43), vorzugsweise Gruppen der Formeln $R^1$-1 bis $R^1$-28 und $R^1$-34 bis $R^1$-38, insbesondere bevorzugt Gruppen der Formeln $R^1$-1, $R^1$-3, $R^1$-4, $R^1$-10, $R^1$-11, $R^1$-12, $R^1$-13, $R^1$-14, $R^1$-16, $R^1$-17, $R^1$-18, $R^1$-19, $R^1$-20, $R^1$-21, $R^1$-22, $R^1$-24 und/oder $R^1$-37. Diese Reste $R^1$, die vorzugsweise aromatische oder heteroaromatische Ringsystem mit 6 bis 18 aromatischen Ringatomen darstellen, befinden sich vorzugsweise in paraStellung zur Anbindungsstelle der Gruppe L' in Formel (Ar-5) beziehungsweise in Formel (Ar'-5) ist der Index p=1 und der Rest $R^1$ stellt die vorzugsweise aromatische oder heteroaromatische Ringsystem mit 6 bis 18 aromatischen Ringatomen dar.

Nochmals ein weiterer Gegenstand der vorliegenden Erfindung ist eine Verbindung, die genau zwei, genau drei oder genau vier Strukturen gemäß Formel (I) und/oder Formeln (II-1), (II-2), (II-3), (II-4), (II-5), (II-6), (II-7), (II-8), (II-9), (II-10) und (II-11) und/oder deren bevorzugten Ausführungsformen, insbesondere Strukturen gemäß Formel (III), (IIIa), (IV-1) bis (IV-14), (V), (Va), (VI-1) bis (VI-14) umfasst.

Besonders bevorzugt sind die Verbindungen ausgewählt aus Verbindungen der Formeln (VIIa) bis (VIIc),

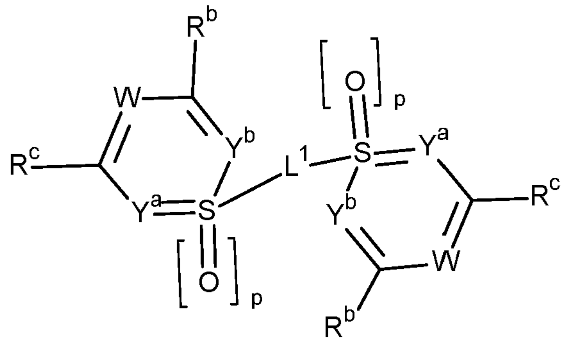

Formel (VIIa)

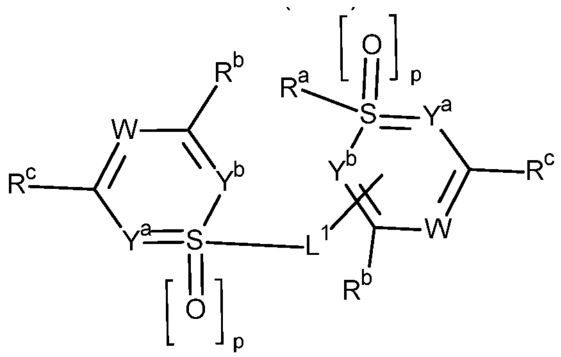

Formel (VIIb)

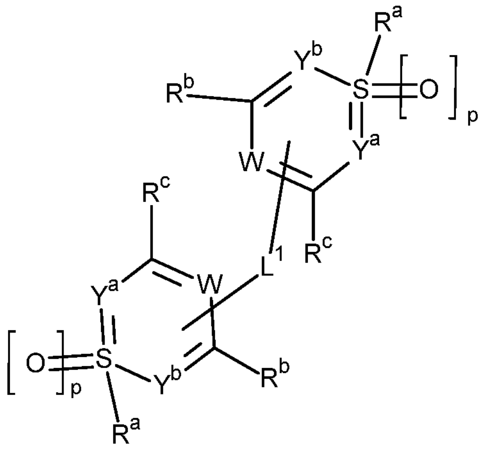

Formel (VIIc)

wobei die Symbole p, $R^a$, $R^b$, $R^c$, $Y^a$, $Y^b$ und W die zuvor, insbesondere für Formel (I) genannten Bedeutungen aufweisen und $L^1$ eine Bindung oder ein aromatisches oder heteroaromatisches Ringsystem mit 5 bis 40, bevorzugt 5 bis 30 aromatischen Ringatomen darstellt, welches durch einen oder mehrere Reste $R^1$ substituiert sein kann, wobei L' vorzugsweise für eine Bindung oder eine Gruppe steht, die ausgewählt ist aus den zuvor definierten Formeln ($L^1$-1) bis ($L^1$-76), wobei in Formel (VIIa) die Gruppe L' besonders bevorzugt nicht für eine Bindung steht.

Bevorzugte Ausführungsformen von erfindungsgemäßen Verbindungen werden in den Beispielen näher ausgeführt, wobei diese Verbindungen allein oder in Kombination mit weiteren für alle erfindungsgemäßen Verwendungszwecke eingesetzt werden können.

Unter der Voraussetzung, dass die in Anspruch 1 genannten Bedingungen eingehalten werden, sind die oben genannten bevorzugten Ausführungsformen beliebig miteinander kombinierbar. In einer besonders bevorzugten Ausführungsform der Erfindung gelten die oben genannten bevorzugten Ausführungsformen gleichzeitig.

Die erfindungsgemäßen Verbindungen sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der erfindungsgemäßen Verbindungen, bevorzugt Verbindungen umfassend Strukturen der Formeln (I) und/oder (II-1) bis (II-11), bei dem in einer Kupplungsreaktion eine Verbindung, umfassend mindestens eine schwefelhaltige Gruppe, mit einer Verbindung, umfassend mindestens eine aromatische oder heteroaromatische Gruppe, verbunden wird.

Geeignete Verbindungen, umfassend mindestens eine heterocyclische Struktur, können vielfach kommerziell erhalten werden, wobei die in den Beispielen dargelegten Ausgangsverbindungen durch bekannte Verfahren erhältlich sind, so dass hierauf verwiesen wird.

Diese Verbindungen können durch bekannte Kupplungsreaktionen mit weiteren Verbindungen, umfassend mindestens eine aromatische oder heteroaromatische Gruppe, umgesetzt werden, wobei die notwendigen Bedingungen hierfür dem Fachmann bekannt sind und ausführliche Angaben in den Beispielen den Fachmann zur Durchführung dieser Umsetzungen unterstützen.

Besonders geeignete und bevorzugte Kupplungsreaktionen, die alle zu C-C-Verknüpfungen und/oder C-N-Verknüpfungen führen, sind solche gemäß BUCHWALD, SUZUKI, YAMAMOTO, STILLE, HECK, NEGISHI, SONOGASHIRA und HIYAMA. Diese Reaktionen sind weithin bekannt, wobei die Beispiele dem Fachmann weitere Hinweise bereitstellen.

Die Grundlagen der zuvor dargelegten Herstellungsverfahren sind im Prinzip aus der Literatur für ähnliche Verbindungen bekannt und können vom Fachmann leicht zur Herstellung der erfindungsgemäßen Verbindungen angepasst werden. Weitere Informationen können den Beispielen entnommen werden.

Durch diese Verfahren, gegebenenfalls gefolgt von Aufreinigung, wie z. B. Umkristallisation oder Sublimation, lassen sich die erfindungsgemäßen Verbindungen, umfassend Strukturen gemäß Formel (I) in hoher Reinheit, bevorzugt mehr als 99 % (bestimmt mittels $^1$H-NMR und/oder HPLC) erhalten.

Die erfindungsgemäßen Verbindungen können auch geeignete Substituenten aufweisen, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, die eine Löslichkeit in gängigen organischen Lösemitteln bewirken, so dass die Verbindungen beispielsweise in Toluol oder Xylol bei Raumtemperatur in ausreichender Konzentration löslich sind, um die Verbindungen aus Lösung verarbeiten zu können. Diese löslichen Verbindungen eignen sich besonders gut für die Verarbeitung aus Lösung, beispielsweise durch Druckverfahren. Weiterhin ist festzuhalten, dass die erfindungsgemäßen Verbindungen, umfassend mindestens eine Struktur der Formeln (I), (IIa) bis (IIc) und/oder (IIb-1) bis (IIb-4) sowie deren bevorzugte Ausführungsformen, die in den weiteren Strukturen dargestellt sind, bereits eine gesteigerte Löslichkeit in diesen Lösungsmitteln besitzen.

Ferner können die Verbindungen der vorliegenden Erfindung eine oder mehrere vernetzbare Gruppen enthalten. "Vernetzbare Gruppe" bedeutet eine funktionelle Gruppe, die in der Lage ist, irreversibel zu reagieren. Dadurch wird ein vernetztes Material gebildet, das unlöslich ist. Die Vernetzung kann gewöhnlich durch Wärme oder durch UV-, Mikrowellen-, Röntgen- oder Elektronenstrahlung unterstützt werden. Hierbei kommt es bei der Vernetzung zu wenig Nebenprodukt-bildung. Zudem vernetzen die vernetzbaren Gruppen, die in den funktionalen Verbindungen enthalten sein können, sehr leicht, so dass geringere Energiemengen für die Vernetzung erforderlich sind (z.B. $< 200°C$ bei der thermischen Vernetzung).

Beispiele für vernetzbare Gruppen sind Einheiten, die eine Doppelbindung, eine Dreifachbindung, eine Vorstufe, die zu einer in situ Bildung einer Doppel- bzw. Dreifachbindung in der Lage ist, oder einen heterocyclischen, additionspolymerisierbaren Rest enthalten. Vernetzbare Gruppen umfassen unter anderem Vinyl, Alkenyl, vorzugsweise Ethenyl und Propenyl, $C_{4-20}$-Cycloalkenyl, Azid, Oxiran, Oxetan, Di(hydrocarbyl)amino, Cyanatester, Hydroxy, Glycidylether, $C_{1-10}$-Alkylacrylat, $C_{1-10}$-Alkylmethacrylat, Alkenyloxy, vorzugsweise Ethenyloxy, Perfluoralkenyloxy, vorzugsweise Perfluorethenyloxy, Alkinyl, vorzugsweise Ethinyl, Maleimid, Cyclobutylphenyl, Tri($C_{1-4}$)-alkylsiloxy und Tri($C_{1-4}$)-alkylsilyl. Besonders bevorzugt ist Cyclobutylphenyl, Vinyl und Alkenyl.

Die erfindungsgemäßen Verbindungen können auch mit einem Polymer gemischt werden. Ebenso ist es möglich, diese Verbindungen kovalent in ein Polymer einzubauen. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. Es ist weiterhin möglich, die Polymere über derartige Gruppen zu vernetzen. Die erfindungsgemäßen Verbindungen und Polymere können als vernetzte oder unvernetzte Schicht eingesetzt werden.

Weiterer Gegenstand der Erfindung sind daher Oligomere, Polymere oder Dendrimere enthaltend eine oder mehrere der oben aufgeführten Strukturen der Formeln (I) und/oder (II-1) bis (II-11) oder erfindungsgemäße Verbindungen, wobei ein oder mehrere Bindungen der erfindungsgemäßen Verbindungen oder der Strukturen der Formeln (I) und/oder (II-1) bis (II-11) zum Polymer, Oligomer oder Dendrimer vorhanden sind. Je nach Verknüpfung der Strukturen der Formeln (I) und/oder (II-1) bis (II-11) bzw. der Verbindungen bilden diese daher eine Seitenkette des Oligomers oder Polymers oder sind in der Hauptkette verknüpft. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Verbindungen in Oligomeren, Dendrimeren und Polymeren gelten dieselben Bevorzugungen, wie oben beschrieben.

Zur Herstellung der Oligomere oder Polymere werden die erfindungsgemäßen Monomere homopolymerisiert oder mit weiteren Monomeren copolymerisiert. Bevorzugt sind Copolymere, wobei die Einheiten gemäß Formeln (I) und/oder ((II-1) bis (II-11) bzw. die zuvor und nachfolgend ausgeführten bevorzugten Ausführungsformen zu 0.01 bis 99.9 mol%, bevorzugt 5 bis 90 mol%, besonders bevorzugt 20 bis 80 mol% vorhanden sind. Geeignete und bevorzugte Comonomere, welche das Polymergrundgerüst bilden, sind gewählt aus Fluorenen (z. B. gemäß EP 842208 oder WO 2000/022026), Spirobifluorenen (z. B. gemäß EP 707020, EP 894107 oder WO 2006/061181), Para-phenylenen (z. B. gemäß WO 92/18552), Carbazolen (z. B. gemäß WO 2004/070772 oder WO 2004/113468), Thiophenen (z. B. gemäß EP 1028136), Dihydrophenanthrenen (z. B. gemäß WO 2005/014689), cis- und trans-Indenofluorenen (z. B. gemäß WO 2004/041901 oder WO 2004/113412), Ketonen (z. B. gemäß WO 2005/040302), Phenanthrenen (z. B. gemäß WO 2005/104264 oder WO 2007/017066) oder auch mehreren dieser Einheiten. Die Polymere, Oligomere und Dendrimere können noch weitere Einheiten enthalten, beispielsweise Lochtransporteinheiten, insbesondere solche basierend auf Triarylaminen, und/oder Elektronentransporteinheiten.

Von besonderem Interesse sind des Weiteren erfindungsgemäße Verbindungen, die sich durch eine hohe Glasübergangstemperatur auszeichnen. In diesem Zusammenhang sind insbesondere erfindungsgemäße Verbindungen bevorzugt, umfassend Strukturen gemäß den Formeln (I) und/oder (II-1) bis (II-11) bzw. die zuvor und nachfolgend ausgeführten bevorzugten Ausführungsformen bevorzugt, die eine Glasübergangstemperatur von mindestens 70 °C, besonders bevorzugt von mindestens 110 °C, ganz besonders bevorzugt von mindestens 125 °C und insbesondere bevorzugt von mindestens 150 °C aufweisen, bestimmt nach DIN 51005 (Version 2005-08).

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, 2-Methylbiphenyl, 3-Methylbiphenyl, 1-Methylnaphthalin, 1-Ethylnaphthalin, Ethyloctanoat, Sebacinsäurediethylester, Octyloctanoat, Heptylbenzol, Menthylisovalerat, Cyclohexylhexanoat oder Mischungen dieser Lösemittel.

Ein weiterer Gegenstand der vorliegenden Erfindung ist daher eine Formulierung bzw. eine Zusammensetzung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Falls die weitere Verbindung ein Lösungsmittel umfasst, so wird diese Mischung hierin als Formulierung bezeichnet. Die weitere Verbindung kann aber auch mindestens eine weitere organische oder anorganische Verbindung sein, die ebenfalls in der elektronischen Vorrichtung eingesetzt wird, beispielsweise eine emittierende Verbindung und/oder ein weiteres Matrixmaterial. Geeignete emittierende Verbindungen und weitere Matrixmaterialien sind hinten im Zusammenhang mit der organischen Elektrolumineszenzvorrichtung aufgeführt. Die weitere Verbindung kann auch polymer sein.

Nochmals ein weiterer Gegenstand der vorliegenden Erfindung ist daher eine Zusammensetzung enthaltend eine Kombination umfassend

A) eine oder mehrere Verbindungen umfassend mindestens eine Struktur der Formel (I), vorzugsweise eine oder mehrere Verbindungen gemäß Formel (I)

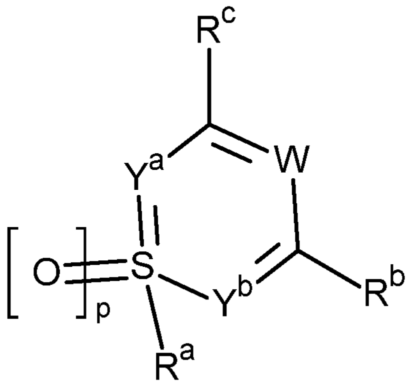

Formel (I)

wobei die Symbole p, $R^a$, $R^b$, $R^c$, $Y^a$, $Y^b$ und W die, zuvor insbesondere für Formel (I) genannte Bedeutung aufweisen;

B) eine weitere Verbindung ausgewählt aus der Gruppe bestehend aus fluoreszierenden Emittern, phosphoreszierenden Emittern, Emittern, die TADF (thermally activated delayed fluorescence) zeigen, Hostmaterialien, Excitonenblockiermaterialien, Elektroneninjektionsmaterialien, Elektronentransportmaterialien, Elektronenblockiermaterialien, Lochinjektionsmaterialien, Lochleitermaterialien, Lochblockiermaterialien, Quantenmaterialien, n-Dotanden, p-Dotanden, Wide-Band-Gap-Materialien und/oder Ladungserzeugungsmeterialien.

Die genannten Materialien sind dem Fachmann aus dem Stand der Technik gut bekannt, wobei unter Quantenmaterialien auch Quantenpunkte (Quantum Dots) und Qunatenstäbchen (Quantum Rods) verstanden werden. Weitere üblich Begriffe, die für Quantenmaterialien verwendet werden sind Nanosized Crystals oder Nanocrystals. Ein weiterer Gegenstand der vorliegenden stellt eine Zusammensetzung dar, enthaltend wenigstens eine Verbindung umfassend mindestens eine Struktur gemäß Formeln (I) und/oder (II-1) bis (II-11) bzw. die zuvor und nachfolgend ausgeführten bevorzugten Ausführungsformen sowie wenigstens ein Wide-Band-Gap-Material, wobei unter Wide-Band-Gap-Material ein Material im Sinne der Offenbarung von US 7,294,849 verstanden wird. Diese Systeme zeigen besondere vorteilhafte Leistungsdaten in elektrolumineszierenden Vorrichtungen.

Vorzugsweise kann die zusätzliche Verbindung eine Bandlücke (band gap) von 2,5 eV oder mehr, bevorzugt 3,0 eV oder mehr, ganz bevorzugt von 3,3 eV oder mehr aufweisen. Die Bandlücke kann unter anderem durch die Energieniveaus des highest occupied molecular orbital (HOMO) und des lowest unoccupied molecular orbital (LUMO)

berechnet werden.

Molekülorbitale, insbesondere auch das highest occupied molecular orbital (HOMO) und das lowest unoccupied molecular orbital (LUMO), deren Energieniveaus sowie die Energie des niedrigsten Triplettzustands $T_1$ bzw. des niedrigsten angeregten Singulettzustands $S_1$ der Materialien werden über quantenchemische Rechnungen bestimmt. Zur Berechnung organischer Substanzen ohne Metalle wird zuerst eine Geometrieoptimierung mit der Methode "Ground State/Semi-empirical/Default Spin/AM1/Charge 0/Spin Singlet" durchgeführt. Im Anschluss erfolgt auf Grundlage der optimierten Geometrie eine Energierechnung. Hierbei wird die Methode "TD-SCF/DFT/Default Spin/B3PW91" mit dem Basissatz "6-31G(d)" verwendet (Charge 0, Spin Singlet). Für metallhaltige Verbindungen wird die Geometrie über die Methode "Ground State/ Hartree-Fock/Default Spin/LanL2MB/Charge 0/Spin Singlet" optimiert. Die Energierechnung erfolgt analog zu der oben beschriebenen Methode für die organischen Substanzen mit dem Unterschied, dass für das Metallatom der Basissatz "LanL2DZ" und für die Liganden der Basissatz "6-31G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$HOMO(eV) = ((HEh*27.212)-0.9899)/1.1206$$

$$LUMO(eV) = ((LEh*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand Si ist definiert als die Energie des angeregten Singulettzustands mit der niedrigsten Energie, der sich aus der beschriebenen quantenchemischen Rechnung ergibt.

Die hierin beschriebene Methode ist unabhängig von dem verwendeten Softwarepaket und liefert immer dieselben Ergebnisse. Beispiele oft benutzter Programme für diesen Zweck sind "Gaussian09W" (Gaussian Inc.) und Q-Chem 4.1 (Q-Chem, Inc.).

Die vorliegende Erfindung betrifft auch eine Zusammensetzung umfassend wenigstens eine Verbindung umfassend Strukuren gemäß Formeln (I) und/oder (II-1) bis (II-11) bzw. die zuvor und nachfolgend ausgeführten bevorzugten Ausführungsformen sowie wenigstens einen phosphoreszierende Emitter, wobei unter dem Begriff phosphoreszierende Emitter auch phosphoreszierende Dotanden verstanden werden.

Unter einem Dotanden wird in einem System enthaltend ein Matrixmaterial und einen Dotanden diejenige Komponente verstanden, deren Anteil in der Mischung der kleinere ist. Entsprechend wird unter einem Matrixmaterial in einem System enthaltend ein Matrixmaterial und einen Dotanden diejenige Komponente verstanden, deren Anteil in der Mischung der größere ist.

Bevorzugte phosphoreszierende Dotanden zur Verwendung in Matrix-Systemen, vorzugsweise Mixed-Matrix-Systemen sind die im Folgenden angebenen bevorzugten phosphoreszierenden Dotanden.

Vom Begriff phosphoreszierende Dotanden sind typischerweise Verbindungen umfasst, bei denen die Lichtemission durch einen spinverbotenen Übergang erfolgt, beispielsweise einen Übergang aus einem angeregten Triplettzustand oder einem Zustand mit einer höheren Spinquantenzahl, beispielsweise einem Quintett-Zustand.

Als phosphoreszierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten.

Beispiele der oben beschriebenen Emitter können den Anmeldungen WO 00/70655, WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339, WO 2012/007086, WO 2014/008982, WO 2014/023377, WO 2014/094961, WO 2014/094960, WO 2015/036074, WO 2015/104045, WO 2015/117718, WO 2016/015815, WO 2016/124304, WO 2017/032439, WO 2018/011186, WO 2018/001990, WO 2018/019687, WO 2018/019688, WO 2018/041769, WO 2018/054798, WO 2018/069196, WO 2018/069197, WO 2018/069273, WO 2018/178001, WO 2018/177981, WO 2019/020538, WO 2019/115423, WO 2019/158453 und WO 2019/179909 entnommen werden. Generell eignen sich alle phosphoreszierenden Komplexe,

wie sie gemäß dem Stand der Technik für phosphoreszierende Elektrolumineszenzvorrichtungen verwendet werden und wie sie dem Fachmann auf dem Gebiet der organischen Elektrolumineszenz bekannt sind, und der Fachmann kann ohne erfinderisches Zutun weitere phosphoreszierende Komplexe verwenden.

Beispiele für phosphoreszierende Dotanden sind in der folgenden Tabelle aufgeführt.

| | | |
|---|---|---|
| 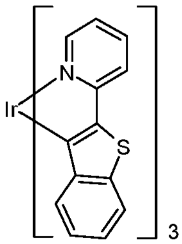 | 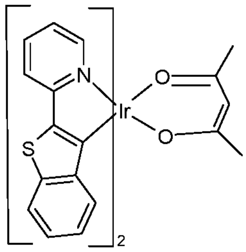 | 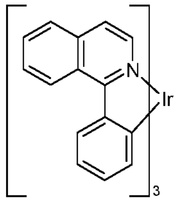 |
| 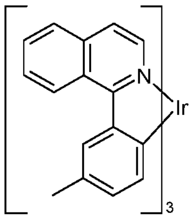 | 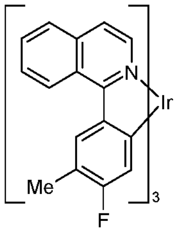 | 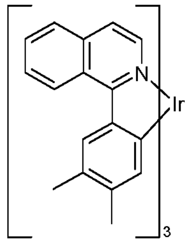 |
| 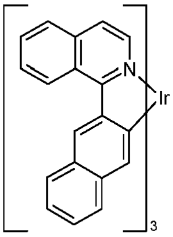 | 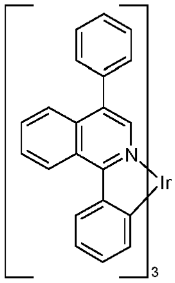 | 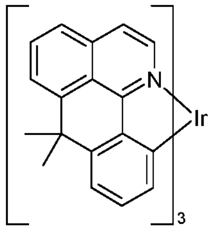 |
| 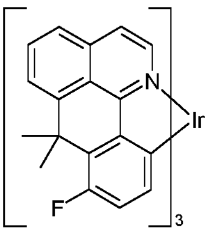 | 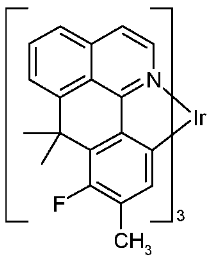 | 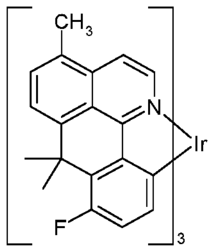 |
| 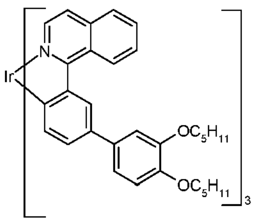 | 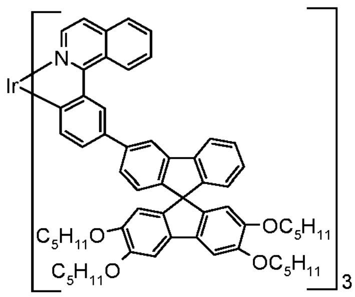 | 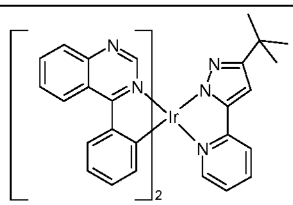 |

| | | |
|---|---|---|
| 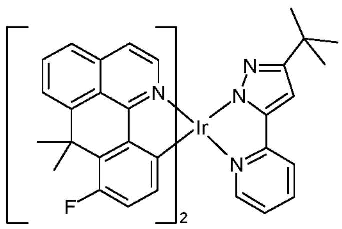 | 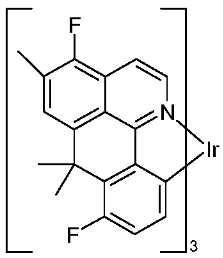 | 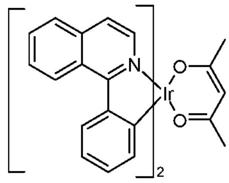 |
| 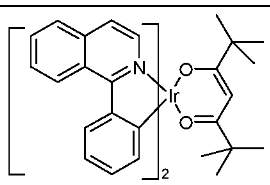 | 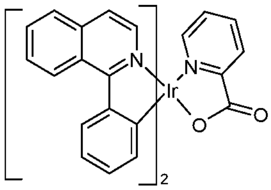 | 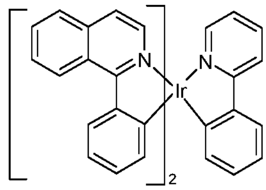 |
| 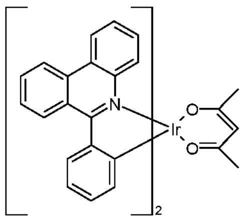 | 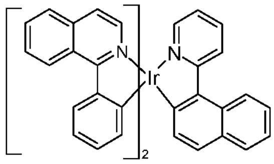 | 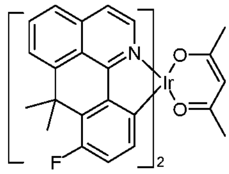 |
| 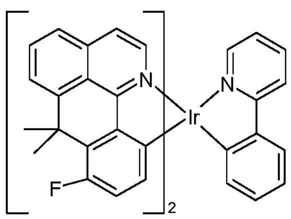 | 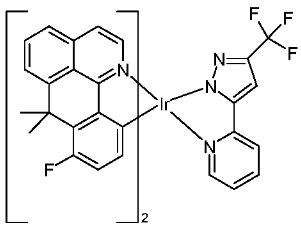 | 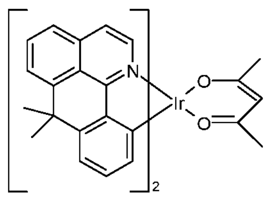 |
| 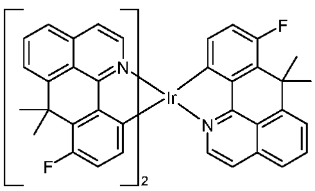 | 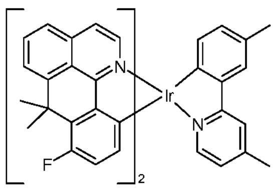 | 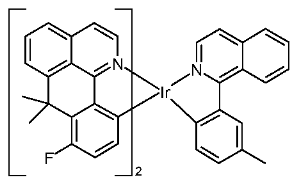 |
| 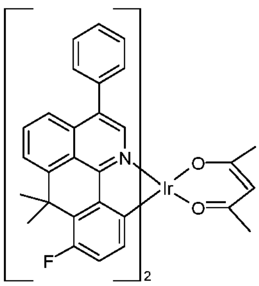 | 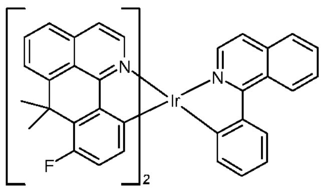 | 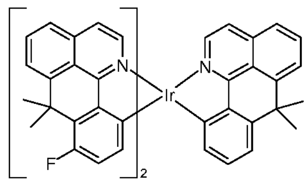 |

| | | |
|---|---|---|
| 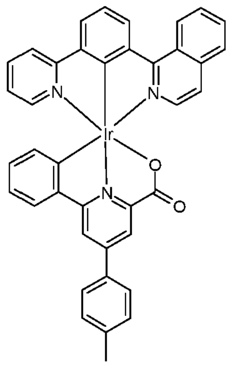 | 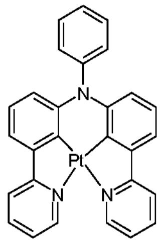 | 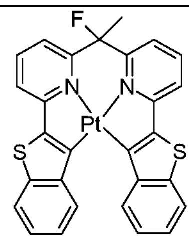 |
| 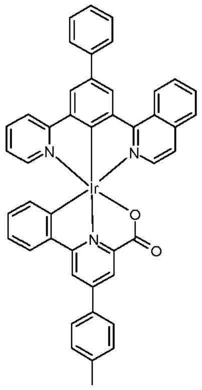 | 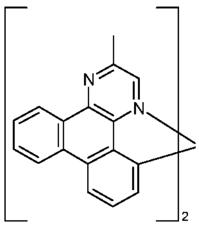 | 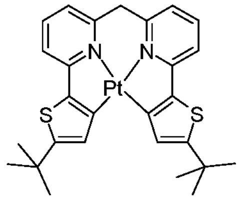 |
| 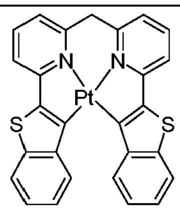 | 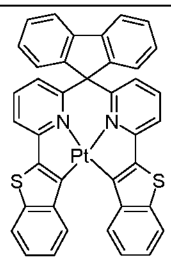 | 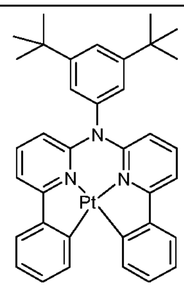 |
| 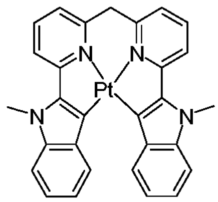 | 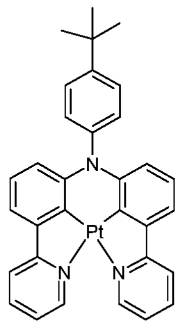 | 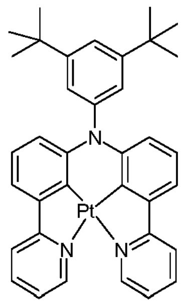 |
| 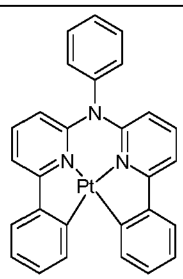 | 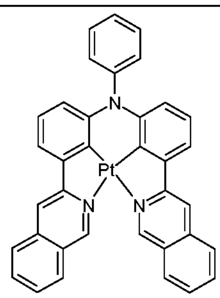 | |

| | | |
|---|---|---|
| 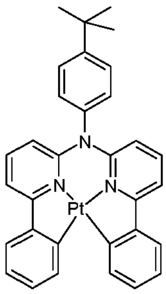 | 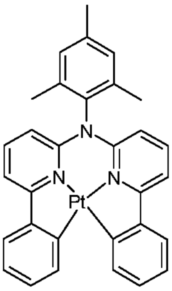 | 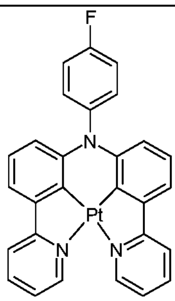 |
| 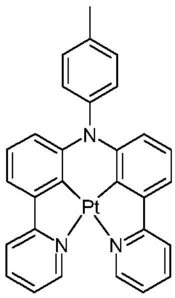 | 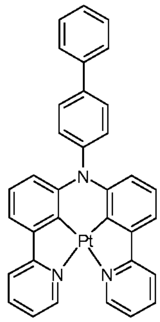 | 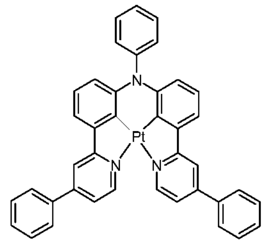 |
| 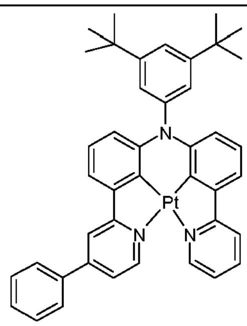 | 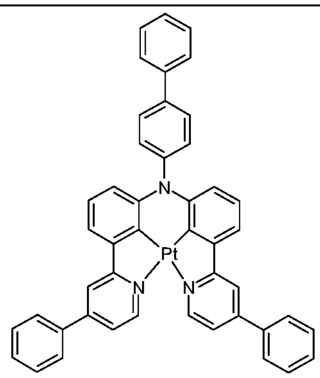 | 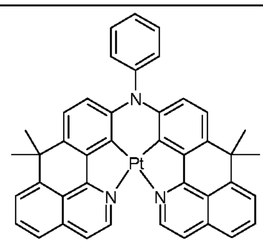 |
| 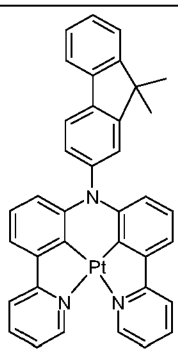 | 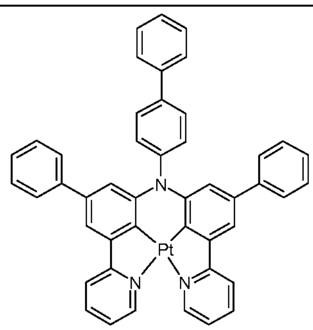 | 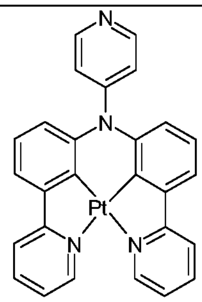 |
| 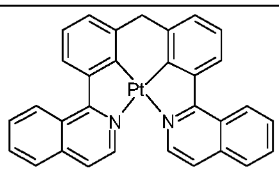 | 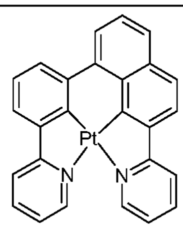 | 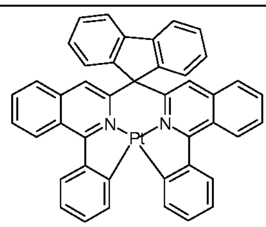 |

| | | |
|---|---|---|
| 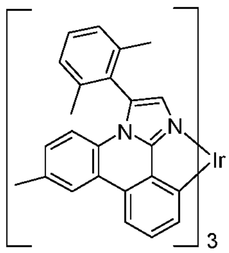 | 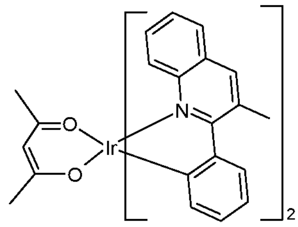 | 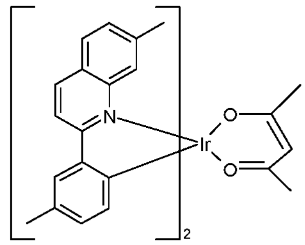 |
| 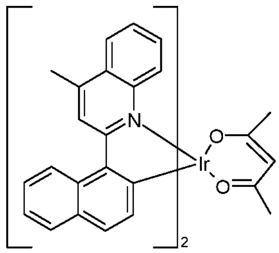 | 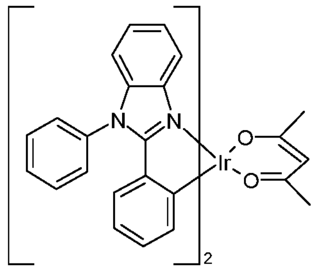 | 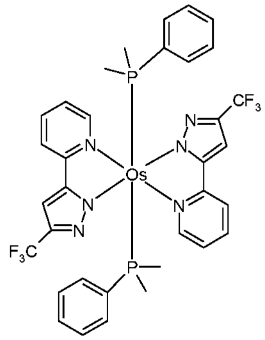 |
| 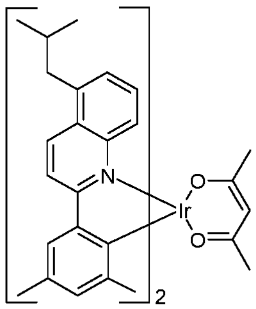 | 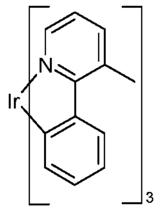 | 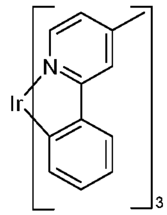 |
| 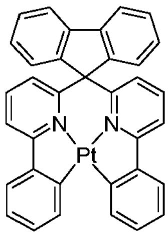 | 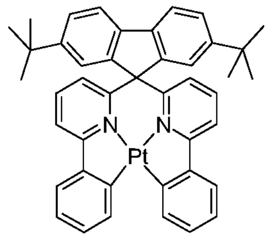 | 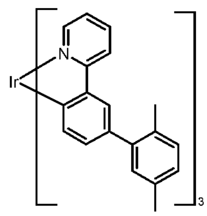 |
| 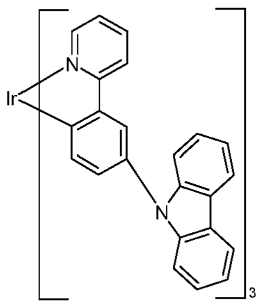 | 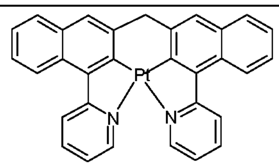 | 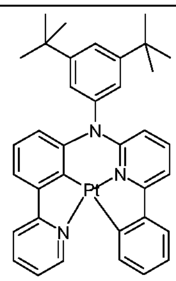 |

| | | |
|---|---|---|
| 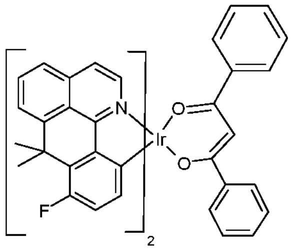 | 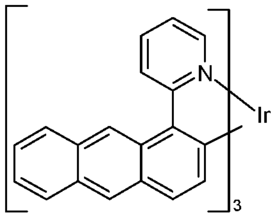 | 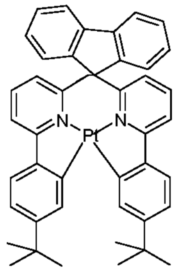 |
| 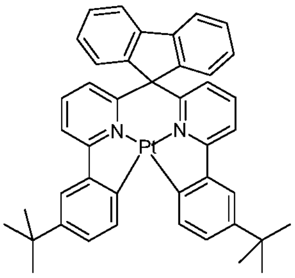 | 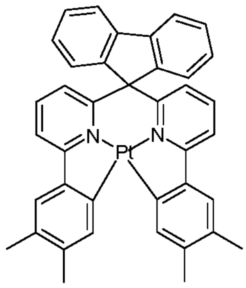 | 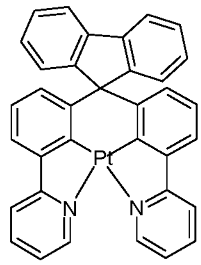 |
| 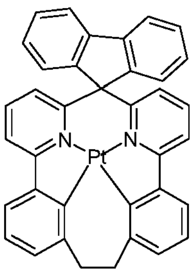 | 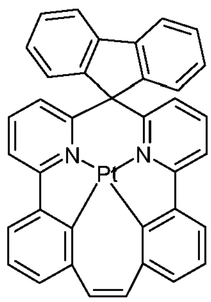 | 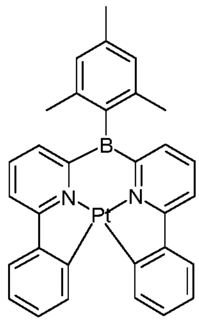 |
| 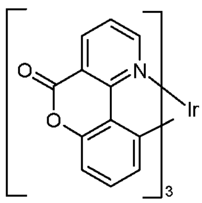 | 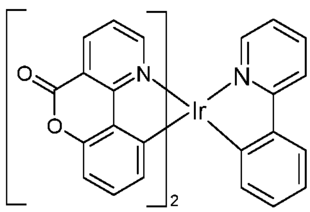 | 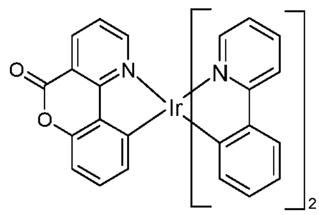 |
| 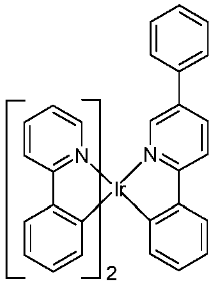 | 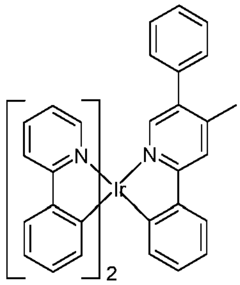 | 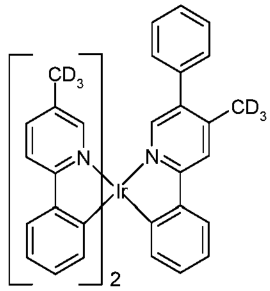 |
| 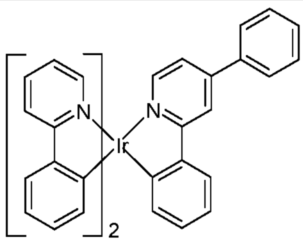 | 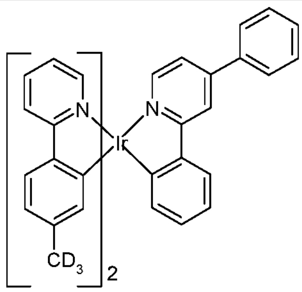 | 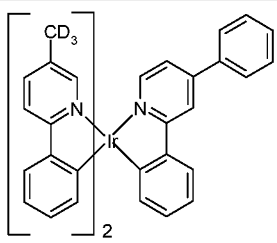 |

| | | |
|---|---|---|
| 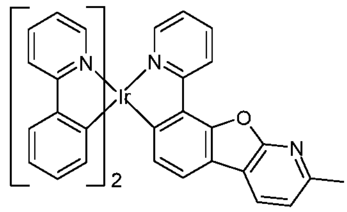 | 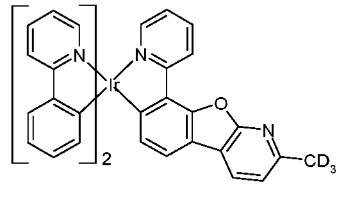 | 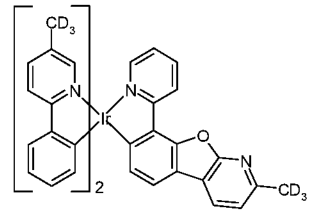 |
| 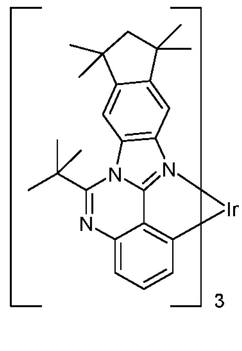 | 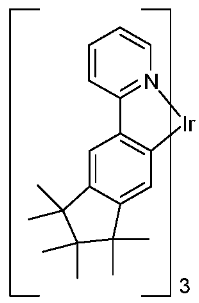 | 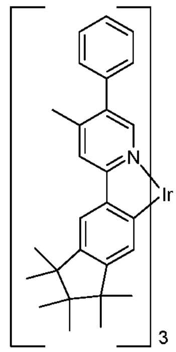 |
| 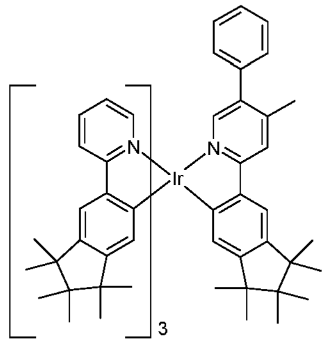 | 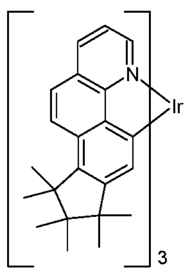 | 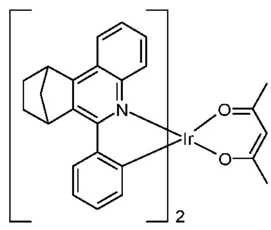 |
| 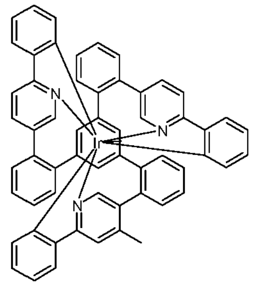 | 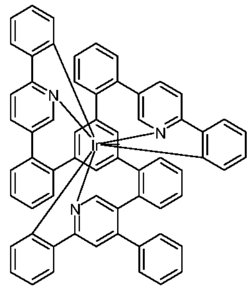 | 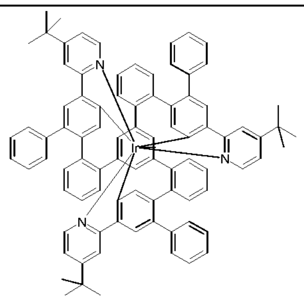 |
| 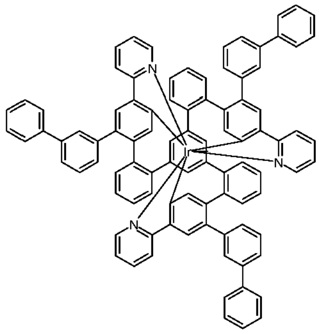 | 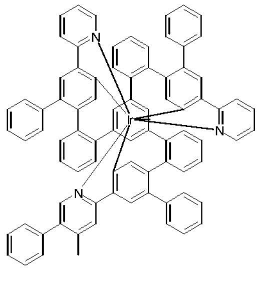 | 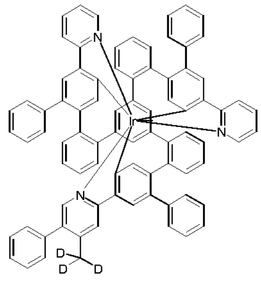 |

Wenn die erfindungsgemäß einzusetzende Verbindung als Matrixmaterial für eine phosphoreszierende Verbindung in einer emittierenden Schicht eingesetzt wird, wird sie bevorzugt in Kombination mit einem oder mehreren phosphoreszierenden Materialien (Triplettemitter) eingesetzt. Unter Phosphoreszenz im Sinne dieser Erfindung wird die Lumineszenz aus einem angeregten Zustand mit höherer Spinmultiplizität verstanden, also einem Spinzustand > 1, insbesondere aus einem angeregten Triplettzustand. Im Sinne dieser Anmeldung sollen alle lumineszierenden Komplexe mit Übergangsmetallen oder Lanthaniden, insbesondere alle Iridium-, Platin- und Kupferkomplexe als phosphoreszierende Verbindungen angesehen werden.

Die Mischung aus der erfindungsgemäß einzusetzenden Verbindung und der emittierenden Verbindung enthält zwischen 99 und 1 Vol.-%, vorzugsweise zwischen 98 und 10 Vol.-%, besonders bevorzugt zwischen 97 und 60 Vol.-%, insbesondere zwischen 95 und 80 Vol.-% der erfindungsgemäßen Verbindung bezogen auf die Gesamtmischung aus Emitter und Matrixmaterial. Entsprechend enthält die Mischung zwischen 1 und 99 Vol.-%, vorzugsweise zwischen 2 und 90 Vol.-%, besonders bevorzugt zwischen 3 und 40 Vol.-%, insbesondere zwischen 5 und 20 Vol.-% des Emitters bezogen auf die Gesamtmischung aus Emitter und Matrixmaterial.

In einer Ausführungsform der Erfindung wird die erfindungsgemäß einzusetzende Verbindung dabei als einziges Matrixmaterial ("single host") für den phosphoreszierenden Emitter eingesetzt.

In einer bevorzugten Ausführungsform der Erfindung enthält die organische Elektrolumineszenzvorrichtung die erfindungsgemäß einzusetzende Verbindung, vorzugsweise eine Verbindung umfassend Strukturen gemäß Formeln (I) und/oder (II-1) bis (II-11) bzw. die oben aufgeführten bevorzugten Ausführungsformen als Matrixmaterial, vorzugsweise als elektronenleitendes Matrixmaterial in einer oder mehreren emittierenden Schichten, bevorzugt in Kombination mit einem weiteren Matrixmaterial, vorzugsweise einem lochleitenden Matrixmaterial. In einer weiteren bevorzugten Ausführungsform der Erfindung ist das weitere Matrixmaterial eine elektronentransportierende Verbindung. In nochmals einer weiteren bevorzugten Ausführungsform ist das weitere Matrixmaterial eine Verbindung mit großem Bandabstand, das nicht oder nicht in wesentlichem Umfang am Loch- und Elektronentransport in der Schicht beteiligt ist. Eine emittierende Schicht umfasst mindestens eine emittierende Verbindung.

In einer weiterhin besonders bevorzugten Ausführungsform der vorliegenden Erfindung umfasst eine erfindungsgemäße organische Elektrolumineszenzvorrichtung die erfindungsgemäß einzusetzende Verbindung, vorzugsweise eine Verbindung umfassend Strukturen gemäß Formeln (I) und/oder (II-1) bis (II-11) bzw. die oben aufgeführten bevorzugten Ausführungsformen in einer Lochtransportschicht oder einer Elektronentransportschicht.

Die vorliegenden Erfindung betrifft daher auch eine Zusammensetzung enthaltend wenigstens eine erfindungsgemäß einzusetzende Verbindung, bevorzugt eine Verbindung umfassend Strukuren gemäß Formeln (I) und/oder (II-1) bis (II-11) bzw. die zuvor und nachfolgend ausgeführten bevorzugten Ausführungsformen sowie wenigstens ein weiteres Matrixmaterial.

Geeignete Matrixmaterialien, welche in Kombination mit den Verbindungen gemäß Formeln (I) und/oder (II-1) bis (II-11) bzw. gemäß den bevorzugten Ausführungsformen eingesetzt werden können, sind aromatische Ketone, aromatische Phosphinoxide oder aromatische Sulfoxide oder Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl) oder die in WO 2005/039246, US 2005/0069729, JP 2004/288381, EP 1205527, WO 2008/086851 oder WO 2013/041176, Indolocarbazolderivate, z. B. gemäß WO 2007/063754 oder WO 2008/056746, Indenocarbazolderivate, z. B. gemäß WO 2010/136109, WO 2011/000455, WO 2013/041176 oder WO 2013/056776, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2007/063754, WO 2008/056746, WO 2010/015306, WO 2011/057706, WO 2011/060859 oder WO 2011/060877, Zinkkomplexe, z. B. gemäß EP 652273 oder WO 2009/062578, Diazasilol- bzw. Tetraazasilol-Derivate, z. B. gemäß WO 2010/054729, Diazaphosphol-Derivate, z. B. gemäß WO 2010/054730, verbrückte Carbazol-Derivate, z. B. gemäß WO 2011/042107, WO 2011/060867, WO 2011/088877 und WO 2012/143080, Triphenylenderivate, z. B. gemäß WO 2012/048781, Dibenzofuranderivate, z. B. gemäß WO 2015/169412, WO 2016/015810, WO 2016/023608, WO 2017/148564 oder WO 2017/148565 oder Biscarbazole, z. B. gemäß JP 3139321 B2, Lactame, z. B. gemäß WO 2011/116865, WO 2011/137951 oder WO 2013/064206, 4-Spirocarbazol-Derivate, z. B. gemäß WO 2014/094963 oder WO 2015/192939. Ebenso kann ein weiterer phosphoreszierender Emitter, welcher kürzerwellig als der eigentliche Emitter emittiert, als Co-Host in der Mischung vorhanden sein.

Bevorzugte Co-Host-Materialien sind Triazine, Chinazoline, Chinoxaline, Triarylaminderivate, insbesondere Monoamine, Indenocarbazolderivate, 4-Spirocarbazolderivate, Lactame und Carbazolderivate.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben. Insbesondere eignen sich in Kombination mit der erfindungsgemäßen Verbindung als Co-Matrix-Material Verbindungen, welche eine große Bandlücke aufweisen und selber nicht oder zumindest nicht in wesentlichem Maße am Ladungstransport der emittierenden Schicht teilnehmen. Es handelt sich bei solchen Materialien bevorzugt um reine Kohlenwasserstoffe. Beispiele für solche Materialien finden sich beispielsweise in der WO 2009/124627 oder in der WO 2010/006680.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum.

Besonders bevorzugt kann eine erfindungsgemäß einzusetzende Verbindung umfassend Strukuren gemäß Formeln (I) und/oder (II-1) bis (II-11) in einer bevorzugten Ausführungsform als Matrixmaterial in einer Emissionsschicht einer organischen elektronischen Vorrichtung, insbesondere in einer organischen elektrolumineszierenden Vorrichtung, beispielsweise in einer OLED oder OLEC, eingesetzt werden. Dabei ist das Matrixmaterial enthaltend Verbindung umfassend Strukuren gemäß Formeln (I) und/oder (II-1) bis (II-11) bzw. die zuvor und nachfolgend ausgeführten bevorzugten Ausführungsformen in der elektronischen Vorrichtung in Kombination mit einem oder mehreren Dotanden, vorzugsweise phosphoreszierenden Dotanden, vorhanden.

Der Anteil des Matrixmaterials in der emittierenden Schicht beträgt in diesem Fall zwischen 50.0 und 99.9 Vol.-%, bevorzugt zwischen 80.0 und 99.5 Vol.-% und besonders bevorzugt für fluoreszierende emittierende Schichten zwischen 92.0 und 99.5 Vol.-% sowie für phosphoreszierende emittierende Schichten zwischen 85.0 und 97.0 Vol.-%.

Entsprechend beträgt der Anteil des Dotanden zwischen 0.1 und 50.0 Vol.-%, bevorzugt zwischen 0.5 und 20.0 Vol.-% und besonders bevorzugt für fluoreszierende emittierende Schichten zwischen 0.5 und 8.0 Vol.-% sowie für phosphoreszierende emittierende Schichten zwischen 3.0 und 15.0 Vol.-%.

Eine emittierende Schicht einer organischen Elektrolumineszenzvorrichtung kann auch Systeme umfassend mehrere Matrixmaterialien (Mixed-Matrix-Systeme) und/oder mehrere Dotanden enthalten. Auch in diesem Fall sind die Dotanden im Allgemeinen diejenigen Materialien, deren Anteil im System der kleinere ist und die Matrixmaterialien sind diejenigen Materialien, deren Anteil im System der größere ist. In Einzelfällen kann jedoch der Anteil eines einzelnen Matrixmaterials im System kleiner sein als der Anteil eines einzelnen Dotanden.

In einer weiteren bevorzugten Ausführungsform der Erfindung werden die Verbindungen umfassend Strukuren gemäß Formeln (I) und/oder (II-1) bis (II-11) bzw. die zuvor und nachfolgend ausgeführten bevorzugten Ausführungsformen als eine Komponente von Mixed-Matrix-Systemen verwendet. Die Mixed-Matrix-Systeme umfassen bevorzugt zwei oder drei verschiedene Matrixmaterialien, besonders bevorzugt zwei verschiedene Matrixmaterialien. Bevorzugt stellt dabei eines der beiden Materialien ein Material mit lochtransportierenden Eigenschaften und das andere Material ein Material mit elektronentransportierenden Eigenschaften dar. Die gewünschten elektronentransportierenden und lochtransportierenden Eigenschaften der Mixed-Matrix-Komponenten können jedoch auch hauptsächlich oder vollständig in einer einzigen Mixed-Matrix-Komponente vereinigt sein, wobei die weitere bzw. die weiteren Mixed-Matrix-Komponenten andere Funktionen erfüllen. Die beiden unterschiedlichen Matrixmaterialien können dabei in einem Verhältnis von 1:50 bis 1:1, bevorzugt 1:20 bis 1:1, besonders bevorzugt 1:10 bis 1:1 und ganz besonders bevorzugt 1:4 bis 1:1 vorliegen. Bevorzugt werden Mixed-Matrix-Systeme in phosphoreszierenden organischen Elektrolumineszenzvorrichtungen eingesetzt. Genauere Angaben zu Mixed-Matrix-Systemen sind unter anderem in der Anmeldung WO 2010/108579 enthalten.

Ein weiterer Gegenstand der vorliegenden Erfindung ist die Verwendung einer erfindungsgemäßen Verbindung in einer elektronischen Vorrichtung, insbesondere in einer organischen Elektrolumineszenzvorrichtung.

Ein nochmals weiterer Gegenstand der vorliegenden Erfindung ist die Verwendung einer erfindungsgemäß einzusetzende Verbindung und/oder eines erfindungsgemäßen Oligomers, Polymers oder Dendrimers in einer elektronischen Vorrichtung als fluoreszierenden Emitter, Emitter, der TADF (thermally activated delayed fluorescence) zeigt, Hostmaterial, Elektronentransportmaterial, Elektroneninjektionsmaterial, Lochtransportmaterial, Loch-injektionsmaterial, Elektronenblockiermaterial, Lochblockiermaterial und/oder Wide-Band-Gap-Material, vorzugsweise als Hostmaterial, Elektronentransportmaterial, Lochblockiermaterial und/oder Elektroneninjektionsmaterial.

Ein nochmals weiterer Gegenstand der vorliegenden Erfindung ist eine elektronische Vorrichtung enthaltend mindestens eine erfindungsgemäß einsetzbare Verbindung und/oder eine eine erfindungsgemäße Verbindung. Eine elektronische Vorrichtung im Sinne der vorliegenden Erfindung ist eine Vorrichtung, welche Anode, Kathode und mindestens eine dazwischen liegende Schicht aufweist, die mindestens eine organische Verbindung enthält. Das Bauteil kann dabei auch anorganische Materialien enthalten oder auch Schichten, welche vollständig aus anorganischen Materialien aufgebaut sind.

Die elektronische Vorrichtung ist bevorzugt ausgewählt aus der Gruppe bestehend aus Besonders bevorzugt ist elektronische Vorrichtung ausgewählt aus der Gruppe bestehend aus organischen Elektrolumineszenzvorrichtungen (OLEDs, sOLED, PLEDs, LECs, etc.),vorzugsweise organische lichtemittierenden Dioden (OLEDs), organische lichtemittierenden Dioden auf Basis von kleinen Molekülen (sOLEDs), organische lichtemittierenden Dioden auf Basis von Polymeren (PLEDs), lichtemittierenden elektrochemischen Zellen (LECs), organischen Laserdioden (O-Laser), "organic plasmon emitting devices" (D. M. Koller et al., Nature Photonics 2008, 1-4); organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs) und organischen elektrischen Sensoren, bevorzugt organischen Elektrolumineszenzvorrichtungen (OLEDs, sOLED, PLEDs, LECs, etc.), besonders bevorzugt organische lichtemittierenden Dioden (OLEDs), organische lichtemittierenden Dioden auf Basis von kleiner Moleküle (sOLEDs), organische lichtemittierenden Dioden auf Basis von Polymeren (PLEDs), insbesondere phosphoreszierenden OLEDs.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Ebenso können zwischen zwei emittierende Schichten Interlayer eingebracht sein, welche beispielsweise eine exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Systeme mit drei emittierenden Schichten, wobei die drei Schichten blaue, grüne und orange oder rote Emission zeigen. Es kann sich bei der erfindungsgemäßen organischen Elektrolumineszenzvorrichtung auch um eine Tandem-Elektrolumineszenzvorrichtung handeln, insbesondere für weiß emittierende OLEDs.

In einer weiteren Ausführungsform der Erfindung enthält die erfindungsgemäße organische Elektrolumineszenzvorrichtung keine separate Lochinjektionsschicht und/oder Lochtransportschicht und/oder Lochblockierschicht und/oder Elektronentransportschicht, d. h. die emittierende Schicht grenzt direkt an die Lochinjektionschicht oder die Anode an, und/ oder die emittierende Schicht grenzt direkt an die Elektronentransportschicht oder die Elektroneninjektionsschicht oder die Kathode an, wie zum Beispiel in WO 2005/053051 beschrieben. Weiterhin ist es möglich, einen Metallkomplex, der gleich oder ähnlich dem Metallkomplex in der emittierenden Schicht ist, direkt angrenzend an die emittierende Schicht als Lochtransport- bzw. Lochinjektionsmaterial zu verwenden, wie z. B. in WO 2009/030981 beschrieben.

Die erfindungsgemäß einzusetzende Verbindung kann dabei in unterschiedlichen Schichten eingesetzt werden, je nach genauer Struktur. Bevorzugt ist eine organische Elektrolumineszenzvorrichtung, enthaltend eine Verbindung gemäß Formel (I) bzw. die oben ausgeführten bevorzugten Ausführungsformen in einer emittierenden Schicht als Matrixmaterial für phosphoreszierende Emitter, für Emitter, die TADF (thermally activated delayed fluorescence) zeigen, insbesondere für fluoreszierende Emitter oder phosphoreszierende Emitter. Weiterhin kann die erfindungsgemäße Verbindung auch in einer Elektronentransportschicht und/oder in einer Lochtransportschicht und/oder in einer Exzitonenblockierschicht und/oder in einer Lochblockierschicht eingesetzt werden. Besonders bevorzugt wird die erfindungsgemäße Verbindung als Matrixmaterial für rot, orange oder gelb phosphoreszierende Emitter, insbesondere für rot phosphoreszierende Emitter, in einer emittierenden Schicht oder als Elektronentransport- bzw. Lochblockiermaterial in einer Elektronentransport- bzw. Lochblockierschicht eingesetzt.

Ferner ist eine elektronische Vorrichtung, vorzugsweise eine organische Elektrolumineszenzvorrichtung Gegenstand der vorliegenden Erfindung, die eine oder mehrere erfindungsgemäße Verbindungen und/oder mindestens ein erfindungsgemäßes Oligomer, Polymer oder Dendrimer in einer oder mehreren elektronenleitenden Schichten umfasst, als elektronenleitende Verbindung.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine elektronischen Vorrichtung, insbesondere eine organische Elektrolumineszenzvorrichtung, welche dadurch gekennzeichnet ist, dass eine oder mehrere Schichten mit einem Sublimationsverfahren beschichtet werden. Dabei werden die Materialien in Vakuum-Sublimationsanlagen bei einem Anfangsdruck von üblicherweise kleiner $10^{-5}$ mbar, bevorzugt kleiner $10^{-6}$ mbar aufgedampft. Es ist auch möglich, dass der Anfangsdruck noch geringer oder noch höher ist, beispielsweise kleiner $10^{-7}$ mbar.

Bevorzugt ist ebenfalls eine elektronischen Vorrichtung, insbesondere eine organische Elektrolumineszenzvorrichtung, welche dadurch gekennzeichnet ist, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine elektronischen Vorrichtung, insbesondere eine organische Elektrolumineszenzvorrichtung, welche dadurch gekennzeichnet ist, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution

erhalten werden.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:

1. Elektronische Vorrichtungen, insbesondere organische Elektrolumineszenzvorrichtungen enthaltend erfindungsgemäß einzusetzende Verbindungen, Oligomere, Polymere oder Dendrimere, bzw. die zuvor und nachfolgend ausgeführten bevorzugten Ausführungsformen, insbesondere als Emitter, vorzugsweise als fluoreszreszierender Emitter , als elektronenleitende Materialien und/oder Lochtransportmaterialien oder als Matrixmaterialien, weisen eine sehr gute Lebensdauer auf.

2. Elektronische Vorrichtungen, insbesondere organische Elektrolumineszenzvorrichtungen enthaltend erfindungsgemäß einzusetzende Verbindungen, Oligomere, Polymere oder Dendrimere, bzw. die zuvor und nachfolgend ausgeführten bevorzugten Ausführungsformen insbesondere als Emitter, vorzugsweise als fluoreszreszierender Emitter , als Elektronentransport-Materialien, Lochtransportmaterialien und/oder als Hostmaterialien weisen eine hervorragende Effizienz auf. Insbesondere ist die Effizienz deutlich höher gegenüber analogen Verbindungen, die keine erfindungsgemäße Struktur enthalten. Hierbei bewirken die erfindungsgemäßen Verbindungen, Oligomere, Polymere oder Dendrimere bzw. die zuvor und nachfolgend ausgeführten bevorzugten Ausführungsformen eine geringe Betriebsspannung bei Verwendung in elektronischen Vorrichtungen. Hierbei bewirken diese Verbindungen insbesondere einen geringen Roll-off, d.h. einen geringen Abfall der Leistungseffizienz der Vorrichtung bei hohen Leuchtdichten.

3. Elektronische Vorrichtungen, insbesondere organische Elektrolumineszenzvorrichtungen enthaltend Verbindungen, Oligomere, Polymere oder Dendrimere bzw. die zuvor und nachfolgend ausgeführten bevorzugten Ausführungsformen als Emitter, vorzugsweise als fluoreszreszierender Emitter, als Elektronentransport-Materialien, Lochtransportmaterialien und/oder als Hostmaterialien weisen sehr schmal Emissionsbanden mit geringen FWHM-Werten (**F**ull **W**idth **H**alf **M**aximum) auf und führen zu besonders Farb-reiner Emission, erkennbar an den kleinen CIE-y-Werten.

4. Die erfindungsgemäß einzusetzenden Verbindungen, Oligomere, Polymere oder Dendrimere bzw. die zuvor und nachfolgend ausgeführten bevorzugten Ausführungsformen zeigen eine sehr hohe thermische und photochemische Stabilität und führen zu Verbindungen mit einer sehr hohen Lebensdauer.

5. Mit Verbindungen, Oligomeren, Polymeren oder Dendrimere bzw. die zuvor und nachfolgend ausgeführten bevorzugten Ausführungsformen kann in elektronischen Vorrichtungen, insbesondere organische Elektrolumineszenzvorrichtungen die Bildung von optischen Verlustkanäle vermieden werden. Hierdurch zeichnen sich diese Vorrichtungen durch eine hohe PL- und damit hohe EL-Effizienz von Emittern bzw. eine ausgezeichnete Energieübertragung der Matrices auf Dotanden aus.

6. Verbindungen, Oligomere, Polymere oder Dendrimere bzw. die zuvor und nachfolgend ausgeführten bevorzugten Ausführungsformen weisen eine ausgezeichnete Glasfilmbildung auf.

7. Verbindungen, Oligomere, Polymere oder Dendrimere bzw. die zuvor und nachfolgend ausgeführten bevorzugten Ausführungsformen bilden aus Lösungen sehr gute Filme.

Diese oben genannten Vorteile gehen im Allgemeinen nicht mit einer Verschlechterung der weiteren elektronischen Eigenschaften einher.

In den weiteren Schichten der erfindungsgemäßen organischen Elektrolumineszenzvorrichtung können alle Materialien verwendet werden, wie sie üblicherweise gemäß dem Stand der Technik eingesetzt werden. Der Fachmann kann daher ohne erfinderisches Zutun alle für organische Elektrolumineszenzvorrichtungen bekannten Materialien in Kombination mit den erfindungsgemäßen Verbindungen, die in einer organischen elektronischen Vorrichtung als aktive Verbindung einsetzbar sind, bevorzugt Verbindungen, umfassend Strukturen gemäß den Formeln (I) und/oder (II-1) bis (II-11) bzw. gemäß den bevorzugten Ausführungsformen einsetzen.

Die erfindungsgemäßen Verbindungen weisen bei Verwendung in organischen Elektrolumineszenzvorrichtungen generell sehr gute Eigenschaften auf. Insbesondere ist bei Verwendung der erfindungsgemäßen Verbindungen in organischen Elektrolumineszenzvorrichtungen die Lebensdauer wesentlich besser im Vergleich zu ähnlichen Verbindungen gemäß dem Stand der Technik. Dabei sind die weiteren Eigenschaften der organischen Elektrolumineszenzvorrichtung, insbesondere die Effizienz und die Spannung, ebenfalls besser oder zumindest vergleichbar.

Es sei darauf hingewiesen, dass Variationen der in der vorliegenden Erfindung beschriebenen Ausführungsformen unter den Umfang dieser Erfindung fallen. Jedes in der vorliegenden Erfindung offenbarte Merkmal kann, sofern dies nicht explizit ausgeschlossen wird, durch alternative Merkmale, die demselben, einem äquivalenten oder einem ähnlichen Zweck dienen, ausgetauscht werden. Somit ist jedes in der vorliegenden Erfindung offenbartes Merkmal, sofern nichts anderes gesagt wurde, als Beispiel einer generischen Reihe oder als äquivalentes oder ähnliches Merkmal zu betrachten.

Alle Merkmale der vorliegenden Erfindung können in jeder Art miteinander kombiniert werden, es sei denn dass sich bestimmte Merkmale und/oder Schritte sich gegenseitig ausschließen. Dies gilt insbesondere für bevorzugte Merkmale der vorliegenden Erfindung. Gleichermaßen können Merkmale nicht wesentlicher Kombinationen separat verwendet werden (und nicht in Kombination).

Es sei ferner darauf hingewiesen, dass viele der Merkmale, und insbesondere die der bevorzugten Ausführungsformen der vorliegenden Erfindung selbst erfinderisch und nicht lediglich als Teil der Ausführungsformen der vorliegenden Erfindung zu betrachten sind. Für diese Merkmale kann ein unabhängiger Schutz zusätzlich oder alternativ zu jeder gegenwärtig beanspruchten Erfindung begehrt werden.

Die mit der vorliegenden Erfindung offengelegte Lehre zum technischen Handeln kann abstrahiert und mit anderen Beispielen kombiniert werden.

Die Erfindung wird durch die nachfolgenden Beispiele näher erläutert, ohne sie dadurch einschränken zu wollen.

Der Fachmann kann aus den Schilderungen ohne erfinderisches Zutun weitere erfindungsgemäße elektronische Vorrichtungen herstellen und somit die Erfindung im gesamten beanspruchten Bereich ausführen.

## Beispiele

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbindungen die mehrere enantiomere, diastereomere oder tautomere Formen aufweisen können wird eine Form stellvertretend gezeigt.

### Synthese der erfindungsgemäßen Verbindungen

### Beispiel B1:

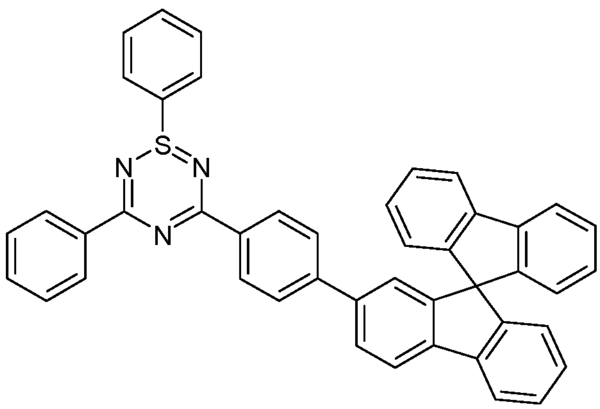

Ein Gemisch aus 36.4 g [100 mmol] 3-(p-Chlorphenyl)-1,5-diphenyl-1H-1,2, 4,6-thiatriazine [100174-69-4], 39.6 g [110 mmol] 9,9'-Spirobi[9H-fluoren]-2-yl-boronsäure [236389-21-2], 42.5 g [200 mmol] Trikaliumphosphat, wasserfrei [7778-53-2], 1.64 g [4 mmol] SPhos [657408-07-6], 449 mg [2 mmol] Palladium(II)acetat, 50 g Glaskugeln (3 mm Durchmesser), 300 ml Dioxan und 200 ml 2-Ethoxyethanol wird 16 h bei 100 °C gerührt. Man saugt noch heiß über ein mit Dioxan vorgeschlämmtes Celite-Bett ab, engt das Filtrat zur Trockene ein und flash-chromatographiert das Rohprodukt,

Kieselgel, *n* Heptan/EE (Ethylacetat), Säulenautomat Torrent der Fa. A. Semrau. Die weitere Reinigung erfolgt durch wiederholte Chromatographie oder durch fünfmalige Heißextraktionskristallisation aus DCM (Dichlormethan) / Acetonitril (1:2 - 1:5, vv) und fraktionierte Sublimation im Hochvakuum. Ausbeute: 29.8 g (46 mmol) 46 %; Reinheit: ca. 99.9 % n. HPLC.

Analog können folgende Verbindungen dargestellt werden:

| Bsp. | Edukt | Produkt | Ausbeute |
|---|---|---|---|
| B2 | 100174-69-4 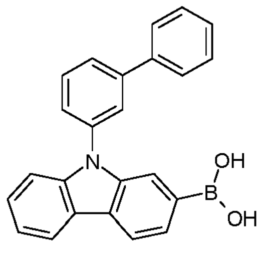 1835251-21-2 | 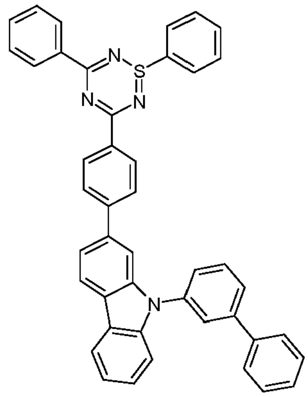 | 50 % |
| B3 | 100174-69-4 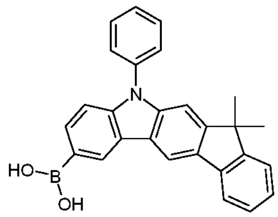 1379585-25-7 | 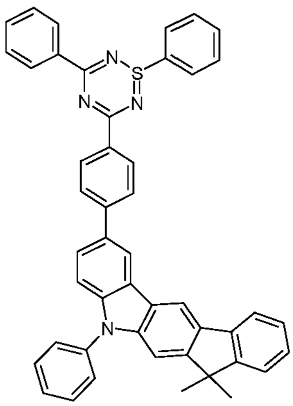 | 53 % |
| B4 | 100174-69-4 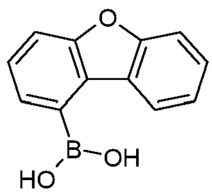 162607-19-4 | 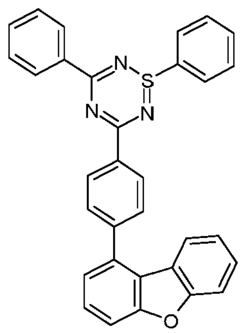 | 47 % |

(fortgesetzt)

| Bsp. | Edukt | Produkt | Ausbeute |
|---|---|---|---|
| B5 | 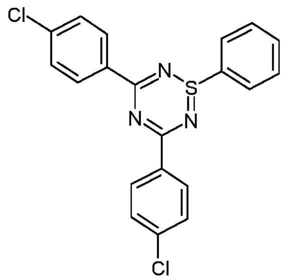 100153-92-2 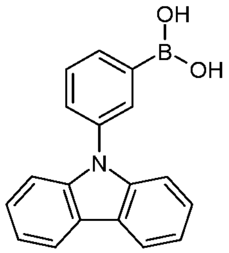 864377-33-3 | 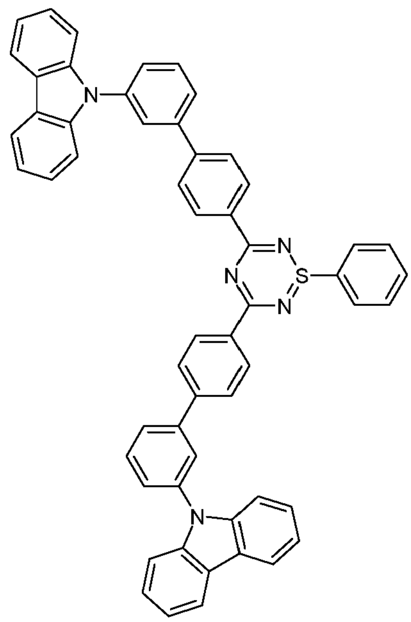 | 32 % |
| B30 | 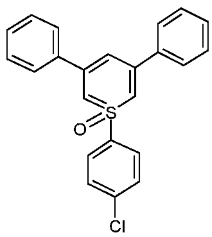 92637-42-8 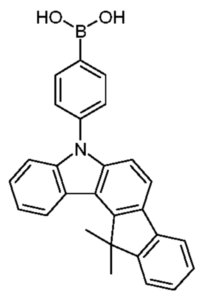 2241229-08-1 | 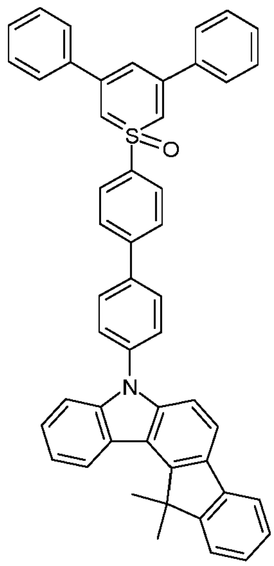 | 60 % |

**Beispiel B50:**

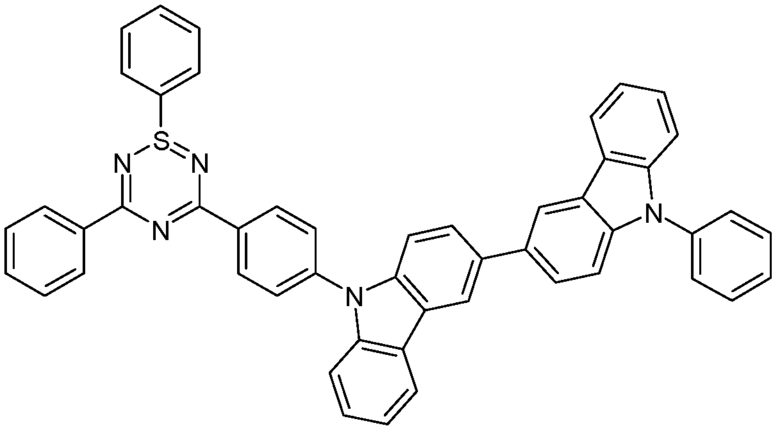

Ein gut gerührtes Gemisch aus 36.4 g [100 mmol] 3-(*p*-Chlorphenyl)-1,5-diphenyl-1*H*-1,2,4,6-thiatriazine [100174-69-4], 44.9 g [110 mmol] 9-Phenyl-3,3'-bi-9H-carbazole [1060735-14-9], 14.4 g [150 mmol] Natriumtert-butanolat [865-48-5], 809 mg [4 mmol] Tri-tert-butylphosphin [13716-12-6], 449 mg [2 mmol] Palladium(II)acetat, 50 g Glaskugeln (3 mm Durchmesser) und 500 ml Toluol wird 16 h unter Rückfluss gerührt. Man saugt noch heiß über ein mit Toluol vorgeschlämmtes Celite-Bett ab, engt das Filtrat zur Trockene ein und flash-chromatographiert das Rohprodukt, Kieselgel, *n* Heptan/EE (Ethylacetat), Säulenautomat Torrent der Fa. A. Semrau. Die weitere Reinigung erfolgt durch wiederholte Chromatographie oder durch fünfmalige Heißextraktions-kristallisation aus DCM (Dichlormethan) / Acetonitril (1:2 - 1:5, vv) und fraktionierte Sublimation im Hochvakuum. Ausbeute: 37.7 g (51 mmol) 51 %; Reinheit: ca. 99.9 % n. HPLC.

Analog können folgende Verbindungen dargestellt werden:

| Bsp. | Edukt | Produkt | Ausbeute |
|---|---|---|---|
| B51 | 100174-69-4 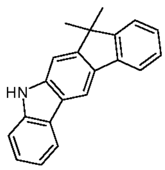 1257220-47-5 | 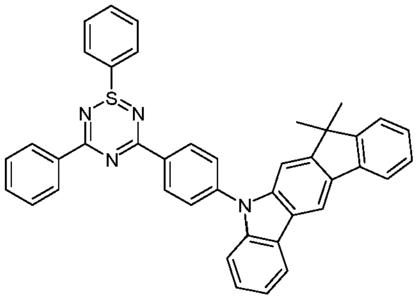 | 48 % |
| B52 | 100174-69-4 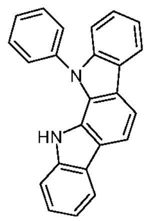 1024598-06-8 | 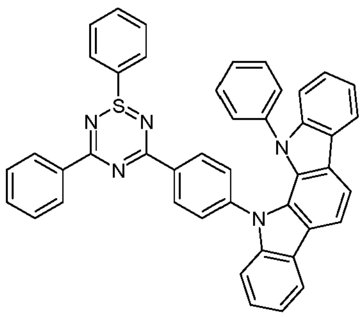 | 36 % |

(fortgesetzt)

| Bsp. | Edukt | Produkt | Ausbeute |
|---|---|---|---|
| B53 | 100153-92-2 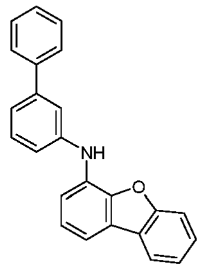 1426933-79-0 | 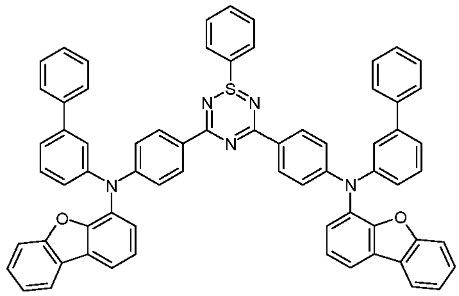 | 40 % |

**Beispiel B100:**

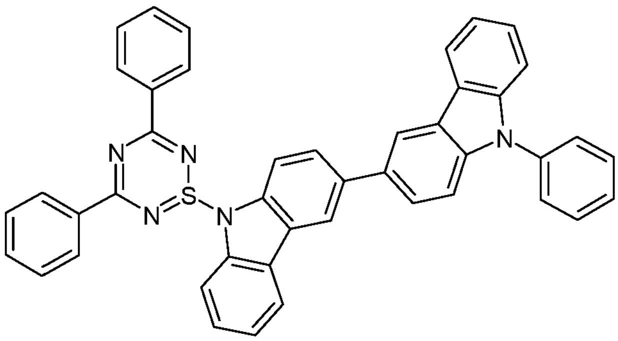

Eine auf -60 °C gekühlte Lösung von 40.9 g [100 mmol] 9-Phenyl-3,3'-bi-9*H*-carbazole [1060735-14-9] in 500 ml THF wird tropfenweise mit 40.0 ml [100 mmol] *n*-BuLi, 2.5 M in *n*-Hexan versetzt und 30 min. nachgerührt. Man transfereiert diese Lösung via Transfernadel zu einer gut gerührten, auf - 60 °C gekühlten Lösung von 28.8 g [100 mmol] 1-Chlor-3,5-diphenyl-1λ-1,2,4,6-thiatriazine [94426-38-7] in 500 ml THF. Nach vollendeter Zugabe rührt man 30 min. bei - 60 °C nach und lässt dann langsam auf Raumtemperatur erwärmen. Man entfernt das THF im Vakuum und flash-chromatographiert das Rohprodukt, Kieselgel, *n*-Heptan/EE (Ethylacetat), Säulenautomat Torrent der Fa. A. Semrau. Die weitere Reinigung erfolgt durch wiederholte Chromatographie oder durch fünfmalige Heißextraktionskristallisation aus DCM (Dichlormethan) / Acetonitril (1:2 - 1:4, vv) und fraktionierte Sublimation im Hochvakuum. Ausbeute: 36.3 g (55 mmol) 55 %; Reinheit: ca. 99.9 % n. HPLC.

Statt der Carbazole/sec-Arylamine können Arylbromide eingesetzt werden. Dann lässt man nach *n*-BuLi Zugabe zur Lösung des Arylbromids in THF diese langsam auf 0 °C erwärmen und kühlt die so erzeugte Aryl-Lithium-Lösung wieder auf -60 °C ab, bevor die zum Elektrophil transferiert wird.

Carbazole/sec-Arylamine und Arylbromide können konsekutiv eingesetzt werden. Dabei wird zunächst die reaktivere Chlor-Funktion am Schwefel und erst danach die beiden am Chlor-Funktionen am 1λ-1,2,4,6-Thiatriazin ausgetaucht.

Analog können folgende Verbindungen dargestellt werden:

| Bsp. | Edukte | Produkt | Ausbeute |
|---|---|---|---|
| B101 | 94426-38-7<br>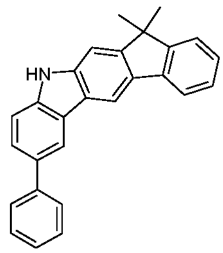<br>1257220-49-7 | 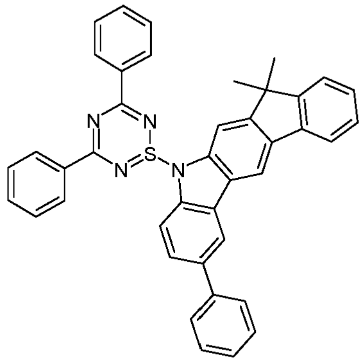 | 58 % |
| B102 | 94426-38-7<br>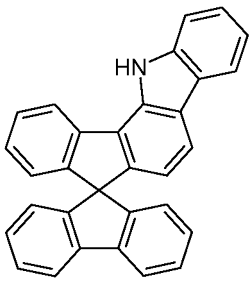<br>1615703-28-0 | 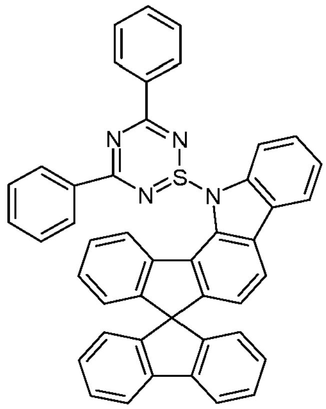 | 43 % |
| B103 | 94426-38-7<br>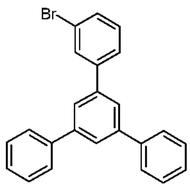<br>1233200-57-1 | 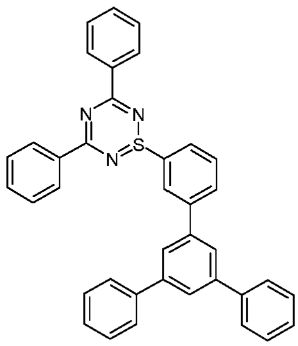 | 50 % |

(fortgesetzt)

| Bsp. | Edukte | Produkt | Ausbeute |
|---|---|---|---|
| B104 | 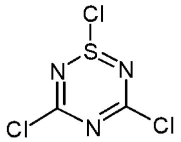<br>58589-34-7<br>1 eq<br>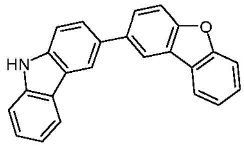<br>953809-18-0<br>dann 2 eq<br>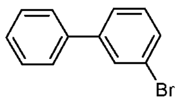<br>2113-57-7 | 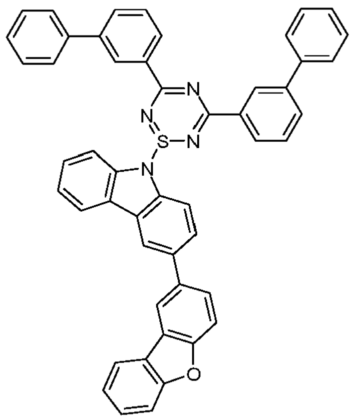 | 39 % |
| B105 | 58589-34-7<br>1 eq<br>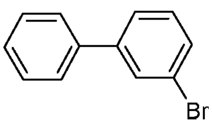<br>2113-57-7<br>dann 2 eq<br>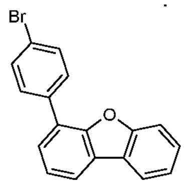<br>955959-84-9 | 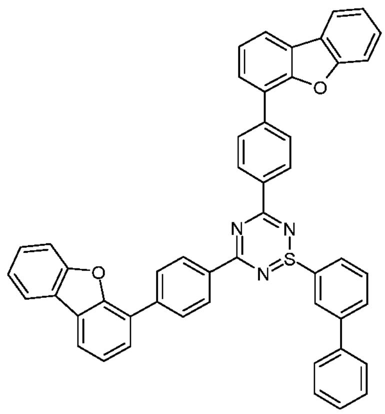 | 41 % |
| B106 | 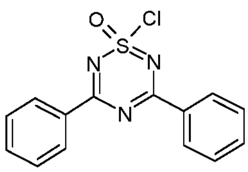<br>307929-26-6<br>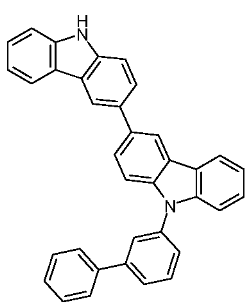<br>1800580-10-2 | 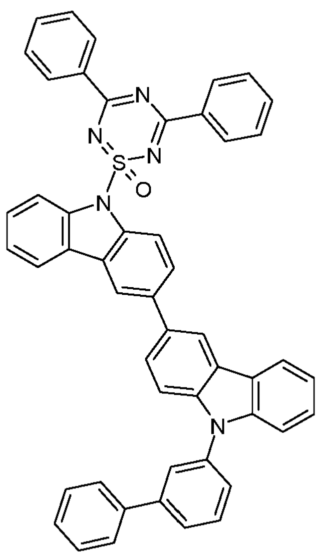 | 63 % |

(fortgesetzt)

| Bsp. | Edukte | Produkt | Ausbeute |
|---|---|---|---|
| B107 | 307929-26-6<br>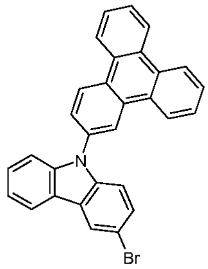<br>1351870-13-7 | 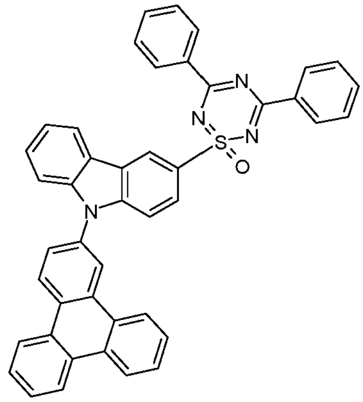 | 57 % |
| B108 | 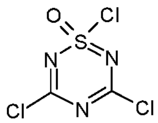<br>219957-19-4<br>1 eq<br>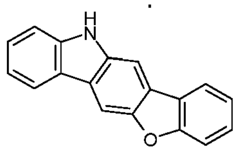<br>1199350-22-5<br>dann 2 eq<br>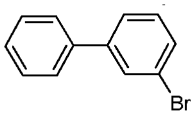<br>2113-57-7 | 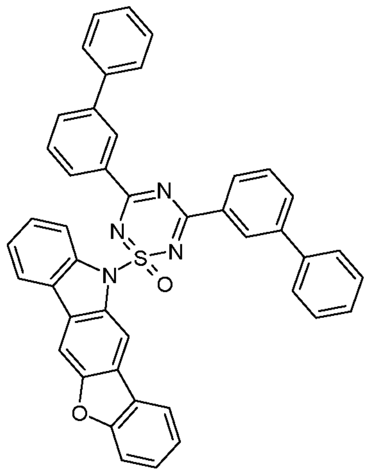 | 43 % |
| B109 | 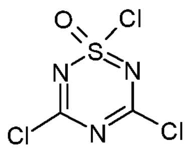<br>219957-19-4<br>3 eq<br>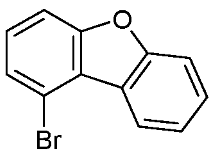<br>50548-45-3 | 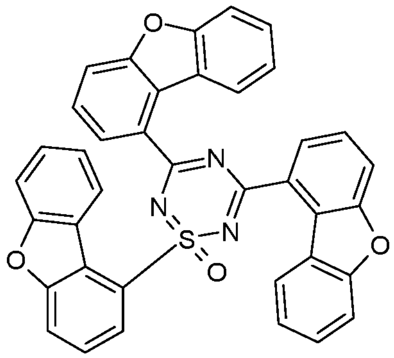 | 30 % |

**Beispiel B150:**

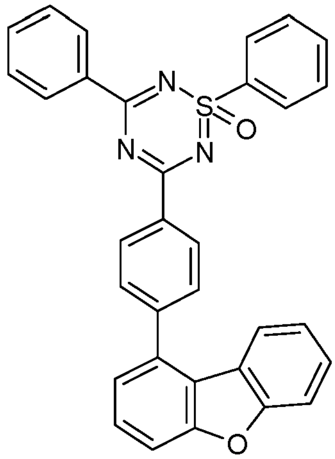

Eine Lösung von 4.96 g (10 mmol) B4 in 200 ml DCM wird mit einer Lösung von 4.73 g (30 mmol) Kaliumpermanganat in 300 ml Wasser und dann mit 3 Tropfen Aliquat 336 versetzt und bis zur vollständigen Oxidation bei Raumtemperatur gerührt (ca. 16 h). Man filtriert vom Braunstein über Celite ab, wäscht mit DCM nach, trennt die DCM-Phase ab und wäscht diese zweimal mit je 200 ml Wasser, das 0,5 ml Hydrazinhydrat enthält, zweimal mit je 200 ml Wasser, einmal mit 200 ml ges. Kochsalzlösung und trocknet über Magnesiumsulfat. Man filtriert vom Trockenmittel über eine mit DCM vorgeschlämmte Kieselgelsäure ab, entfernt das DCM im Vakuum und reinigt das Rohprodukt durch dreimalige Heißextraktionskristallisation aus DCM (Dichlormethan) / Acetonitril (1:2 - 1:5, vv) und fraktionierte Sublimation im Hochvakuum. Ausbeute: 3.97 g (8.0 mmol) 80 %; Reinheit: ca. 99.9 % n. HPLC.

Analog können folgende Verbindungen dargestellt werden:

| Bsp. | Edukte | Produkt | Ausbeute |
|---|---|---|---|
| B151 | B1 | 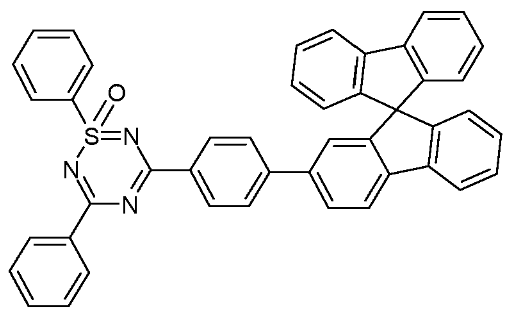 | 83 % |
| B152 | B2 | 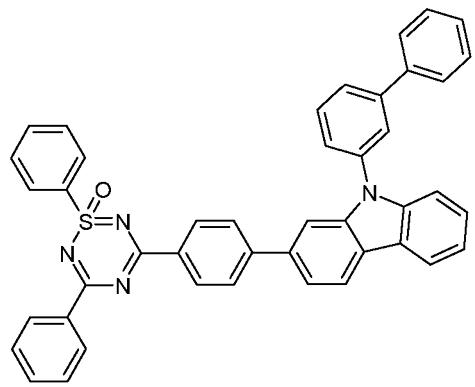 | 32 % |

(fortgesetzt)

| Bsp. | Edukte | Produkt | Ausbeute |
|---|---|---|---|
| B153 | B100 | 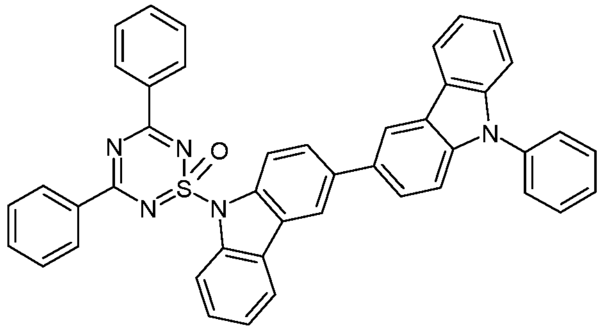 | 36 % |

**Beispiel: Herstellung der OLEDs**

**1) Vakuum-prozessierte Devices:**

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 25 Minuten mit UV-Ozon vorbehandelt (UV-Ozon Generator PR-100, Firma UVP) und innerhalb 30 min. zur verbesserten Prozessierung mit 20 nm PEDOT:PSS beschichtet (Poly(3,4-ethylendioxy-thiophen)poly(styrolsulfonat), bezogen als CLEVIOS™ P VP AI 4083 von Heraeus Precious Metals GmbH Deutschland, aus wässriger Lösung aufgeschleudert) und anschließend bei 180 °C 10 min. lang ausgeheizt. Diese beschichteten Glasplättchen bilden die Substrate, auf welche die OLEDs aufgebracht werden. Die OLEDs haben prinzipiell folgenden Schichtaufbau: Substrat / Lochinjektionsschicht 1 (HIL1) bestehend aus HTM1 dotiert mit 5 % NDP-9 (kommerziell erhältlich von der Fa. Novaled), 20 nm / Lochtransportschicht 1 (HTL1) bestehend aus HTM1, 170 nm für blaue Devices, 215 nm für grüne/gelbe Devices, 110 nm für rote Devices / Lochtransportschicht 2 (HTL2) / Emissionsschicht (EML) / Lochblockierschicht (HBL) / Elektronentransportschicht (ETL) / optionale Elektroneninjektionsschicht (EIL aus ETM2) und abschließend eine Kathode. Die Kathode wird durch eine 100 nm dicke Aluminiumschicht gebildet.

Zunächst werden vakuum-prozessierte OLEDs beschrieben. Hierfür werden alle Materialien in einer Vakuumkammer thermisch aufgedampft. Dabei besteht die Emissionsschicht immer aus mindestens einem Matrix-material (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M1:M2:Ir(L1) (55%:35%:10%) bedeutet hierbei, dass das Material M1 in einem Volumenanteil von 55%, M2 in einem Volumenanteil von 35% und Ir(L1) in einem Volumenanteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 4 gezeigt.

Die OLEDs werden standardmäßig charakterisiert. Hierfür werden die Elektrolumineszenzspektren, die Stromeffizienz (gemessen in cd/A), die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/m$^2$ bestimmt und daraus die CIE 1931 x und y Farbkoordinaten berechnet.

**Verwendung von erfindungsgemäßen Verbindungen als Emittermaterialien in phosphoreszierenden OLEDs**

Die erfindungsgemäßen Verbindungen lassen sich unter anderem als elektronenleitendes Hostmaterial eTMM in der Emissionsschicht EML einer phosphoreszierenden OLED und als Elektronentransportmaterial in der HBL und der ETL einsetzen. Die Ergebnisse der OLEDs sind in Tabelle 2 zusammengefasst.

**Tabelle 1: Aufbau der OLEDs**

| Bsp. | HTL2 Dicke | EML Dicke | HBL Dicke | ETL Dicke |
|---|---|---|---|---|
| Blaue OLED's | | | | |
| DB1-Ref | HTM3<br>20 nm | M3:M4:IrB1 (30%:60%:10%)<br>30 nm | ETM1<br>10nm | ETM1:ETM2 (50%:50%)<br>30 nm |
| DB1 | HTM3<br>20 nm | B104:M4:IrB1 (30%:60%:10%)<br>30 nm | ETM1<br>10nm | ETM1:ETM2 (50%:50%)<br>30 nm |
| Grüne und Gelbe OLED's | | | | |
| DG1-Ref | HTM2<br>10 nm | M1:M2:IrG1 (40%:50%:10%)<br>30 nm | ETM1<br>10nm | ETM1:ETM2 (50%:50%)<br>30 nm |
| DG1 | HTM2<br>10 nm | M1:M2:IrG1 (40%:50%:10%)<br>30 nm | B1<br>10nm | ETM1:ETM2 (50%:50%)<br>30 nm |
| DG2-Ref | HTM2<br>10 nm | M1:M2:IrG2 (44%:44%:12%)<br>30 nm | ETM1<br>10nm | ETM1:ETM2 (50%:50%)<br>30 nm |
| DG2 | HTM2<br>10 nm | M1:M2:IrG2 (44%:44%:12%)<br>30 nm | B2<br>10nm | ETM1:ETM2 (50%:50%)<br>30 nm |
| DG3 | HTM2<br>10 nm | B3:M2:IrG2 (44%:44%:12%)<br>30 nm | ETM1<br>10nm | ETM1:ETM2 (50%:50%)<br>30 nm |
| DG4 | HTM2<br>10 nm | B4:M2:IrG2 (40%:48%:12%)<br>30 nm | ETM1<br>10nm | ETM1:ETM2 (50%:50%)<br>30 nm |
| DG5 | HTM2<br>10 nm | B5:M2:IrG2 (55%:30%:15%)<br>30 nm | B5<br>10nm | B5: ETM2 (50%:50%)<br>30 nm |
| DG6 | HTM2<br>10 nm | B50:M2:IrG2 (40%:45%:15%)<br>30 nm | ETM1<br>10nm | ETM1:ETM2 (50%:50%)<br>30 nm |
| DG7 | HTM2<br>10 nm | M1:M2:IrG2 (40%:45%:15%)<br>30 nm | B51<br>10nm | ETM1:ETM2 (50%:50%)<br>30 nm |
| DG8 | HTM2<br>10 nm | B52:IrG2 (85%:15%)<br>30 nm | ETM1<br>10nm | ETM1:ETM2 (50%:50%)<br>30 nm |
| GD9 | HTM2<br>10 nm | B101:M2:IrG2 (40%:45%:15%)<br>30 nm | ETM1<br>10nm | ETM1:ETM2 (50%:50%)<br>30 nm |
| DG10 | HTM2<br>10 nm | B106:M2:IrG2 (40%:45%:15%)<br>30 nm | ETM1<br>10nm | ETM1:ETM2 (50%:50%)<br>30 nm |
| DG11 | HTM2<br>10 nm | B 107: M2: IrG2 (40%:45%:15%)<br>30 nm | B107<br>10nm | ETM1:ETM2 (50%:50%)<br>30 nm |
| DG12 | HTM2<br>10 nm | B 103: M2: IrG3 (50%:40%:10%)<br>30 nm | ETM1<br>10nm | ETM1:ETM2 (50%:50%)<br>30 nm |
| DG13 | HTM2<br>10 nm | B100:IrG3 (85%:15%)<br>30 nm | ETM1<br>10nm | ETM1:ETM2 (50%:50%)<br>30 nm |
| DG14 | HTM2<br>10 nm | B105:M2:IrG3 (40%:50%:10%)<br>30 nm | ETM1<br>10nm | ETM1:ETM2 (50%:50%)<br>30 nm |
| DG15 | HTM2<br>10 nm | B150:M4:IrG4 (30%:60%:10%)<br>30 nm | ETM1<br>10nm | ETM1:ETM2 (50%:50%)<br>30 nm |
| DG16 | HTM2<br>10 nm | B151:M4:IrG4 (30%:60%:10%)<br>30 nm | ETM1<br>10nm | ETM1:ETM2 (50%:50%)<br>30 nm |

(fortgesetzt)

| Grüne und Gelbe OLED's | | | | |
|---|---|---|---|---|
| DG17 | HTM2 10 nm | B152:M4:IrG4 (40%:50%:10%) 30 nm | ETM1 10nm | ETM1:ETM2 (50%:50%) 30 nm |
| DG18 | HTM2 10 nm | B153:M4:IrG4 (40%:50%:10%) 30 nm | ETM1 10nm | ETM1:ETM2 (50%:50%) 30 nm |

**Tabelle 2: Ergebnisse der Vakuum-prozessierten OLEDs**

| Bsp. | EQE (%) 1000 cd/m$^2$ | Spannung (V) 1000 cd/m$^2$ | CIE x/y 1000 cd/m$^2$ |
|---|---|---|---|
| Blaue OLED's | | | |
| DB1-Ref | 21.3 | 3.8 | 0.16/0.36 |
| DB1 | 21.8 | 3.5 | 0.16/0.36 |
| Grüne und Gelbe OLED's | | | |
| DG1-Ref | 20.7 | 3.4 | 0.34/0.61 |
| DG1 | 21.4 | 3.3 | 0.35/0.61 |
| DG2-Ref | 21.8 | 3.3 | 0.34/0.64 |
| DG2 | 22.3 | 3.3 | 0.34/0.64 |
| DG3 | 22.3 | 3.1 | 0.35/0.64 |
| DG4 | 22.1 | 3.1 | 0.34/0.64 |
| DG5 | 22.2 | 3.2 | 0.35/0.64 |
| DG6 | 22.6 | 3.1 | 0.34/0.64 |
| DG7 | 22.5 | 3.2 | 0.34/0.64 |
| DG8 | 22.5 | 3.2 | 0.34/0.64 |
| DG9 | 22.4 | 3.2 | 0.34/0.64 |
| DG10 | 22.5 | 3.2 | 0.34/0.64 |
| DG11 | 22.7 | 3.1 | 0.34/0.64 |
| DG12 | 27.1 | 3.1 | 0.49/0.51 |
| DG13 | 27.4 | 3.2 | 0.50/0.49 |
| DG14 | 27.0 | 3.0 | 0.49/0.51 |
| DG15 | 28.8 | 3.3 | 0.33/0.63 |
| DG16 | 28.9 | 3.4 | 0.33/0.63 |
| DG17 | 29.2 | 3.2 | 0.32/0.63 |
| DG18 | 29.3 | 3.3 | 0.33/0.62 |

**2) Lösungs-prozessierte Devices:**

**Aus niedermolekularen löslichen Funktionsmaterialien**

Die erfindungsgemäßen Verbindungen können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht (PEDOT:PSS von Clevios™) durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, wobei in diesem Fall wird HL-X von Merck verwendet wird. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices enthalten eine Emissionsschicht Ma:Mb:Ir (w%:x%:z%) oder Ma:Mb:Mc:Ir (w%:x%:y%:z%), s. Tabelle 3. Die Emissionsschicht wird in einer Inertgasatmosphäre, im vorliegenden Fall Argon, aufgeschleudert und 10 min bei 160 °C ausgeheizt. Darüber wird die Lochblockierschicht (10 nm ETM1) und die Elektronentransportschicht (40 nm ETM1 (50%) / ETM2 (50%)) aufgedampft (Aufdampfanlagen von Lesker o.a., typischer Aufdampfdruck $5 \times 10^{-6}$ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert. Tabelle 3 fasst die erhaltenen Daten zusammen.

**Tabelle 3: Ergebnisse mit aus Lösung prozessierten Materialien**

| **Bsp.** | **Emissionsschicht** | **EQE** (%) 1000 cd/m$^2$ | **Spannung** (V) 1000 cd/m$^2$ | **CIE x/y** 1000 cd/m$^2$ |
|---|---|---|---|---|
| Sol-Ref | M6:M7:IrG-Sol1 (20%:58%:22%) | 21.3 | 4.6 | 0.51/0.48 |
| Sol-D1 | M6:M7:B30:IrG-Sol1 (20%:48%:10%:22%) | 21.5 | 4.5 | 0.51/0.48 |
| Sol-D2 | M6:M7:B53:IrG-Sol1 (20%:48%:10%:22%) | 21.4 | 4.4 | 0.51/0.49 |
| Sol-D3 | B102:M7:IrG-Sol1 (20%:58%:22%) | 21.8 | 4.4 | 0.51/0.48 |
| Sol-D4 | M6:M7:B108:IrG-Sol1 (20%:48%:10%:22%) | 21.5 | 4.4 | 0.51/0.48 |
| Sol-D5 | M6:M7:B109:IrG-Sol1 (20%:48%:10%:22%) | 21.7 | 4.4 | 0.51/0.48 |

**Tabelle 4: Strukturformeln der verwendeten Materialien**

| | |
|---|---|
| 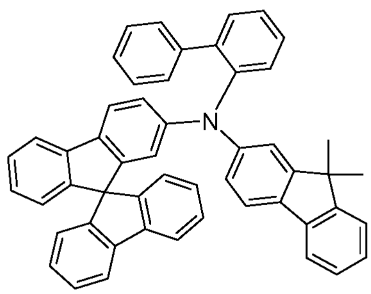 HTM1 [136463-07-5] | 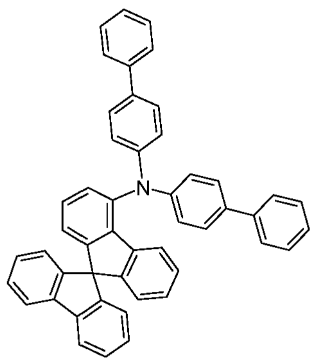 HTM2 [1450933-43-3] |

(fortgesetzt)

| | |
|---|---|
| 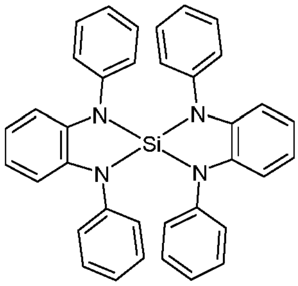 HTM3 [1206465-62-4] WO2010045729 | 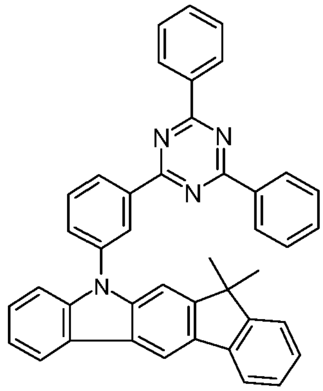 M1 [1257248-13-7] |
| 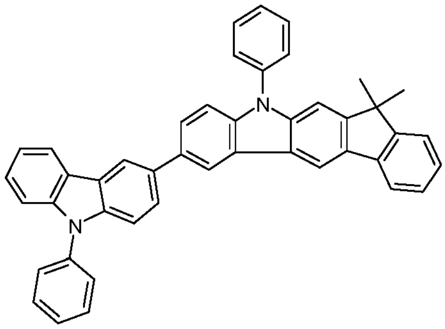 M2 [1357150-54-9] | 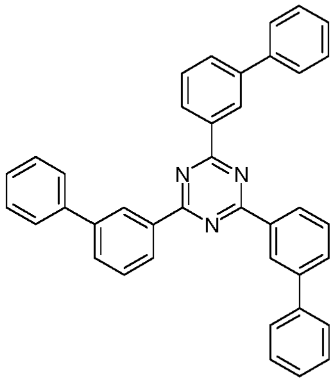 M3 [1201800-83-0] |
| 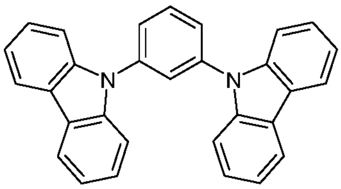 M4 [550378-78-4] | 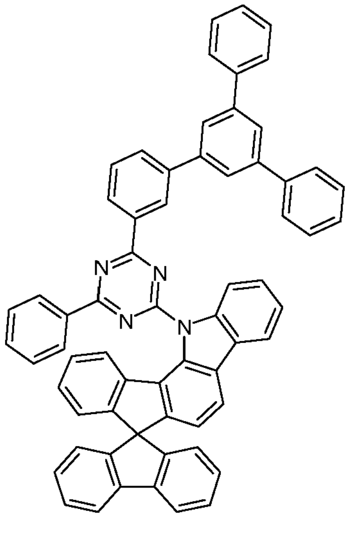 M6 [1616231-60-7] |

(fortgesetzt)

| | |
|---|---|
| 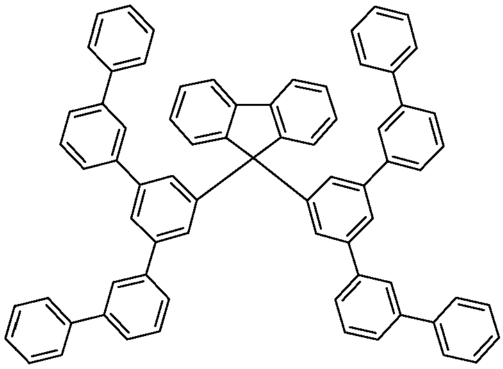 M7 [1246496-85-4] | |
| 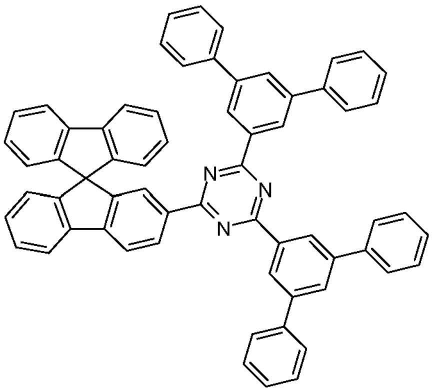 ETM1 [1233200-52-6] | 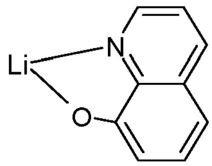 ETM2 [25387-93-3] |
| 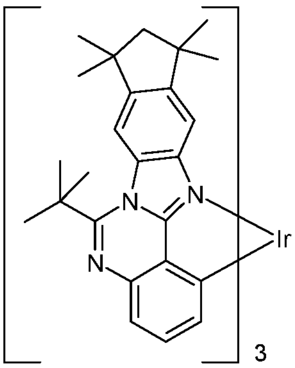 IrB1 1541114-98-0 | 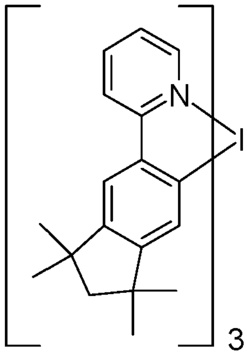 IrG1 1562420-772 |

(fortgesetzt)

| | |
|---|---|
| 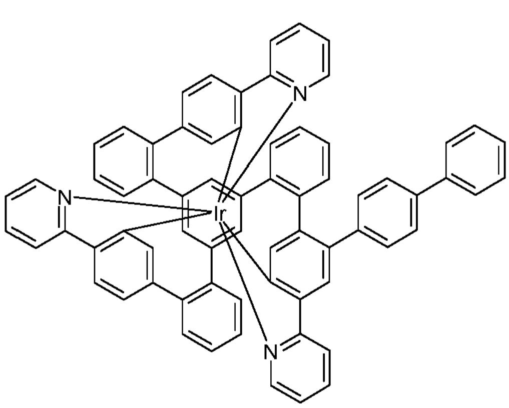<br>IrG2<br>2245866-06-0 | 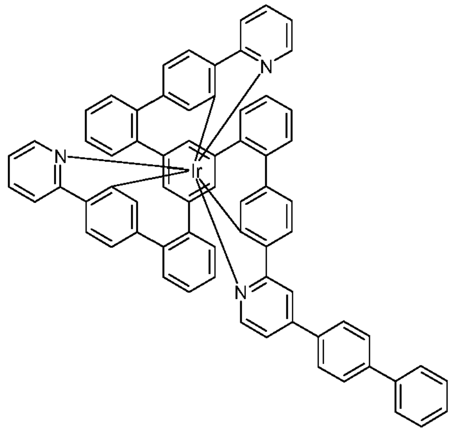<br>IrG3<br>2245945-28-0 |
| 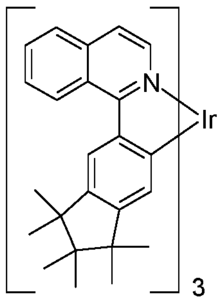<br>IrR1<br>1562420-79-4 | 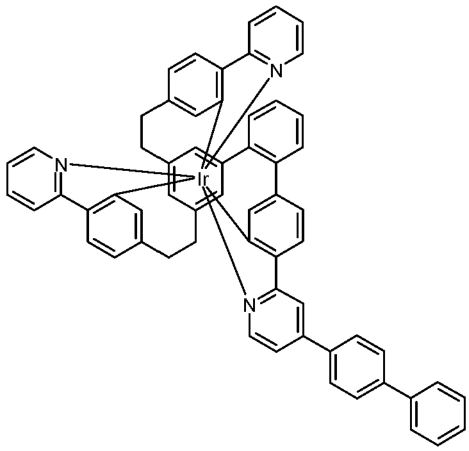<br>IrG-Sol1<br>2375153-57-2 |
| 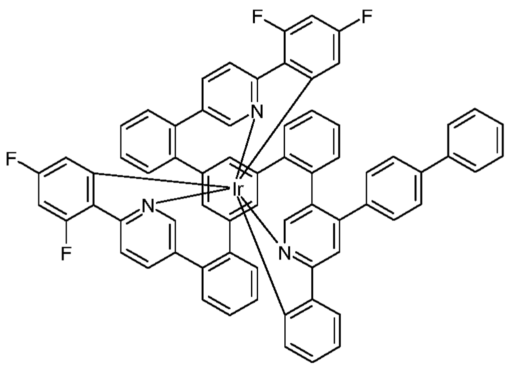<br>IrG4<br>WO 2018178001<br>WO 2020182779 | |

Die erfindungsgemäßen Materialien führen bei Einsatz in der Emissionsschicht EML, in der Lochblockerschicht HBL (**H**ole **B**locking **L**ayer), sowie in der Elektronentransportschicht ETL (**E**lectron **T**ransport **L**ayer) zu verbesserter EQE (**E**xternal **Q**uantum **E**fficacy) in Verbindung mit verringerter Spannung und damit insgesamt zu verbesserter Leistungseffizienz.

## Patentansprüche

1. Verwendung einer Verbindung umfassend mindestens eine Struktur der Formel (I), vorzugsweise einer Verbindung gemäß Formel (I),

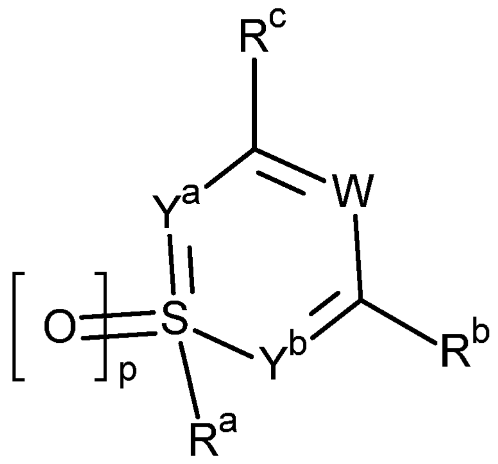

Formel (I)

wobei gilt:

W ist CR, N, $SR^a$ oder $S(=O)R^a$;
$Y^a$, $Y^b$ steht gleich oder verschieden für CR oder N;
p ist 0 oder 1, mit der Maßgabe, dass p=1 ist, falls die Gruppen W, $Y^a$, $Y^b$ jeweils für CR stehen;
$R^a$, $R^b$, $R^c$, ist gleich oder verschieden $N(Ar')_2$, $N(R^1)_2$ oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 60 aromatischen Ringatomen, die durch einen oder mehrere Reste $R^1$ substituiert sein kann; dabei können die Reste $R^a$, $R^b$, $R^c$ mit einer weiteren Gruppe ein Ringsystem bilden;
R ist bei jedem Auftreten gleich oder verschieden H, D, OH, F, Cl, Br, I, CN, $NO_2$, $N(Ar')_2$, $N(R^1)_2$, $C(=O)N(Ar')_2$, $C(=O)N(R^1)_2$, $C(Ar')_3$, $C(R^1)_3$, $Si(Ar')_3$, $Si(R^1)_3$, $B(Ar')_2$, $B(R^1)_2$, $C(=O)Ar'$, $C(=O)R^1$, $P(=O)(Ar')_2$, $P(=O)(R^1)_2$, $P(Ar')_2$, $P(R^1)_2$, $S(=O)Ar'$, $S(=O)R^1$, $S(=O)_2Ar'$, $S(=O)_2R^1$, $OSO_2Ar'$, $OSO_2R^1$, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten $R^1$ substituiert sein kann, wobei eine oder mehrere nicht benachbarte $CH_2$-Gruppen durch $R^1C=CR^1$, C≡C, $Si(R^1)_2$, C=O, C=S, C=Se, $C=NR^1$, -C(=O)O-, $-C(=O)NR^1-$, $NR^1$, $P(=O)(R^1)$, -O-, -S-, SO oder $SO_2$ ersetzt sein können, oder ein aromatisches oder heteroaromatisches Ringsystem mit 5 bis 60 aromatischen Ringatomen, das jeweils durch einen oder mehrere Reste $R^1$ substituiert sein kann, oder eine Aryloxy- oder Heteroaryloxygruppe mit 5 bis 60 aromatischen Ringatomen, die durch einen oder mehrere Reste $R^1$ substituiert sein kann; dabei können zwei Reste R auch miteinander oder einer weiteren Gruppe, beispielsweise mit einem oder mehreren der Reste $R^a$, $R^b$, $R^c$ ein Ringsystem bilden;
Ar' ist bei jedem Auftreten gleich oder verschieden ein aromatisches oder heteroaromatisches Ringsystem mit 5 bis 60 aromatischen Ringatomen, das mit einem oder mehreren Resten $R^1$ substituiert sein kann, dabei können zwei Reste Ar', welche an dasselbe C-Atom, Si-Atom, N-Atom, P-Atom oder B-Atom binden, auch durch eine Einfachbindung oder eine Brücke, ausgewählt aus $B(R^1)$, $C(R^1)_2$, $Si(R^1)_2$, C=O, $C=NR^1$, $C=C(R^1)_2$, O, S, S=O, $SO_2$, $N(R^1)$, $P(R^1)$ und $P(=O)R^1$, miteinander verbrückt sein;
$R^1$ ist bei jedem Auftreten gleich oder verschieden H, D, F, Cl, Br, I, CN, $NO_2$, $N(Ar'')_2$, $N(R^2)_2$, $C(=O)Ar''$, $C(=O)R^2$, $P(=O)(Ar'')_2$, $P(Ar'')_2$, $B(Ar'')_2$, $B(R^2)_2$, $C(Ar'')_3$, $C(R^2)_3$, $Si(Ar'')_3$, $Si(R^2)_3$, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen oder eine Alkenylgruppe mit 2 bis 40 C-Atomen, die jeweils mit einem oder mehreren Resten $R^2$ substituiert sein kann, wobei eine oder mehrere nicht benachbarte $CH_2$-Gruppen durch $-R^2C=CR^2-$, -C≡C-, $Si(R^2)_2$, C=O, C=S, C=Se, $C=NR^2$, -C(=O)O-, $-C(=O)NR^2-$, $NR^2$, $P(=O)(R^2)$, -O-, -S-, SO oder $SO_2$ ersetzt sein können und wobei ein oder mehrere H-Atome durch D, F, Cl, Br, I, CN oder $NO_2$

ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann, oder eine Aralkyl- oder Heteroaralkylgruppe mit 5 bis 60 aromatischen Ringatomen, die mit einem oder mehreren Resten $R^2$ substituiert sein kann, oder eine Kombination dieser Systeme; dabei können zwei oder mehrere, vorzugsweise benachbarte Reste $R^1$ miteinander ein Ringsystem bilden, dabei können einer oder mehrere Reste $R^1$ mit einem weiteren Teil der Verbindung ein Ringsystem bilden;

Ar" ist bei jedem Auftreten gleich oder verschieden ein aromatisches oder heteroaromatisches Ringsystem mit 5 bis 30 aromatischen Ringatomen, das mit einem oder mehreren Resten $R^2$ substituiert sein kann, dabei können zwei Reste Ar", welche an dasselbe C-Atom, Si-Atom, N-Atom, P-Atom oder B-Atom binden, auch durch eine Einfachbindung oder eine Brücke, ausgewählt aus $B(R^2)$, $C(R^2)_2$, $Si(R^2)_2$, C=O, $C=NR^2$, $C=C(R^2)_2$, O, S, S=O, $SO_2$, $N(R^2)$, $P(R^2)$ und $P(=O)R^2$, miteinander verbrückt sein;

$R^2$ ist bei jedem Auftreten gleich oder verschieden ausgewählt aus der Gruppe bestehend aus H, D, F, CN, einem aliphatischen Kohlenwasserstoffrest mit 1 bis 20 C-Atomen oder einem aromatischen oder heteroaromatischen Ringsystem mit 5 bis 30 aromatischen Ringatomen, in dem ein oder mehrere H-Atome durch D, F, Cl, Br, I oder CN ersetzt sein können und das durch ein oder mehrere Alkylgruppen mit jeweils 1 bis 4 Kohlenstoffatomen substituiert sein kann, dabei können zwei oder mehrere, vorzugsweise benachbarte Substituenten $R^2$ miteinander ein Ringsystem bilden;

in einer organischen elektronischen Vorrichtung.

2. Verwendung gemäß Anspruch 1, **dadurch gekennzeichnet, dass** die Verbindung umfassend Strukturen gemäß Formel (I), vorzugsweise Verbindungen gemäß Formel (I), in einer organischen elektronischen Vorrichtung als fluoreszierender Emitter, phosphoreszierender Emitter, Emitter, der TADF (thermally activated delayed fluorescence) zeigt, Hostmaterial, Excitonenblockiermaterial, Elektroneninjektionsmaterial, Elektronentransportmaterial, Elektronenblockiermaterial, Lochinjektionsmaterial, Lochleitermaterial, Lochblockiermaterial, n-Dotand, p-Dotand, Wide-Band-Gap-Material und/oder Ladungserzeugungsmeterial verwendet wird, vorzugsweise als Hostmaterial, Elektronentransportmaterial und/oder Lochblockiermaterial, besonders bevorzugt als Hostmaterial für phosphoreszierende Emitter und speziell bevorzugt als Hostmaterial für blau phosphoreszierende Emitter.

3. Verwendung gemäß Anspruch 1 oder 2, **dadurch gekennzeichnet, dass** die Verbindung mindestens eine Struktur der Formeln (II-1), (II-2), (II-3), (II-4), (II-5), (II-6), (II-7), (II-8), (II-9), (II-10) und (II-11) umfasst, vorzugsweise ausgewählt aus den Verbindungen der Formeln (II-1), (II-2), (II-3), (II-4), (II-5), (II-6), (II-7), (II-8), (II-9), (II-10) und (II-11),

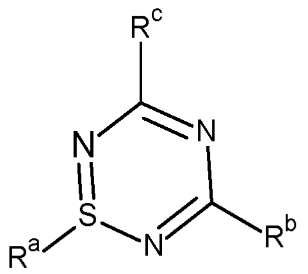

Formel (II-1)

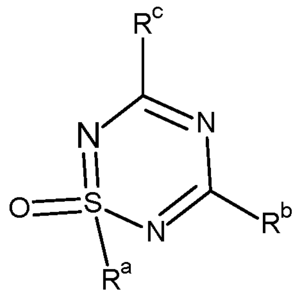

Formel (II-2)

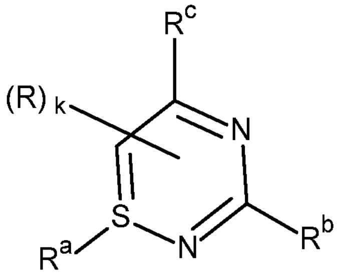

Formel (II-3)

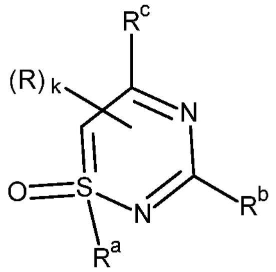

Formel (II-4)

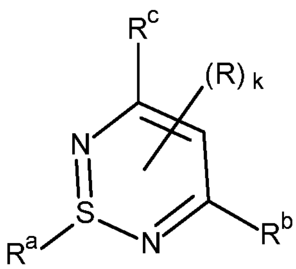

Formel (II-5)

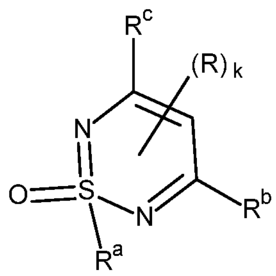

Formel (II-6)

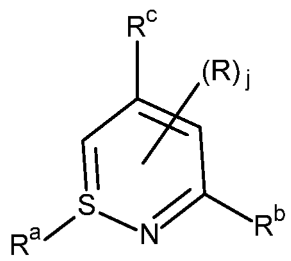

Formel (II-7)

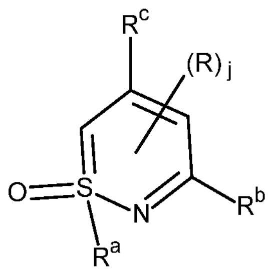

Formel (II-8)

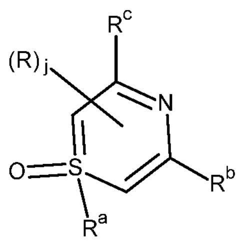

Formel (II-9)

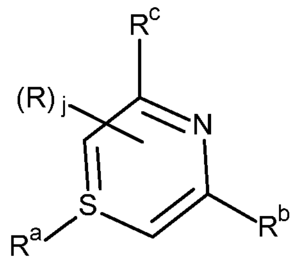

Formel (II-10)

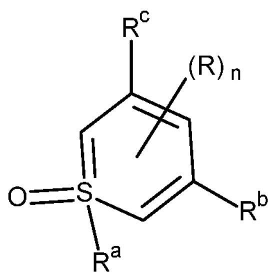

Formel (II-11)

wobei die Reste $R^a$, $R^b$, $R^c$ und R die in Anspruch 1 genannte Bedeutung haben, der Index n 0, 1, 2 oder 3, vorzugsweise 0, 1 oder 2 ist, der Index j 0, 1 oder 2 ist und der Index k 0 oder 1 ist.

4. Verwendung gemäß einem oder mehreren der vorhergehenden Ansprüche, **dadurch gekennzeichnet, dass** mindestens einer der Reste $R^a$, $R^b$, $R^c$ und/oder R ausgewählt ist aus der Gruppe der Phenyle, Fluorene, Indenofluorene, Spirobifluorene, Carbazole, Indenocarbazole, Indolocarbazole, Spirocarbazole, Pyrimidine, Triazine, Chinazoline, Chinoxaline, Pyridine, Chinoline, iso-Chinoline, Lactame, Triarylamine, Dibenzofurane, Dibenzothiene, Imidazole, Benzimidazole, Benzoxazole, Benzthiazole, 5-Aryl-phenanthridin-6-one, 9,10-Dehydrophenanthrene, Fluoranthene, Naphthaline, Phenanthrene, Anthracene, Benzanthracene, Fluoradene, Pyrene, Perylene, Chrysene, Borazine, Boroxine, Borole, Borazole, Azaborole, Ketone, Phosphinoxide, Arylsilane, Siloxane und deren Kombinationen.

5. Verwendung gemäß mindestens einem der vorhergehenden Ansprüche, **dadurch gekennzeichnet, dass** die Verbindung eine Lochtransportgruppe umfasst, wobei vorzugsweise einer der Reste $R^a$, $R^b$, $R^c$ und/oder R eine Lochtransportgruppe umfasst, vorzugsweise darstellt.

6. Verwendung gemäß Anspruch 5, **dadurch gekennzeichnet, dass** die Lochtransportgruppe eine Gruppe umfasst, bevorzugt für eine Gruppe steht, die ausgewählt ist aus den Formeln (H-1) bis (H-3)

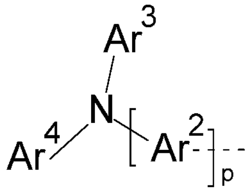
Formel (H-1)

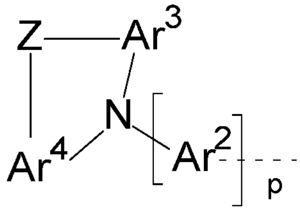
Formel (H-2)

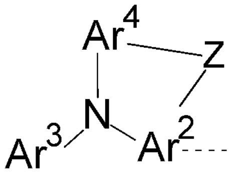
Formel (H-3)

wobei die gestrichelte Bindung die Anbindungsposition markiert und die Symbole die folgende Bedeutung aufweisen:

$Ar^2$, $Ar^3$, $Ar^4$ ist jeweils unabhängig ein aromatisches Ringsystem mit 6 bis 40 C-Atomen oder ein heteroaromatisches Ringsystem mit 3 bis 40 C-Atomen, welches jeweils durch einen oder mehrere Reste $R^1$ substituiert sein kann;
p ist 0 oder 1;
Z steht für eine Bindung oder $C(R^1)_2$, $Si(R^1)_2$, C=O, $NR^1$, $NAr^1$, $BR^1$, $PR^1$, $PO(R^1)$, SO, $SO_2$, Se, O oder S, vorzugsweise für eine Bindung oder $C(R^1)_2$, $NAr^1$, O oder S;
wobei $Ar^1$ ein aromatisches Ringsystem mit 6 bis 40 C-Atomen oder ein heteroaromatisches Ringsystem mit 3 bis 40 C-Atomen ist, welches durch einen oder mehrere Reste $R^1$ substituiert sein kann, und der Rest $R^1$ die zuvor, insbesondere in Anspruch 1 dargelegte Bedeutung aufweist.

7. Verwendung gemäß Anspruch 5 oder 6, **dadurch gekennzeichnet, dass** die Lochtransportgruppe eine Gruppe umfasst, bevorzugt für eine Gruppe steht, die ausgewählt ist aus den Formeln (H-4) bis (H-26)

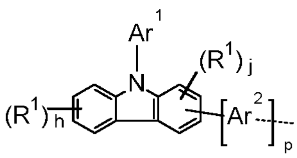
Formel (H-4)

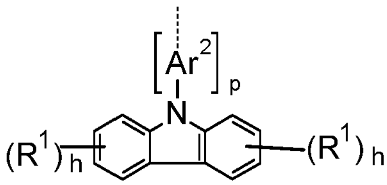
Formel (H-5)

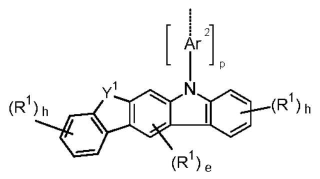

Formel (H-6)

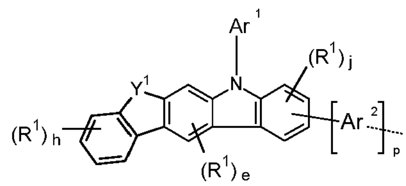

Formel (H-7)

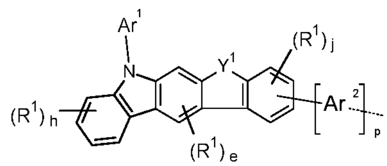

Formel (H-8)

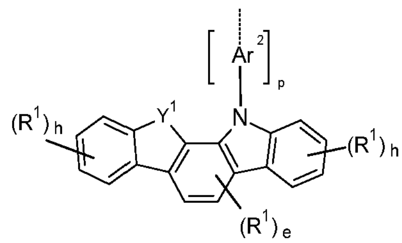

Formel (H-9)

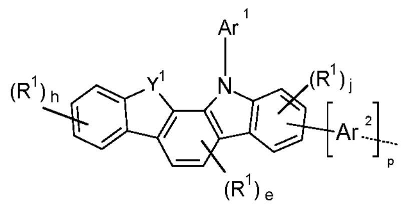

Formel (H-10)

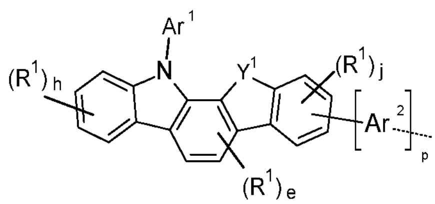

Formel (H-11)

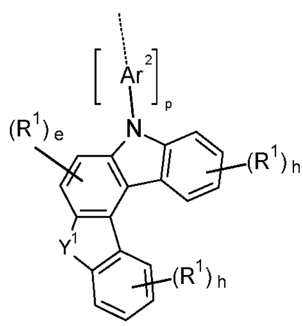

Formel (H-12)

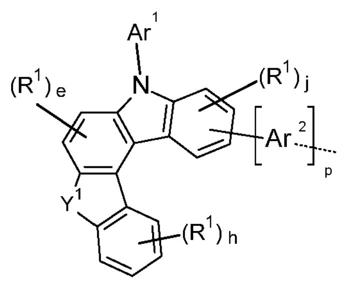

Formel (H-13)

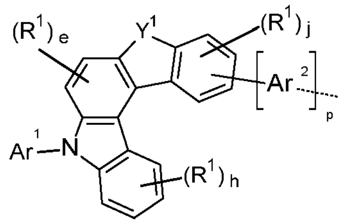

Formel (H-14)

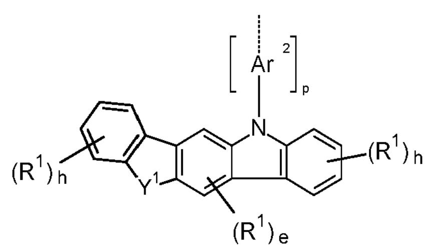

Formel (H-15)

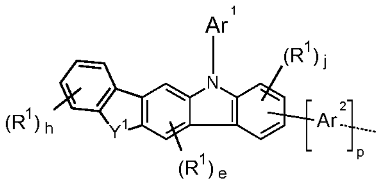

Formel (H-16)

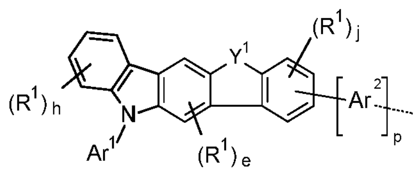

Formel (H-17)

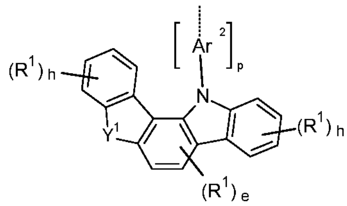

Formel (H-18)

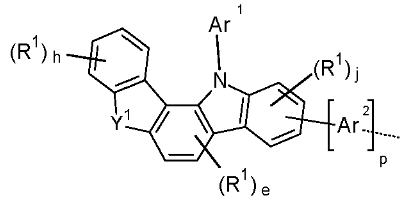

Formel (H-19)

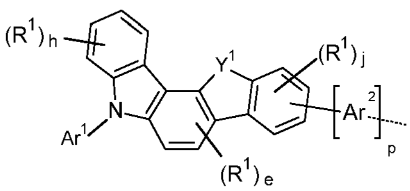

Formel (H-20)

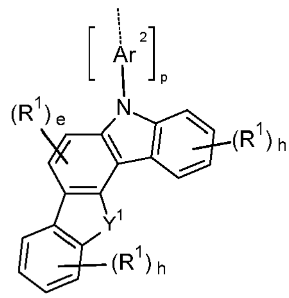

Formel (H-21)

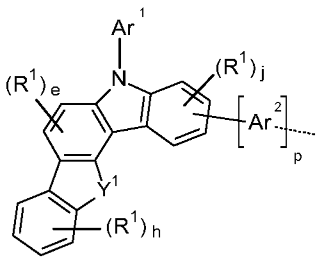

Formel (H-22)

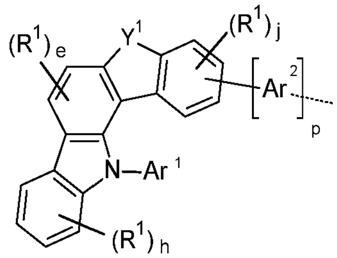

Formel (H-23)

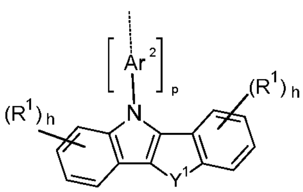

Formel (H-24)

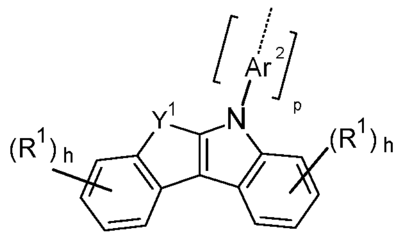

Formel (H-25)

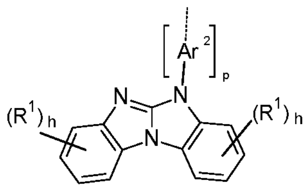

Formel (H-26)

wobei $Y^1$ O, S, $C(R^1)_2$ oder $NAr^1$ darstellt, die gestrichelte Bindung die Anbindungsposition markiert, e 0, 1 oder 2 ist, j 0, 1, 2 oder 3 ist, h 0, 1, 2, 3 oder 4 ist, p 0 oder 1 ist, $Ar^1$, $Ar^2$ und $R^1$ die in Anspruch 7 genannte Bedeutung aufweisen.

**8.** Verwendung gemäß mindestens einem der vorhergehenden Ansprüche, **dadurch gekennzeichnet, dass** die Verbindung einen Elektronentransportgruppe-umfassenden Rest umfasst, wobei vorzugsweise eine der Gruppen $R^a$, $R^b$, $R^c$ und/oder R einen Elektronentransportgruppe-umfassenden Rest umfasst, vorzugsweise darstellt.

**9.** Verwendung gemäß Anspruch 8, **dadurch gekennzeichnet, dass** die Elektronentransportgruppe ausgewählt ist aus Strukturen der Formeln (Q-11), (Q-12), (Q-13), (Q-14) und/oder (Q-15)

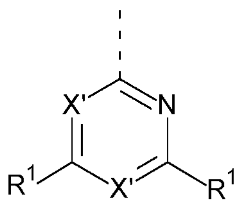

Formel (Q-11)

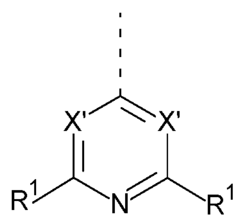

Formel (Q-12)

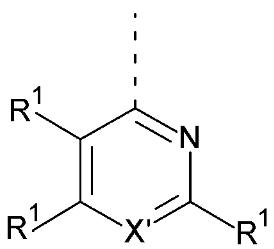

Formel (Q-13)

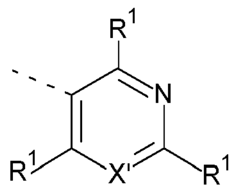

Formel (Q-14)

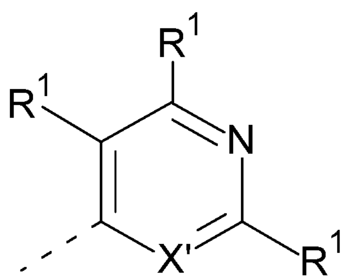

Formel (Q-15)

wobei das Symbol $R^1$ die zuvor in Anspruch 1 genannte Bedeutung aufweist, X‘ N oder $CR^1$ ist und die gestrichelte Bindung die Anbindungsposition markiert, wobei X‘ vorzugsweise ein Stickstoffatom darstellt.

**10.** Verwendung gemäß Anspruch 8 oder 9, **dadurch gekennzeichnet, dass** die Elektronentransportgruppe ausgewählt ist aus Strukturen der Formeln (Q-26), (Q-27), (Q-28), (Q-29) und/oder (Q-30),

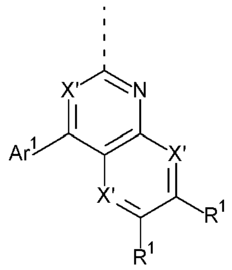

Formel (Q-26)

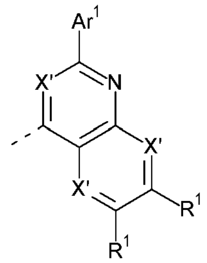

Formel (Q-27)

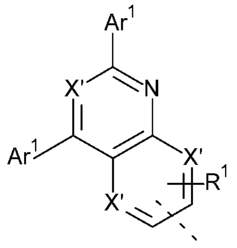

Formel (Q-28)

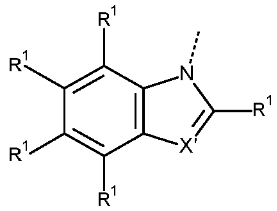

Formel (Q-29)

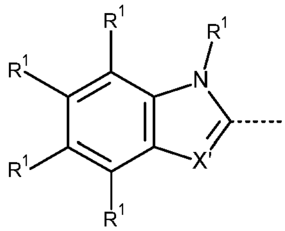

Formel (Q-30)

wobei die Symbole $Ar^1$ und $R^1$ die zuvor in Anspruch 1 oder 7 genannten Bedeutungen aufweisen, X‘ N oder $CR^1$ ist und die gestrichelte Bindung die Anbindungsposition markiert, wobei vorzugsweise genau ein X’ein Stickstoffatom darstellt.

**11.** Verwendung gemäß mindestens einem der vorhergehenden Ansprüche, **dadurch gekennzeichnet, dass** mindestens einer der Reste $R^a$, $R^b$, $R^c$ und/oder R mindestens ein aromatisches oder heteroaromatisches Ringsystem mit zwei, vorzugsweise mit drei kondensierten aromatischen oder heteroaromatischen Ringen umfasst.

**12.** Verwendung gemäß Anspruch 11, **dadurch gekennzeichnet, dass** das aromatisches oder heteroaromatisches Ringsystem mit zwei, vorzugsweise mit drei kondensierten aromatischen oder heteroaromatischen Ringen ausgewählt ist aus den Gruppen der Formeln (Ar-1) bis (Ar-17)

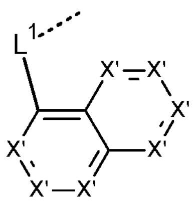

(Ar-1)

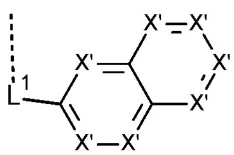

(Ar-2)

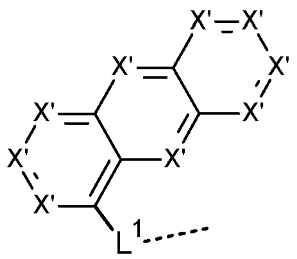

(Ar-3)

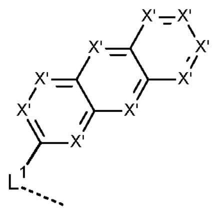
(Ar-4)

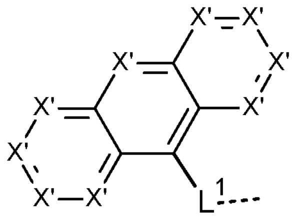
(Ar-5)

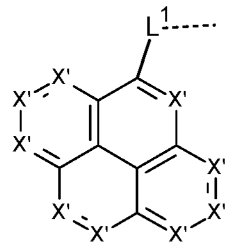
(Ar-6)

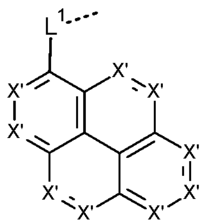
(Ar-7)

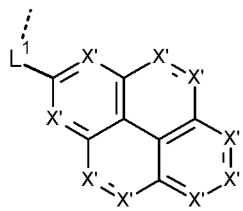
(Ar-8)

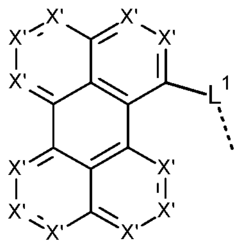
(Ar-9)

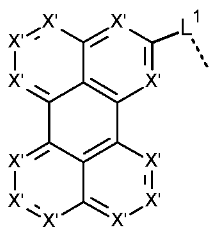
(Ar-10)

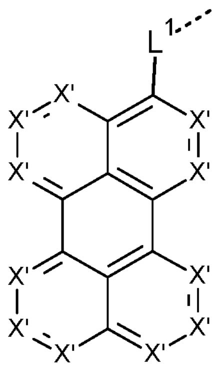
(Ar-11)

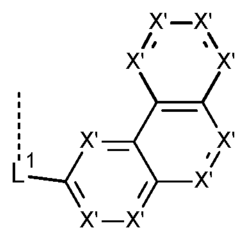
(Ar-12)

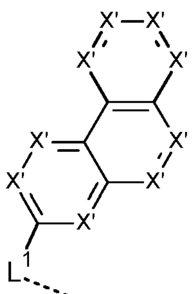
(Ar-13)

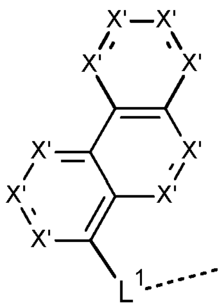
(Ar-14)

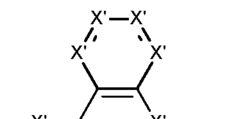
(Ar-15)

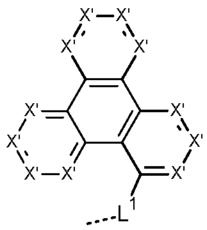

(Ar-16)

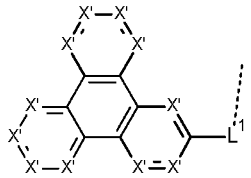

(Ar-17)

wobei X' N oder $CR^1$, vorzugsweise $CR^1$ ist, $L^1$ eine Bindung oder ein aromatisches oder heteroaromatisches Ringsystem mit 5 bis 40, bevorzugt 5 bis 30 aromatischen Ringatomen darstellt, welches durch einen oder mehrere Reste $R^1$ substituiert sein kann, $R^1$ die in Anspruch 1 dargelegte Bedeutung hat und die gestrichelte Bindung die Anbindungsposition markiert.

**13.** Zusammensetzung enthaltend eine Kombination umfassend

A) eine oder mehrere Verbindungen umfassend mindestens eine Struktur der Formel (I), vorzugsweise eine oder mehrere Verbindungen gemäß Formel (I),

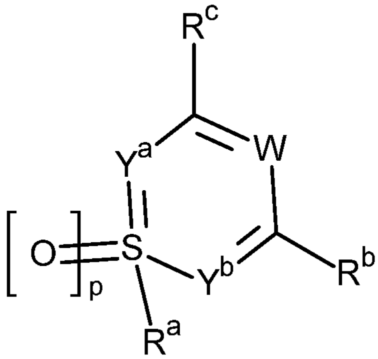

Formel (I)

wobei die Symbole p, $R^a$, $R^b$, $R^c$, $Y^a$, $Y^b$ und W die in Anspruch 1 genannte Bedeutung aufweisen;
B) eine weitere Verbindung ausgewählt aus der Gruppe bestehend aus fluoreszierenden Emittern, phosphoreszierenden Emittern, Emittern, die TADF (thermally activated delayed fluorescence) zeigen, Hostmaterialien, Excitonenblockiermaterialien, Elektroneninjektionsmaterialien, Elektronentransportmaterialien, Elektronenblockiermaterialien, Lochinjektionsmaterialien, Lochleitermaterialien, Lochblockiermaterialien, Quantenmaterialien, n-Dotanden, p-Dotanden, Wide-Band-Gap-Materialien und/oder Ladungserzeugungsmeterialien.

**14.** Verbindung umfassend mindestens eine Struktur der Formel (III), vorzugsweise Verbindung gemäß der Formel (III),

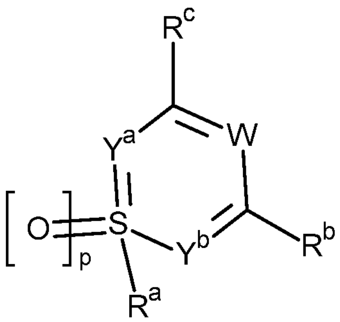

Formel (III)

wobei die Symbole p, $R^a$, $R^b$, $R^c$, $Y^a$, $Y^b$ und W die in Anspruch 1 genannte Bedeutung aufweisen und mindestens einer der Reste $R^a$, $R^b$, $R^c$, $Y^a$, $Y^b$ und Weine Gruppe HetAr umfasst oder darstellt, wobei HetAr für eine Gruppe steht, die ausgewählt ist aus den in Ansprüchen 7 und 8 definierten Formeln (H-1) bis (H-26) oder die ausgewählt ist aus den in Ansprüchen 10 und 11 definierten Formeln ( (Q-11) bis (Q-30), wobei die Gruppe HetAr mit einem Rest R, einer Gruppe $R^a$, $R^b$, $R^c$, $Y^a$, $Y^b$ oder einer weiteren Gruppe ein Ringsystem bilden kann.

**15.** Verbindung umfassend mindestens eine Struktur der Formel (V), vorzugsweise Verbindung gemäß der Formel (V),

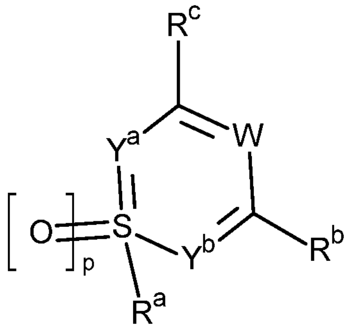

Formel (V)

wobei die Symbole p, $R^a$, $R^b$, $R^c$, $Y^a$, $Y^b$ und W die in Anspruch 1 genannte Bedeutung aufweisen und mindestens einer der Reste $R^a$, $R^b$, $R^c$, $Y^a$, $Y^b$ und Weine Gruppe KonAr umfasst oder darstellt, wobei KonAr für eine Gruppe steht, die ausgewählt ist aus den in Anspruch 13 definierten Formeln (Ar-3) bis (Ar-17), wobei KonAr mit einem oder mehreren Resten $R^1$ substituiert sein kann, wobei die Gruppe KonAr mit einem Rest R, einer Gruppe $R^a$, $R^b$, $R^c$, $Y^a$, $Y^b$ oder einer weiteren Gruppe ein Ringsystem bilden kann.

**16.** Verbindung umfassend genau zwei, genau drei oder genau vier Strukturen gemäß der in Anspruch 1 definierten Formel (I) und/oder gemäß der in Anspruch 3 definierten Formeln (II-1) bis (II-11).

**17.** Oligomere, Polymere oder Dendrimere enthaltend mindestens eine Verbindung deren Verwendung in einem oder mehreren der Ansprüche 1 bis 12 definiert ist, eine Verbindung nach Anspruch 14 oder 15, wobei statt eines Wasserstoffatoms oder eines Substituenten ein oder mehrere Bindungen zu dem jeweiligen Konstitutionsisomer der Mischung zum Polymer, Oligomer oder Dendrimer vorhanden sind.

**18.** Formulierung, enthaltend eine oder mehrere Verbindungen nach Anspruch 14 oder 15, ein Oligomer, Polymer oder Dendrimer nach Anspruch 17 oder eine Zusammensetzung nach Anspruch 13 und mindestens ein Lösemittel.

**19.** Elektronische Vorrichtung, enthaltend mindestens eine Verbindung deren Verwendung in einem oder mehreren der Ansprüche 1 bis 13 definiert ist, eine Verbindung nach einem oder mehreren der Ansprüche 14 bis 16, ein Oligomer, Polymer oder Dendrimer nach Anspruch 17 oder eine Zusammensetzung gemäß Anspruch 13, wobei die elektronische Vorrichtung bevorzugt ausgewählt ist aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laserdioden.

**20.** Elektronische Vorrichtung gemäß Anspruch 19, wobei es sich um eine elektrolumineszenzvorrichtung handelt die vorzugsweise ausgewählt ist aus der Gruppe bestehend aus den organischen lichtemittierenden dioden (OLED), den polymeren lichtemittierenden Dioden (PLED) und den organischen lichtemittierenden elektrochemischen Zellen (OLEC).

## Claims

**1.** Use of a compound comprising at least one structure of the formula (I), preferably a compound of the formula (I),

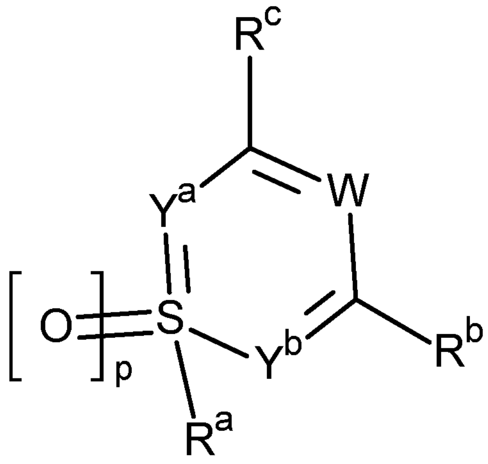

formula (I)

where the following applies:

W is CR, N, $SR^a$ or $S(=O)R^a$;
$Y^a$, $Y^b$ stand, identically or differently, for CR or N;
p is 0 or 1, with the proviso that p=1 if the groups W, $Y^a$, $Y^b$ each stand for CR;
$R^a$, $R^b$, $R^c$, are, identically or differently, $N(Ar')_2$, $N(R^1)_2$ or an aromatic or heteroaromatic ring system having 5 to 60 aromatic ring atoms, which may in each case be substituted by one or more radicals $R^1$, or an aryloxy or heteroaryloxy group having 5 to 60 aromatic ring atoms, which may be substituted by one or more radicals $R^1$; the radicals $R^a$, $R^b$, $R^c$ may form a ring system with a further group;
R is on each occurrence, identically or differently, H, D, OH, F, Cl, Br, I, CN, $NO_2$, $N(Ar')_2$, $N(R^1)_2$, $C(=O)N(Ar')_2$, $C(=O)N(R^1)_2$, $C(Ar')_3$, $C(R^1)_3$, $Si(Ar')_3$, $Si(R^1)_3$, $B(Ar')_2$, $B(R^1)_2$, C(=O)Ar', $C(=O)R^1$, $P(=O)(Ar')_2$, $P(=O)(R^1)_2$, $P(Ar')_2$, $P(R^1)_2$, S(=O)Ar', $S(=O)R^1$, $S(=O)_2Ar'$, $S(=O)_2R^1$, $OSO_2Ar'$, $OSO_2R^1$, a straight-chain alkyl, alkoxy or thioalkoxy group having 1 to 40 C atoms or an alkenyl or alkynyl group having 2 to 40 C atoms or a branched or cyclic alkyl, alkoxy or thioalkoxy group having 3 to 20 C atoms, where the alkyl, alkoxy, thioalkoxy, alkenyl or alkynyl group may in each case be substituted by one or more radicals $R^1$, where one or more non-adjacent $CH_2$ groups may be replaced by $R^1C=CR^1$, C=C, $Si(R^1)_2$, C=O, C=S, C=Se, $C=NR^1$, -C(=O)O-, -C(=O)NR'-, $NR^1$, P(=O)(R'), -O-, -S-, SO or $SO_2$, or an aromatic or heteroaromatic ring system having 5 to 60 aromatic ring atoms, which may in each case be substituted by one or more radicals $R^1$, or an aryloxy or heteroaryloxy group having 5 to 60 aromatic ring atoms, which may be substituted by one or more radicals $R^1$; two radicals R may also form a ring system with one another or a further group, for example with one or more of the radicals $R^a$, $R^b$, $R^c$;
Ar' is on each occurrence, identically or differently, an aromatic or heteroaromatic ring system having 5 to 60 aromatic ring atoms, which may be substituted by one or more radicals $R^1$, two radicals Ar' that are bonded to the same C atom, Si atom, N atom, P atom or B atom may also be bridged to one another by a single bond or a bridge selected from $B(R^1)$, $C(R^1)_2$, $Si(R^1)_2$, C=O, $C=NR^1$, $C=C(R^1)_2$, O, S, S=O, $SO_2$, $N(R^1)$, $P(R^1)$ and P(=O)R';
$R^1$ is on each occurrence, identically or differently, H, D, F, Cl, Br, I, CN, $NO_2$, $N(Ar'')_2$, $N(R^2)_2$, C(=O)Ar'', $C(=O)R^2$, $P(=O)(Ar'')_2$, $P(Ar'')_2$, $B(Ar'')_2$, $B(R^2)_2$, $C(Ar'')_3$, $C(R^2)_3$, $Si(Ar'')_3$, $Si(R^2)_3$, a straight-chain alkyl, alkoxy or thioalkoxy group having 1 to 40 C atoms or a branched or cyclic alkyl, alkoxy or thioalkoxy group having 3 to 40 C atoms or an alkenyl group having 2 to 40 C atoms, which may in each case be substituted by one or more radicals $R^2$, where one or more non-adjacent $CH_2$ groups may be replaced by $-R^2C=CR^2-$, -C=C-, $Si(R^2)_2$, C=O, C=S, C=Se, $C=NR^2$, -C(=O)O-, $-C(=O)NR^2-$, $NR^2$, $P(=O)(R^2)$, -O-, -S-, SO or $SO_2$ and where one or more H atoms may be replaced by D, F, Cl, Br, I, CN or $NO_2$, or an aromatic or heteroaromatic ring system having 5 to 60 aromatic ring atoms, which may in each case be substituted by one or more radicals $R^2$, or an aryloxy or heteroaryloxy group having 5 to 60 aromatic ring atoms, which may be substituted by one or more radicals $R^2$, or an aralkyl or heteroaralkyl group having 5 to 60 aromatic ring atoms, which may be substituted by one or more radicals $R^2$, or a combination of these systems; two or more, preferably adjacent radicals $R^1$ may form a ring system with one another, one or more radicals $R^1$ may form a ring system with a further part of the compound;
Ar'' is on each occurrence, identically or differently, an aromatic or heteroaromatic ring system having 5 to 30 aromatic ring atoms, which may be substituted by one or more radicals $R^2$, two radicals Ar'' that are bonded to the same C atom, Si atom, N atom, P atom or B atom may also be bridged to one another by a single bond or

a bridge selected from $B(R^2)$, $C(R^2)_2$, $Si(R^2)_2$, C=O, $C=NR^2$, $C=C(R^2)_2$, O, S, S=O, $SO_2$, $N(R^2)$, $P(R^2)$ and $P(=O)R^2$;

$R^2$ is selected on each occurrence, identically or differently, from the group consisting of H, D, F, CN, an aliphatic hydrocarbon radical having 1 to 20 C atoms or an aromatic or heteroaromatic ring system having 5 to 30 aromatic ring atoms, in which one or more H atoms may be replaced by D, F, Cl, Br, I or CN and which may be substituted by one or more alkyl groups, each having 1 to 4 carbon atoms, two or more preferably adjacent substituents $R^2$ may form a ring system with one another;

in an organic electronic device.

2. Use according to Claim 1, **characterised in that** the compound comprising structures of the formula (I), preferably compounds of the formula (I), in an organic electronic device as fluorescent emitter, phosphorescent emitter, emitter which exhibits TADF (thermally activated delayed fluorescence), host material, exciton-blocking material, electron-injection material, electron-transport material, electron-blocking material, hole-injection material, hole-conductor material, hole-blocking material, n-dopant, p-dopant, wide band gap material and/or charge-generation material, preferably as host material, electron-transport material and/or hole-blocking material, particularly preferably as host material for phosphorescent emitters and especially preferably as host material for blue-phosphorescent emitters.

3. Use according to Claim 1 or 2, **characterised in that** the compound comprises at least one structure of the formulae (II-1), (II-2), (II-3), (II-4), (II-5), (II-6), (II-7), (II-8), (II-9), (II-10) and (II-11), preferably selected from the compounds of the formulae (II-1), (II-2), (II-3), (II-4), (II-5), (II-6), (II-7), (II-8), (II-9), (II-10) and (II-11),

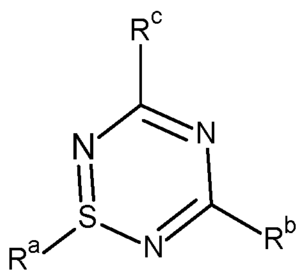

formula (II-1)

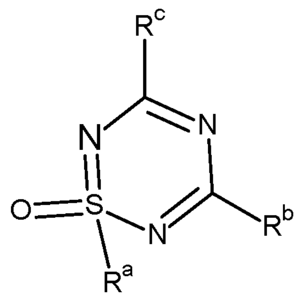

formula (II-2)

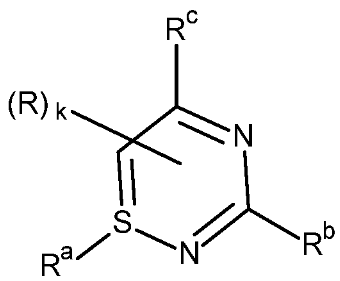

formula (II-3)

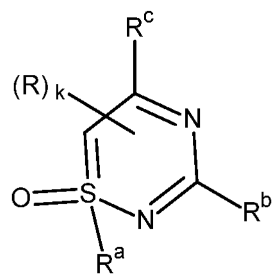

formula (II-4)

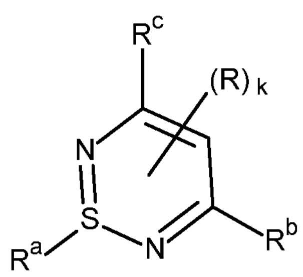

formula (II-5)

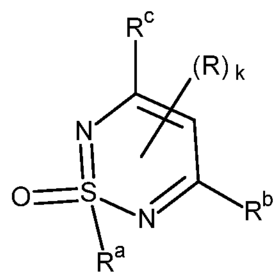

formula (II-6)

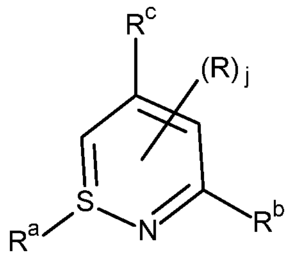

formula (II-7)

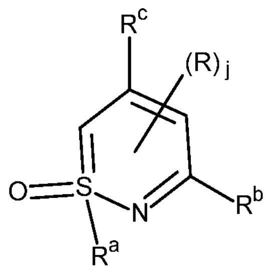

formula (II-8)

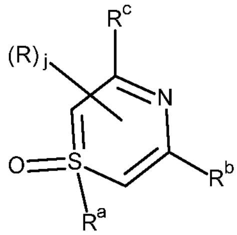

formula (II-9)

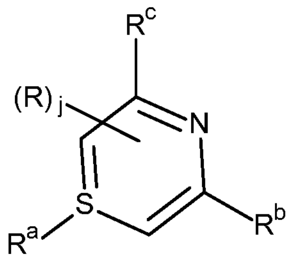

formula (II-10)

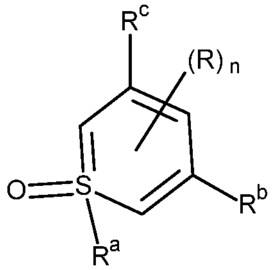

formula (II-11)

where the radicals $R^a$, $R^b$, $R^c$ and R have the meaning given in Claim 1, the index n is 0, 1, 2 or 3, preferably 0, 1 or 2, the index j is 0, 1 or 2 and the index k is 0 or 1.

**4.** Use according to one or more of the preceding claims, **characterised in that** at least one of the radicals $R^a$, $R^b$, $R^c$ and/or R is selected from the group of the phenyls, fluorenes, indenofluorenes, spirobifluorenes, carbazoles, indenocarbazoles, indolocarbazoles, spirocarbazoles, pyrimidines, triazines, quinazolines, quinoxalines, pyridines, quinolines, isoquinolines, lactams, triarylamines, dibenzofurans, dibenzothienes, imidazoles, benzimidazoles, benzoxazoles, benzothiazoles, 5-aryl-phenanthridin-6-ones, 9,10-dehydrophenanthrenes, fluoranthenes, naphthalenes, phenanthrenes, anthracenes, benzanthracenes, fluoradenes, pyrenes, perylenes, chrysenes, borazines, boroxines, boroles, borazoles, azaboroles, ketones, phosphine oxides, arylsilanes, siloxanes and combinations thereof.

**5.** Use according to at least one of the preceding claims, **characterised in that** the compound comprises a hole-transport group, where preferably one of the radicals $R^a$, $R^b$, $R^c$ and/or R comprises, preferably represents, a hole-transport group.

**6.** Use according to Claim 5, **characterised in that** the hole-transport group comprises a group, preferably stands for a group, selected from the formulae (H-1) to (H-3)

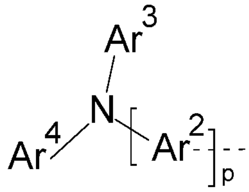

formula (H-1)

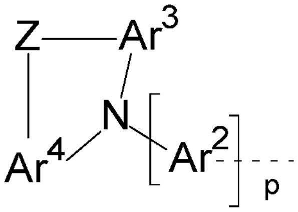

formula (H-2)

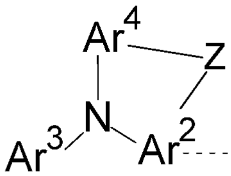

formula (H-3)

where the dashed bond marks the bonding position and the symbols have the following meaning:

$Ar^2$, $Ar^3$, $Ar^4$ are in each case independently an aromatic ring system having 6 to 40 C atoms or a heteroaromatic ring system having 3 to 40 C atoms, which may in each case be substituted by one or more radicals $R^1$;
p is 0 or 1;
Z stands for a bond or $C(R^1)_2$, $Si(R^1)_2$, C=O, $NR^1$, $NAr^1$, $BR^1$, $PR^1$, $PO(R^1)$, SO, $SO_2$, Se, O or S, preferably for a bond or $C(R^1)_2$, $NAr^1$, O or S;
where $Ar^1$ is an aromatic ring system having 6 to 40 C atoms or a heteroaromatic ring system having 3 to 40 C atoms, which may be substituted by one or more radicals $R^1$, and the radical $R^1$ has the meaning explained above, in particular in Claim 1.

7. Use according to Claim 5 or 6, **characterised in that** the hole-transport group comprises a group, preferably stands for a group, selected from the formulae (H-4) to (H-26)

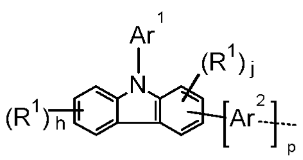

formula (H-4)

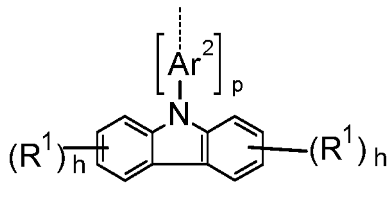

formula (H-5)

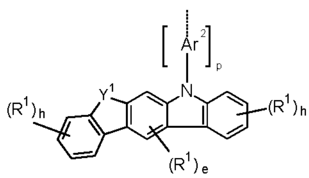

formula (H-6)

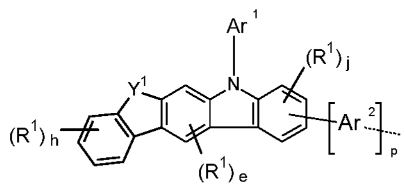

formula (H-7)

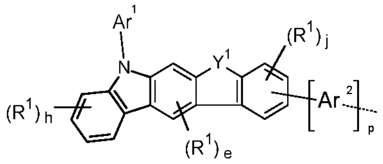

formula (H-8)

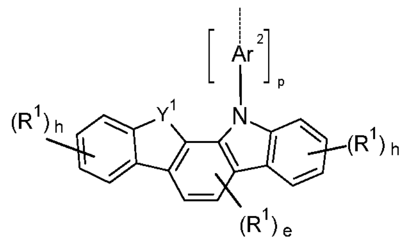

formula (H-9)

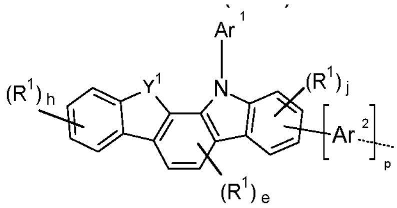

formula (H-10)

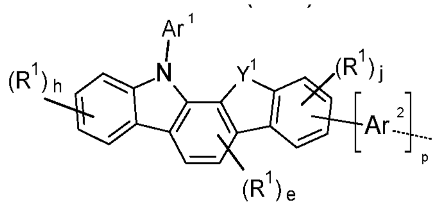

formula (H-11)

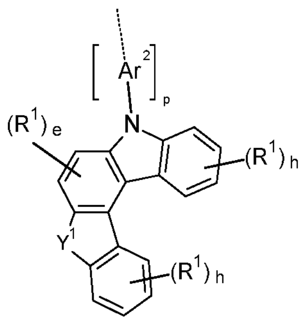

formula (H-12)

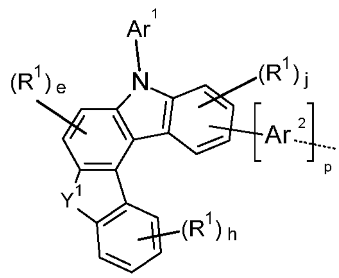

formula (H-13)

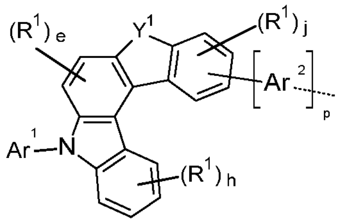

formula (H-14)

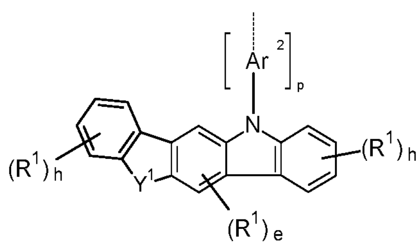

formula (H-15)

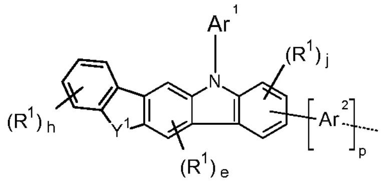

formula (H-16)

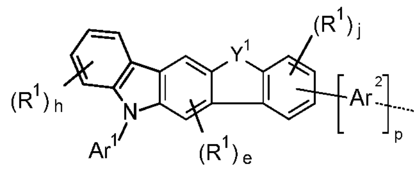

formula (H-17)

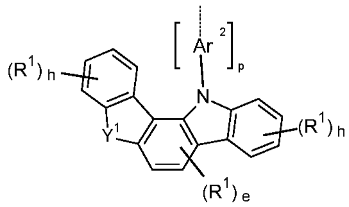

formula (H-18)

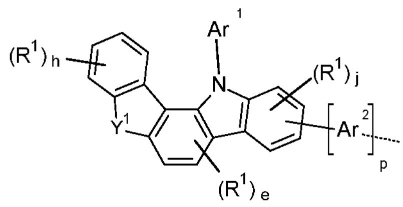

formula (H-19)

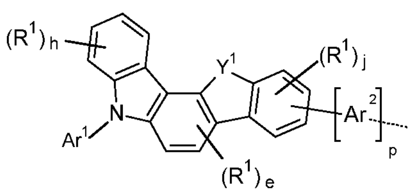

formula (H-20)

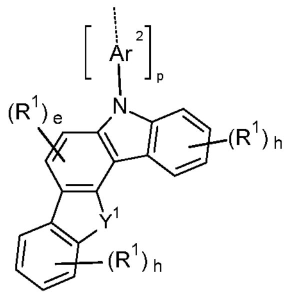

formula (H-21)

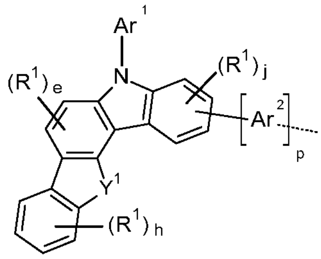

formula (H-22)

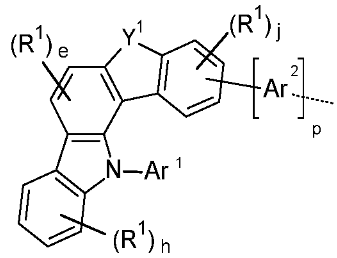

formula (H-23)

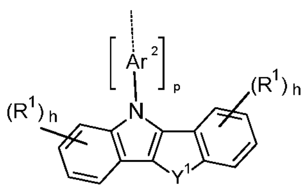

formula (H-24)

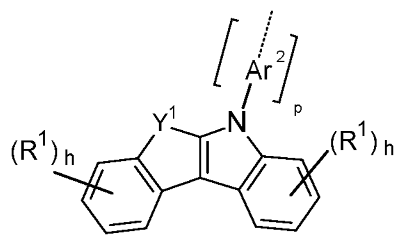

formula (H-25)

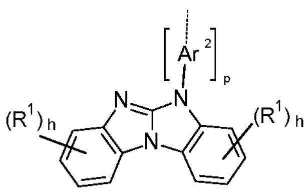

formula (H-26)

where Y’ represents O, S, $C(R^1)_2$ or $NAr^1$, the dashed bond marks the bonding position, e is 0, 1 or 2, j is 0, 1, 2 or 3, h is 0, 1, 2, 3 or 4, p is 0 or 1, $Ar^1$, $Ar^2$ and $R^1$ have the meaning given in Claim 6.

8. Use according to at least one of the preceding claims, **characterised in that** the compound comprises a radical comprising an electron-transport group, where preferably one of the groups $R^a$, $R^b$, $R^c$ and/or R comprises, preferably represents, a radical comprising an electron-transport group.

9. Use according to Claim 8, **characterised in that** the electron-transport group is selected from structures of the formulae (Q-11), (Q-12), (Q-13), (Q-14) and/or (Q-15)

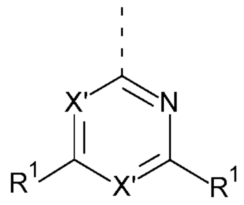
formula (Q-11)

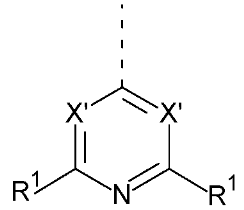
formula (Q-12)

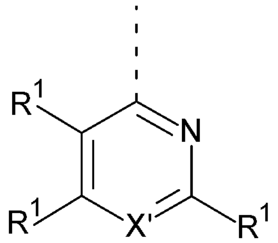
formula (Q-13)

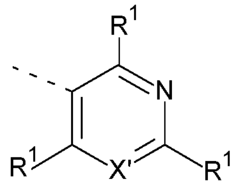
formula (Q-14)

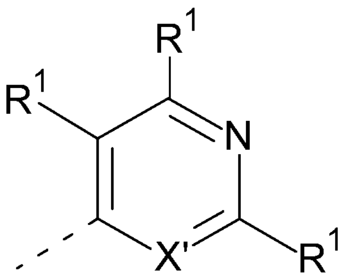
formula (Q-15)

where the symbol $R^1$ has the meaning given above in Claim 1, X' is N or $CR^1$ and the dashed bond marks the bonding position, where X' preferably represents a nitrogen atom.

10. Use according to Claim 8 or 9, **characterised in that** the electron-transport group is selected from structures of the formulae (Q-26), (Q-27), (Q-28), (Q-29) and/or (Q-30),

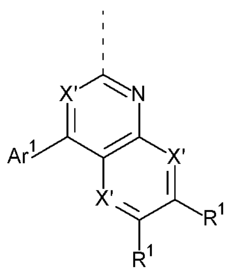
formula (Q-26)

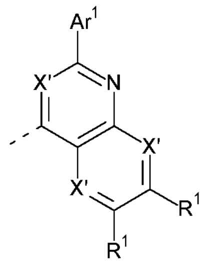
formula (Q-27)

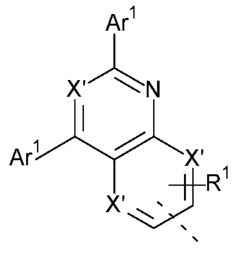

formula (Q-28)

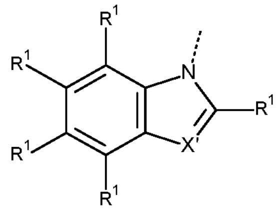

formula (Q-29)

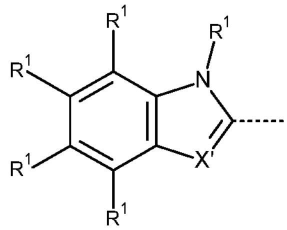

formula (Q-30)

where the symbols $Ar^1$ and $R^1$ have the meanings given above in Claim 1 or 6, X' is N or $CR^1$ and the dashed bond marks the bonding position, where preferably precisely one X' represents a nitrogen atom.

11. Use according to at least one of the preceding claims, **characterised in that** at least one of the radicals $R^a$, $R^b$, $R^c$ and/or R comprises at least one aromatic or heteroaromatic ring system having two, preferably having three, condensed aromatic or heteroaromatic rings.

12. Use according to Claim 11, **characterised in that** the aromatic or heteroaromatic ring system having two, preferably having three, condensed aromatic or heteroaromatic rings is selected from the groups of the formulae (Ar-1) to (Ar-17)

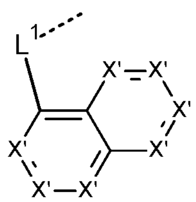

(Ar-1)

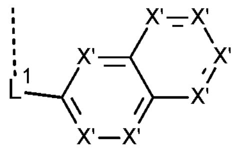

(Ar-2)

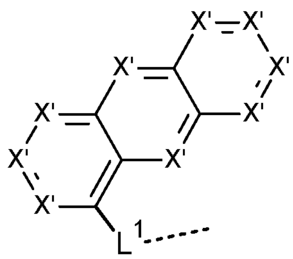

(Ar-3)

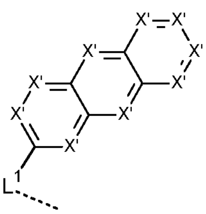

(Ar-4)

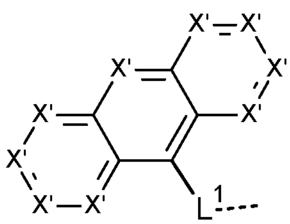

(Ar-5)

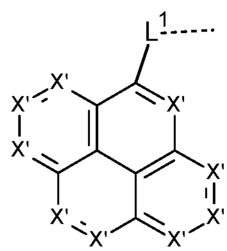

(Ar-6)

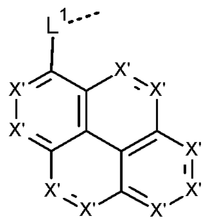
(Ar-7)

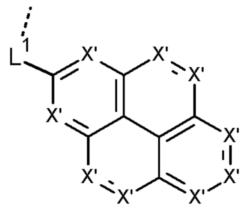
(Ar-8)

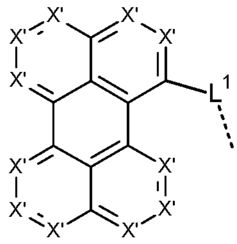
(Ar-9)

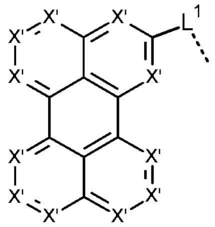
(Ar-10)

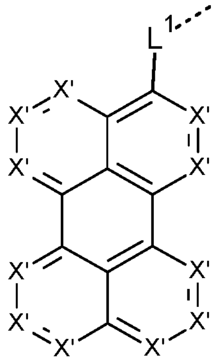
(Ar-11)

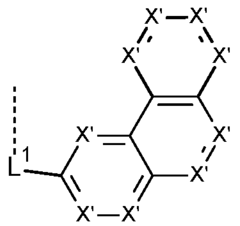
(Ar-12)

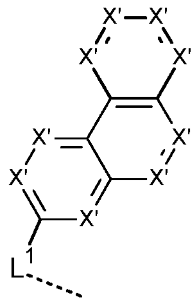
(Ar-13)

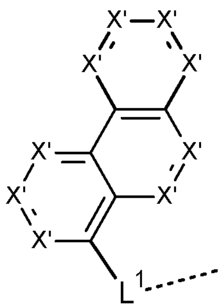
(Ar-14)

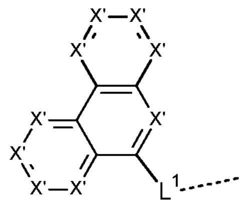
(Ar-15)

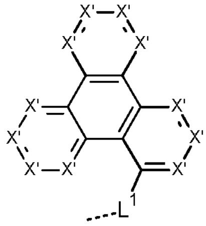
(Ar-16)

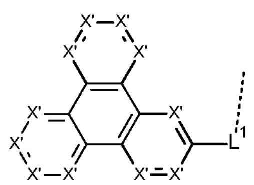
(Ar-17)

where X' is N or $CR^1$, preferably $CR^1$, $L^1$ represents a bond or an aromatic or heteroaromatic ring system having 5 to 40, preferably 5 to 30, aromatic ring atoms, which may be substituted by one or more radicals $R^1$, $R^1$ has the meaning explained in Claim 1 and the dashed bond marks the bonding position.

**13.** Composition comprising a combination comprising

A) one or more compounds comprising at least one structure of the formula (I), preferably one or more compounds of the formula (I),

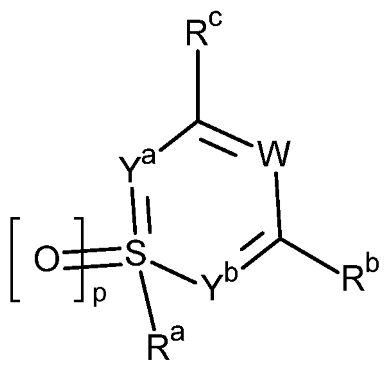

formula (I)

where the symbols p, $R^a$, $R^b$, $R^c$, $Y^a$, $Y^b$ and W have the meaning given in Claim 1
B) a further compound selected from the group consisting of fluorescent emitters, phosphorescent emitters, emitters which exhibit TADF (thermally activated delayed fluorescence), host materials, exciton-blocking materials, electron-injection materials, electron-transport materials, electron-blocking materials, hole-injection materials, hole-conductor materials, hole-blocking materials, quantum materials, n-dopants, p-dopants, wide band gap materials and/or charge-generation materials.

**14.** Compound comprising at least one structure of the formula (III), preferably compound of the formula (III),

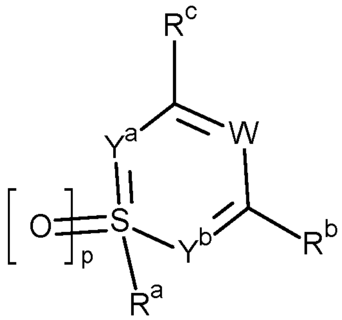

formula (III)

where the symbols p, $R^a$, $R^b$, $R^c$, $Y^a$, $Y^b$ and W have the meaning given in Claim 1 and at least one of the radicals $R^a$, $R^b$, $R^c$, $Y^a$, $Y^b$ and W comprises or represents a group HetAr, where HetAr stands for a group selected from the formulae (H-1) to (H-26) defined in Claims 6 and 7 or selected from the formulae (Q-11) to (Q-30) defined in Claims 9 and 10, where the group HetAr may form a ring system with a radical R, a group $R^a$, $R^b$, $R^c$, $Y^a$, $Y^b$ or a further group.

**15.** Compound comprising at least one structure of the formula (V), preferably compound of the formula (V),

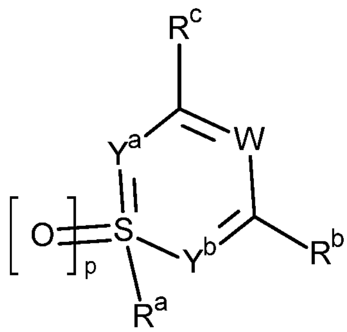

formula (V)

where the symbols p, $R^a$, $R^b$, $R^c$, $Y^a$, $Y^b$ and W have the meaning given in Claim 1 and at least one of the radicals $R^a$, $R^b$, $R^c$, $Y^a$, $Y^b$ and W comprises or represents a group KonAr, where KonAr stands for a group selected from the formulae (Ar-3) to (Ar-17) defined in Claim 12, where KonAr may be substituted by one or more radicals $R^1$, where the group KonAr may form a ring system with a radical R, a group $R^a$, $R^b$, $R^c$, $Y^a$, $Y^b$ or a further group.

**16.** Compound comprising precisely two, precisely three or precisely four structures of the formula (I) defined in Claim 1 and/or of the formulae (II-1) to (II-11) defined in Claim 3.

**17.** Oligomers, polymers or dendrimers comprising at least one compound whose use is defined in one or more of Claims 1 to 12 or a compound according to Claim 14 or 15 in which, instead of a hydrogen atom or a substituent, one or more bonds are present to the polymer, oligomer or dendrimer.

**18.** Formulation comprising one or more compounds according to Claim 14 or 15, an oligomer, polymer or dendrimer according to Claim 17 or a composition according to Claim 13 and at least one solvent.

**19.** Electronic device containing at least one compound whose use is defined in one or more of Claims 1 to 12, a compound according to one or more of Claims 14 to 16, an oligomer, polymer or dendrimer according to Claim 17 or a composition according to Claim 13, where the electronic device is preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes.

**20.** Electronic device according to Claim 19, which is an electroluminescent device, preferably selected from the group consisting of organic light-emitting diodes (OLEDs), polymeric light-emitting diodes (PLEDs) and organic light-emitting electrochemical cells (OLECs).

**Revendications**

**1.** Utilisation d'un composé comprenant au moins une structure de formule (I), préférablement un composé de formule (I),

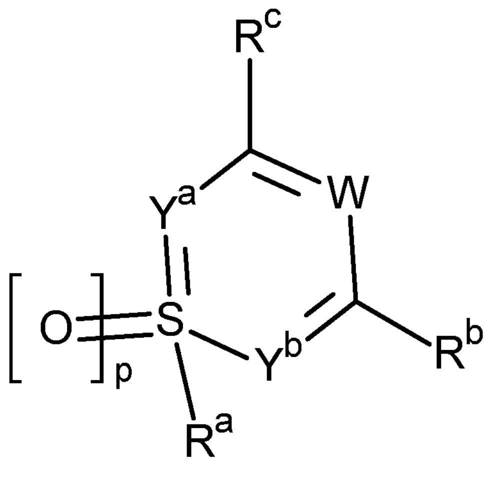

formule (I)

dans laquelle ce qui suit s'applique :

W est CR, N, $SR^a$ ou $S(=O)R^a$ ;
$Y^a$, $Y^b$ représentent, de manière identique ou différente, CR ou N ;
p vaut 0 ou 1, à condition que p=1 si les groupements W, $Y^a$, $Y^b$ représentent chacun CR ;
$R^a$, $R^b$, $R^c$, sont, de manière identique ou différente, $N(Ar')_2$, $N(R^1)_2$ ou un noyau aromatique ou hétéroaromatique ayant de 5 à 60 atomes de cycle aromatique, qui peut dans chaque cas être substitué par un ou plusieurs radicaux $R^1$, ou un groupement aryloxy ou hétéroaryloxy ayant de 5 à 60 atomes de cycle aromatique, qui peut

être substitué par un ou plusieurs radicaux $R^1$ ; les radicaux $R^a$, $R^b$, $R^c$ peuvent former un noyau avec un groupement supplémentaire ;

R est à chaque occurrence, de manière identique ou différente, H, D, OH, F, Cl, Br, I, CN, $NO_2$, $N(Ar')_2$, $N(R^1)_2$, $C(=O)N(Ar')_2$, $C(=O)N(R^1)_2$, $C(Ar')_3$, $C(R^1)_3$, $Si(Ar')_3$, $Si(R^1)_3$, $B(Ar')_2$, $B(R^1)_2$, C(=O)Ar', $C(=O)R^1$, $P(=O)(Ar')_2$, $P(=O)(R^1)_2$, $P(Ar')_2$, $P(R^1)_2$, S(=O)Ar', $S(=O)R^1$, $S(=O)_2Ar'$, $S(=O)_2R^1$, $OSO_2Ar'$, $OSO_2R^1$, un groupement alkyle, alcoxy ou thioalcoxy à chaîne linéaire ayant de 1 à 40 atomes de C ou un groupement alcényle ou alcynyle ayant de 2 à 40 atomes de C ou un groupement alkyle, alcoxy ou thioalcoxy ramifié ou cyclique ayant de 3 à 20 atomes de C, où le groupement alkyle, alcoxy, thioalcoxy, alcényle ou alcynyle peut dans chaque cas être substitué par un ou plusieurs radicaux $R^1$, où un ou plusieurs groupements $CH_2$ non adjacents peuvent être remplacés par $R^1C=CR^1$, C=C, $Si(R^1)_2$, C=O, C=S, C=Se, $C=NR^1$, -C(=O)O-, -C(=O)NR'-, $NR^1$, P(=O)(R'), -O-, -S-, SO ou $SO_2$, ou un noyau aromatique ou hétéroaromatique ayant de 5 à 60 atomes de cycle aromatique, qui peut dans chaque cas être substitué par un ou plusieurs radicaux $R^1$, ou un groupement aryloxy ou hétéroaryloxy ayant de 5 à 60 atomes de cycle aromatique, qui peut être substitué par un ou plusieurs radicaux $R^1$ ; deux radicaux R peuvent également former un noyau l'un avec l'autre ou un groupement supplémentaire, par exemple avec un ou plusieurs parmi les radicaux $R^a$, $R^b$, $R^c$ ;

Ar' est à chaque occurrence, de manière identique ou différente, un noyau aromatique ou hétéroaromatique ayant de 5 à 60 atomes de cycle aromatique, qui peut être substitué par un ou plusieurs radicaux $R^1$, deux radicaux Ar' qui sont liés au même atome de C, atome de Si, atome de N, atome de P ou atome de B peuvent également être pontés l'un à l'autre par une liaison simple ou un pont choisi parmi $B(R^1)$, $C(R^1)_2$, $Si(R^1)_2$, C=O, $C=NR^1$, $C=C(R^1)_2$, O, S, S=O, $SO_2$, $N(R^1)$, $P(R^1)$ et $P(=O)R^1$ ;

$R^1$ est à chaque occurrence, de manière identique ou différente, H, D, F, Cl, Br, I, CN, $NO_2$, $N(Ar'')_2$, $N(R^2)_2$, C(=O)Ar'', $C(=O)R^2$, $P(=O)(Ar'')_2$, $P(Ar'')_2$, $B(Ar'')_2$, $B(R^2)_2$, $C(Ar'')_3$, $C(R^2)_3$, $Si(Ar'')_3$, $Si(R^2)_3$, un groupement alkyle, alcoxy ou thioalcoxy à chaîne linéaire ayant de 1 à 40 atomes de C ou un groupement alkyle, alcoxy ou thioalcoxy ramifié ou cyclique ayant de 3 à 40 atomes de C ou un groupement alcényle ayant de 2 à 40 atomes de C, qui peut dans chaque cas être substitué par un ou plusieurs radicaux $R^2$, où un ou plusieurs groupements $CH_2$ non adjacents peuvent être remplacés par $-R^2C=CR^2-$, -C=C-, $Si(R^2)_2$, C=O, C=S, C=Se, $C=NR^2$, -C(=O)O-, $-C(=O)NR^2-$, $NR^2$, $P(=O)(R^2)$, -O-, -S-, SO ou $SO_2$ et où un ou plusieurs atomes de H peuvent être remplacés par D, F, Cl, Br, I, CN ou $NO_2$, ou un noyau aromatique ou hétéroaromatique ayant de 5 à 60 atomes de cycle aromatique, qui peut dans chaque cas être substitué par un ou plusieurs radicaux $R^2$, ou un groupement aryloxy ou hétéroaryloxy ayant de 5 à 60 atomes de cycle aromatique, qui peut être substitué par un ou plusieurs radicaux $R^2$, ou un groupement aralkyle ou hétéroaralkyle ayant de 5 à 60 atomes de cycle aromatique, qui peut être substitué par un ou plusieurs radicaux $R^2$, ou une combinaison de ces systèmes ; deux, ou plus, radicaux $R^1$, préférablement adjacents, peuvent former un noyau les uns avec les autres, un ou plusieurs radicaux $R^1$ peuvent former un noyau avec une autre partie du composé ;

Ar'' est à chaque occurrence, de manière identique ou différente, un noyau aromatique ou hétéroaromatique ayant de 5 à 30 atomes de cycle aromatique, qui peut être substitué par un ou plusieurs radicaux $R^2$, deux radicaux Ar'' qui sont liés au même atome de C, atome de Si, atome de N, atome de P ou atome de B peuvent également être pontés l'un à l'autre par une liaison simple ou un pont choisi parmi $B(R^2)$, $C(R^2)_2$, $Si(R^2)_2$, C=O, $C=NR^2$, $C=C(R^2)_2$, O, S, S=O, $SO_2$, $N(R^2)$, $P(R^2)$ et $P(=O)R^2$ ;

$R^2$ est choisi à chaque occurrence, de manière identique ou différente, dans le groupe constitué par H, D, F, CN, un radical hydrocarboné aliphatique ayant de 1 à 20 atomes de C ou un noyau aromatique ou hétéroaromatique ayant de 5 à 30 atomes de cycle aromatique, où un ou plusieurs atomes de H peuvent être remplacés par D, F, Cl, Br, I ou CN et qui peut être substitué par un ou plusieurs groupements alkyle, chacun ayant de 1 à 4 atomes de carbone, deux, ou plus, substituants $R^2$, préférablement adjacents, peuvent former un noyau les uns avec les autres ;

dans un dispositif électronique organique.

2. Utilisation selon la revendication 1, **caractérisée en ce que** le composé comprenant les structures de formule (I), préférablement les composés de formule (I), dans un dispositif électronique organique comme émetteur fluorescent, émetteur phosphorescent, émetteur présentant une TADF (fluorescence retardée activée thermiquement), matériau hôte, matériau de blocage d'excitons, matériau d'injection d'électrons, matériau de transport d'électrons, matériau de blocage d'électrons, matériau d'injection de trous, matériau conducteur de trous, matériau de blocage de trous, dopant de type N, dopant de type P, matériau à large bande interdite et/ou matériau générateur de charges, préférablement comme matériau hôte, matériau de transport d'électrons et/ou matériau de blocage de trous, particulièrement préférablement comme matériau hôte pour les émetteurs phosphorescents et particulièrement préférablement comme matériau hôte pour les émetteurs phosphorescents bleus.

3. Utilisation selon la revendication 1 ou 2, **caractérisée en ce que** le composé comprend au moins une structure de

formules (II-1), (II-2), (II-3), (II-4), (II-5), (II-6), (II-7), (II-8), (II-9), (II-10) et (II-11), préférablement choisie parmi les composés de formules (II-1), (II-2), (II-3), (II-4), (II-5), (II-6), (II-7), (II-8), (II-9), (II-10) et (II-11),

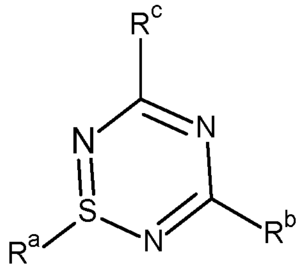

formule (II-1)

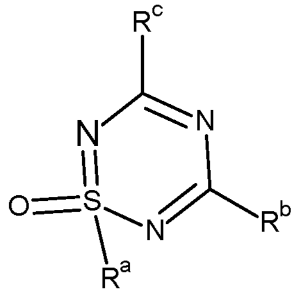

formule (II-2)

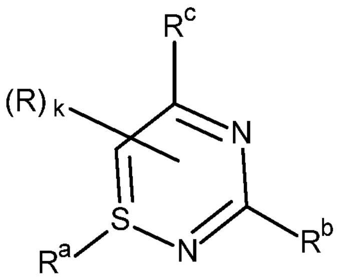

formule (II-3)

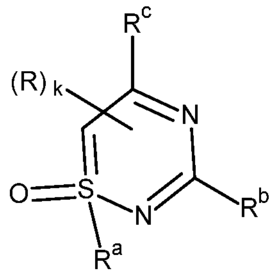

formule (II-4)

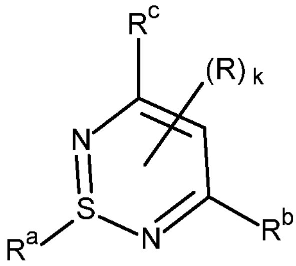

formule (II-5)

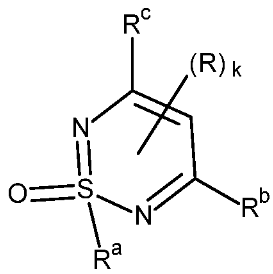

formule (II-6)

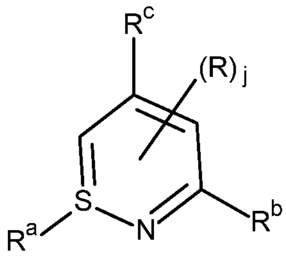

formule (II-7)

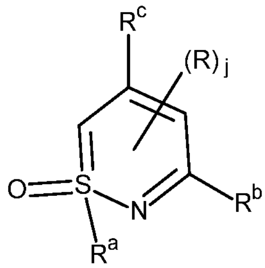

formule (II-8)

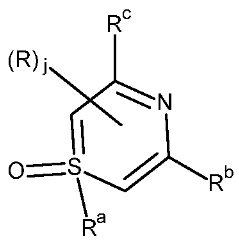

formule (II-9)

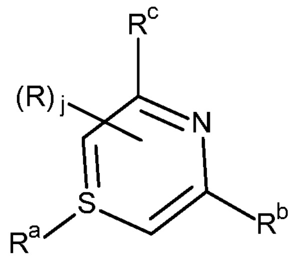

formule (II-10)

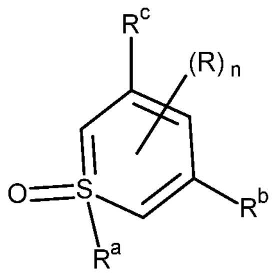

formule (II-11)

dans lesquelles les radicaux $R^a$, $R^b$, $R^c$ et R revêtent la signification donnée selon la revendication 1, l'indice n vaut 0, 1, 2 ou 3, préférablement 0, 1 ou 2, l'indice j vaut 0, 1 ou 2 et l'indice k vaut 0 ou 1.

4. Utilisation selon l'une ou plusieurs parmi les revendications précédentes, **caractérisée en ce qu'**au moins l'un parmi les radicaux $R^a$, $R^b$, $R^c$ et/ou R est choisi dans le groupe constitué par les phényles, les fluorènes, les indénofluorènes, les spirobifluorènes, les carbazoles, les indénocarbazoles, les indolocarbazoles, les spirocarbazoles, les pyrimidines, les triazines, les quinazolines, les quinoxalines, les pyridines, les quinoléines, les isoquinoléines, les lactames, les triarylamines, les dibenzofuranes, les dibenzothiènes, les imidazoles, les benzimidazoles, les benzoxazoles, les benzothiazoles, les 5-aryl-phénanthridin-6-ones, les 9,10-déshydrophénanthrènes, les fluoranthènes, les naphtalènes, les phénanthrènes, les anthracènes, les benzanthracènes, les fluoradènes, les pyrènes, les pérylènes, les chrysènes, les borazines, les boroxines, les boroles, les borazoles, les azaboroles, les cétones, les oxydes de phosphine, les arylsilanes, les siloxanes et des combinaisons de ceux-ci.

5. Utilisation selon au moins l'une parmi les revendications précédentes, **caractérisée en ce que** le composé comprend un groupement de transport de trous, où préférablement l'un parmi les radicaux $R^a$, $R^b$, $R^c$ et/ou R comprend, préférablement représente, un groupement de transport de trous.

6. Utilisation selon la revendication 5, **caractérisée en ce que** le groupement de transport de trous comprend un groupement, préférablement représente un groupement, choisi parmi les formules (H-1) à (H-3)

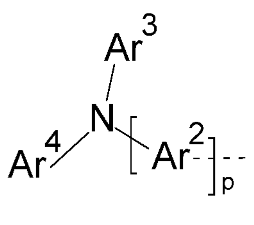

formule (H-1)

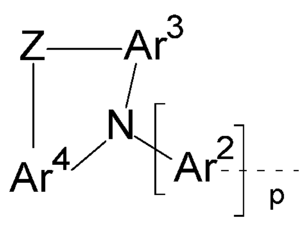

formule (H-2)

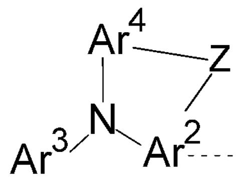

formule (H-3)

dans lesquelles la ligne en pointillés marque la position de liaison et les symboles revêtent la signification suivante :

$Ar^2$, $Ar^3$, $Ar^4$ sont indépendamment dans chaque cas un noyau aromatique ayant de 6 à 40 atomes de C ou un noyau hétéroaromatique ayant de 3 à 40 atomes de C, qui peut dans chaque cas être substitué par un ou plusieurs radicaux $R^1$ ;
p vaut 0 ou 1 ;
Z représente une liaison ou $C(R^1)_2$, $Si(R^1)_2$, C=O, $NR^1$, $NAr^1$, $BR^1$, $PR^1$, $PO(R^1)$, SO, $SO_2$, Se, O ou S, préférablement une liaison ou $C(R^1)_2$, $NAr^1$, O ou S ;
où $Ar^1$ est un noyau aromatique ayant de 6 à 40 atomes de C ou un noyau hétéroaromatique ayant de 3 à 40 atomes de C, qui peut être substitué par un ou plusieurs radicaux $R^1$, et le radical $R^1$ revêt la signification expliquée ci-dessus, en particulier selon la revendication 1.

**7.** Utilisation selon la revendication 5 ou 6, **caractérisée en ce que** le groupement de transport de trous comprend un groupement, préférablement représente un groupement, choisi parmi les formules (H-4) à (H-26)

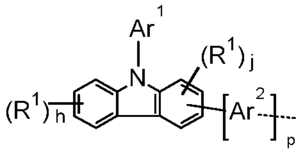

formule (H-4)

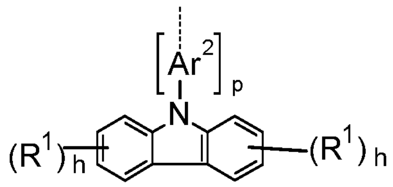

formule (H-5)

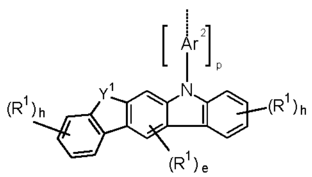

formule (H-6)

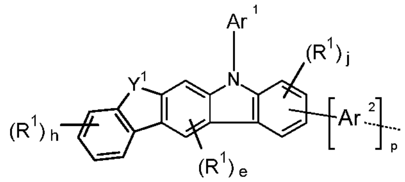

formule (H-7)

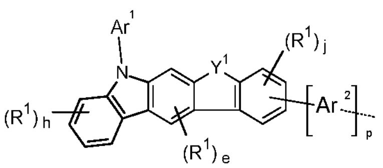

formule (H-8)

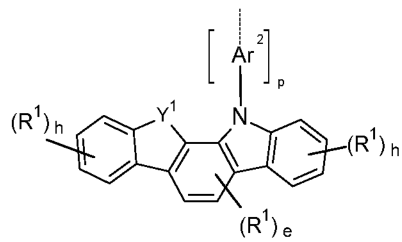

formule (H-9)

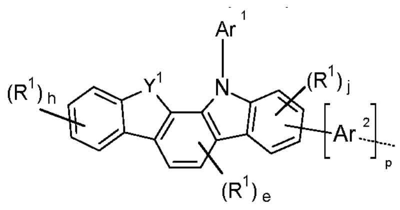

formule (H-10)

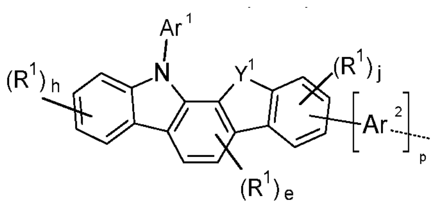

formule (H-11)

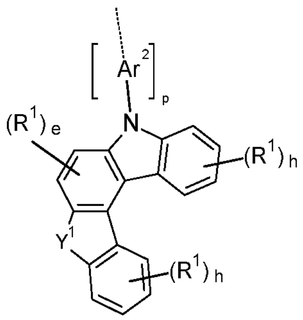

formule (H-12)

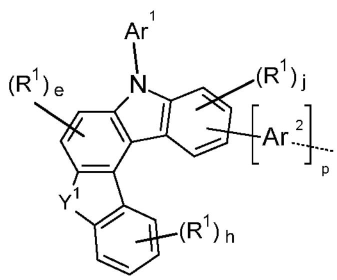

formule (H-13)

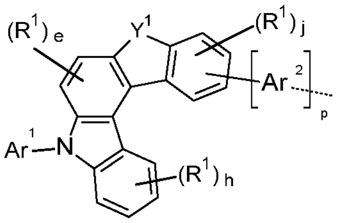

formule (H-14)

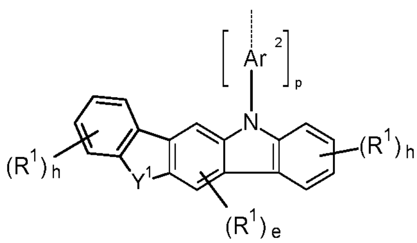

formule (H-15)

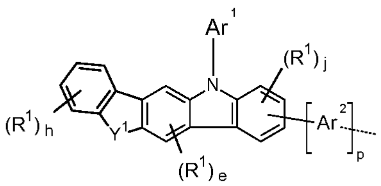

formule (H-16)

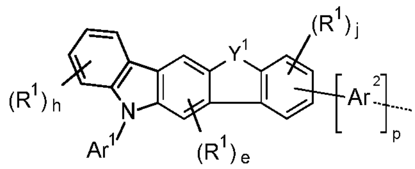

formule (H-17)

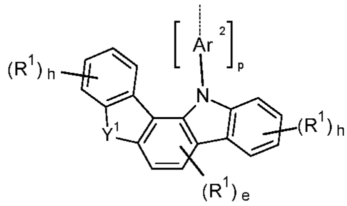

formule (H-18)

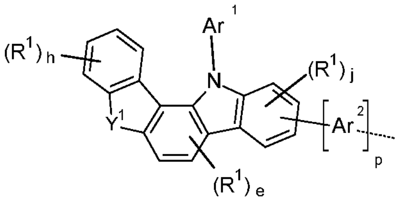

formule (H-19)

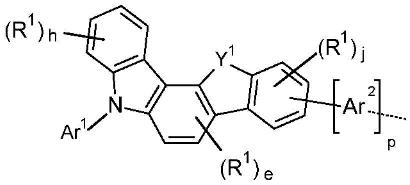

formule (H-20)

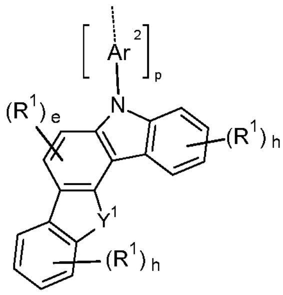

formule (H-21)

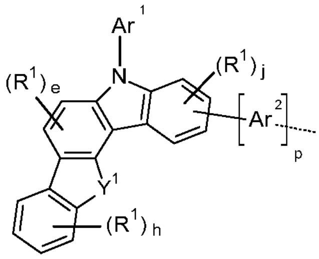

formule (H-22)

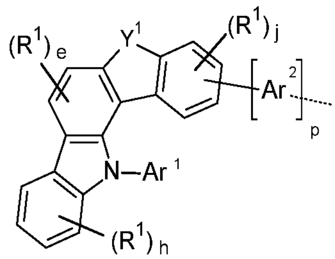

formule (H-23)

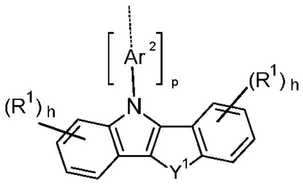

formule (H-24)

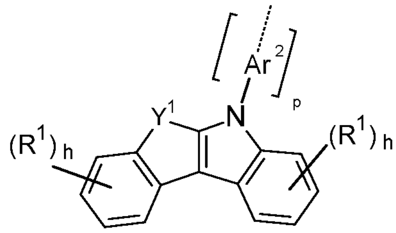

formule (H-25)

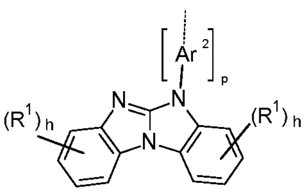

formule (H-26)

dans lesquelles Y’ représente O, S, $C(R^1)_2$ ou $NAr^1$, la liaison en pointillés marque la position de liaison, e vaut 0, 1 ou 2, j vaut 0, 1, 2 ou 3, h vaut 0, 1, 2, 3 ou 4, p vaut 0 ou 1, $Ar^1$, $Ar^2$ et $R^1$ revêtent la signification donnée selon la revendication 6.

8. Utilisation selon au moins l’une parmi les revendications précédentes, **caractérisée en ce que** le composé comprend un radical comprenant un groupement de transport d’électrons, où préférablement l’un des groupements $R^a$, $R^b$, $R^c$ et/ou R comprend, préférablement représente, un radical comprenant un groupement de transport d’électrons.

9. Utilisation selon la revendication 8, **caractérisée en ce que** le groupement de transport d’électrons est choisi parmi les structures de formules (Q-11), (Q-12), (Q-13), (Q-14) et/ou (Q-15)

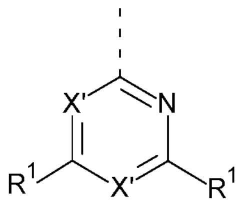

formule (Q-11)

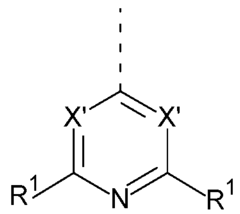

formule (Q-12)

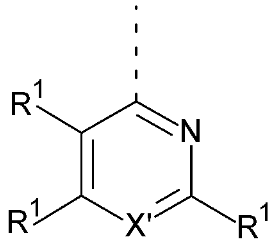

formule (Q-13)

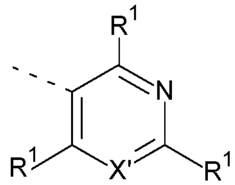

formule (Q-14)

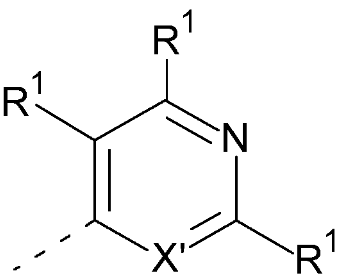

formule (Q-15)

dans lesquelles le symbole $R^1$ revêt la signification donnée ci-dessus selon la revendication 1, X' est N ou $CR^1$ et la liaison en pointillés marque la position de liaison, où X' représente préférablement un atome d'azote.

**10.** Utilisation selon la revendication 8 ou 9, **caractérisée en ce que** le groupement de transport d'électrons est choisi parmi les structures de formules (Q-26), (Q-27), (Q-28), (Q-29) et/ou (Q-30),

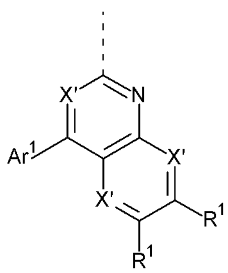

formule (Q-26)

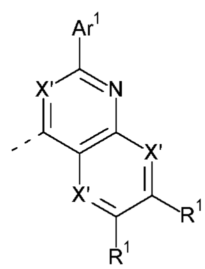

formule (Q-27)

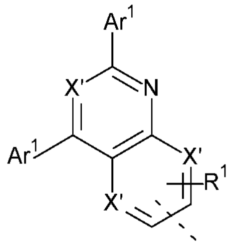
formule (Q-28)

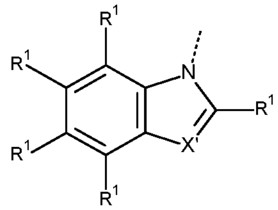
formule (Q-29)

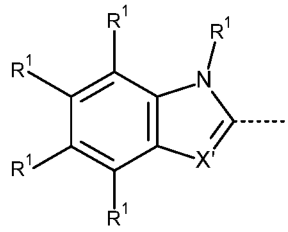
formule (Q-30)

dans lesquelles les symboles $Ar^1$ et $R^1$ revêtent les significations données ci-dessus selon la revendication 1 ou 6, X' est N ou $CR^1$ et la liaison en pointillés marque la position de liaison, où préférablement précisément un seul X' représente un atome d'azote.

**11.** Utilisation selon au moins l'une parmi les revendications précédentes, **caractérisée en ce qu'**au moins l'un parmi les radicaux $R^a$, $R^b$, $R^c$ et/ou R comprend au moins un noyau aromatique ou hétéroaromatique ayant deux, préférablement ayant trois, cycles aromatiques ou hétéroaromatiques condensés.

**12.** Utilisation selon la revendication 11, **caractérisée en ce que** le noyau aromatique ou hétéroaromatique ayant deux, préférablement ayant trois, cycles aromatiques ou hétéroaromatiques condensés est choisi parmi les groupements de formules (Ar-1) à (Ar-17)

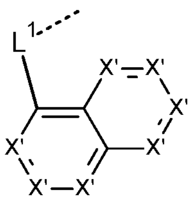
(Ar-1)

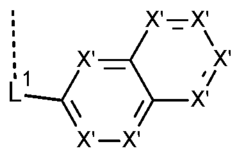
(Ar-2)

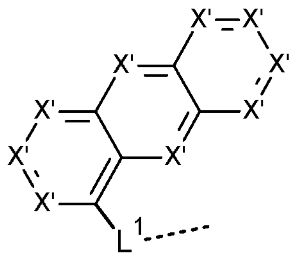
(Ar-3)

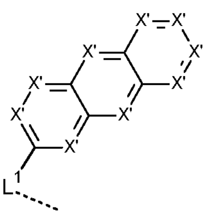
(Ar-4)

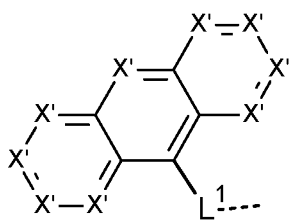
(Ar-5)

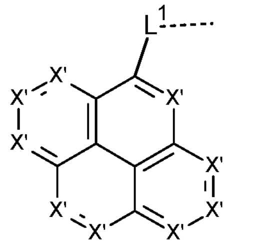
(Ar-6)

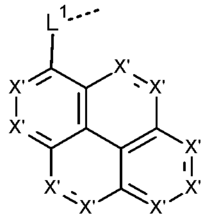

(Ar-7)

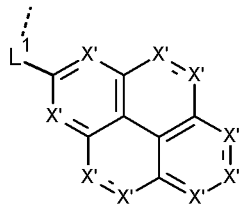

(Ar-8)

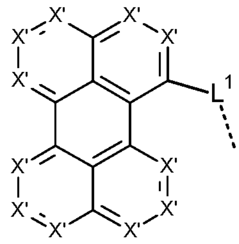

(Ar-9)

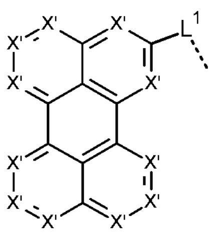

(Ar-10)

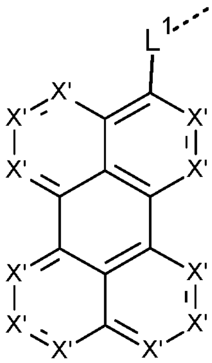

(Ar-11)

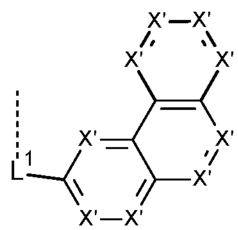

(Ar-12)

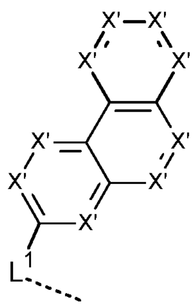

(Ar-13)

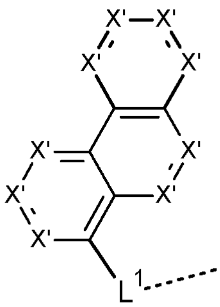

(Ar-14)

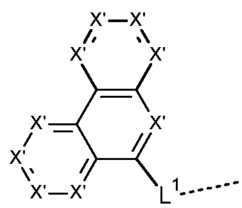

(Ar-15)

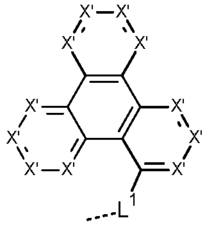

(Ar-16)

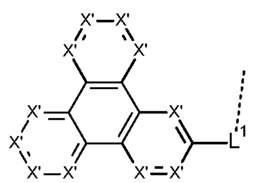

(Ar-17)

dans lesquelles X’ est N ou $CR^1$, préférablement $CR^1$, $L^1$ représente une liaison ou un noyau aromatique ou hétéroaromatique ayant de 5 à 40, préférablement de 5 à 30, atomes de cycle aromatique, qui peut être substitué par un ou plusieurs radicaux $R^1$, $R^1$ revêt la signification expliquée selon la revendication 1 et la liaison en pointillés marque la position de liaison.

**13.** Composition comprenant une combinaison comprenant

A) un ou plusieurs composés comprenant au moins une structure de formule (I), préférablement un ou plusieurs

composés de formule (I),

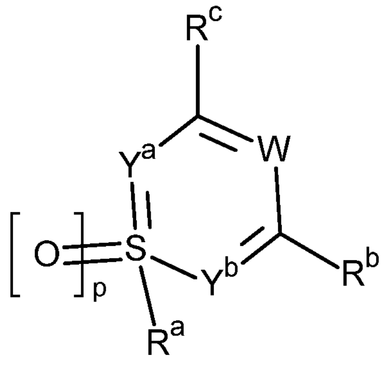

formule (I)

dans laquelle les symboles p, $R^a$, $R^b$, $R^c$, $Y^a$, $Y^b$ et W revêtent la signification donnée selon la revendication 1
B) un composé supplémentaire choisi dans le groupe constitué par les émetteurs fluorescents, les émetteurs phosphorescents, les émetteurs présentant une TADF (fluorescence retardée activée thermiquement), les matériaux hôtes, les matériaux de blocage d'excitons, les matériaux d'injection d'électrons, les matériaux de transport d'électrons, les matériaux de blocage d'électrons, les matériaux d'injection de trous, les matériaux conducteurs de trous, les matériaux de blocage de trous, les matériaux quantiques, les dopants de type N, les dopants de type P, les matériaux à large bande interdite et/ou les matériaux générateurs de charges.

**14.** Composé comprenant au moins une structure de formule (III), préférablement un composé de formule (III),

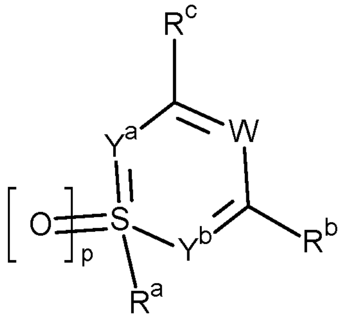

formule (III)

dans laquelle les symboles p, $R^a$, $R^b$, $R^c$, $Y^a$, $Y^b$ et W revêtent la signification donnée selon la revendication 1 et au moins l'un parmi les radicaux $R^a$, $R^b$, $R^c$, $Y^a$, $Y^b$ et W comprend ou représente un groupement HetAr, où HetAr représente un groupement choisi parmi les formules (H-1) à (H-26) définies selon les revendications 6 et 7 ou choisi parmi les formules (Q-11) à (Q-30) définies selon les revendications 9 et 10, où le groupement HetAr peut former un noyau avec un radical R, un groupement $R^a$, $R^b$, $R^c$, $Y^a$, $Y^b$ ou un groupement supplémentaire.

**15.** Composé comprenant au moins une structure de formule (V), préférablement un composé de formule (V),

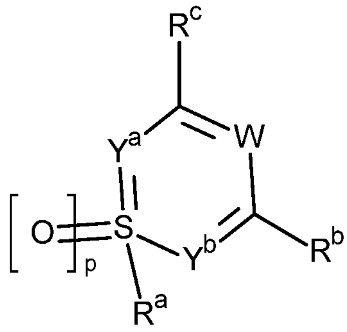

formule (V)

dans laquelle les symboles p, $R^a$, $R^b$, $R^c$, $Y^a$, $Y^b$ et W revêtent la signification donnée selon la revendication 1 et au moins l'un parmi les radicaux $R^a$, $R^b$, $R^c$, $Y^a$, $Y^b$ et W comprend ou représente un groupement KonAr, où KonAr représente un groupement choisi parmi les formules (Ar-3) à (Ar-17) définies selon la revendication 12, où KonAr peut être substitué par un ou plusieurs radicaux $R^1$, où le groupement KonAr peut former un noyau avec un radical R, un groupement $R^a$, $R^b$, $R^c$, $Y^a$, $Y^b$ ou un groupement supplémentaire.

**16.** Composé comprenant précisément deux, précisément trois ou précisément quatre structures de formule (I) définie selon la revendication 1 et/ou de formules (II-1) à (II-11) définies selon la revendication 3.

**17.** Oligomères, polymères ou dendrimères comprenant au moins un composé dont l'utilisation est définie selon l'une ou plusieurs parmi les revendications 1 à 12 ou un composé selon la revendication 14 où 15, au lieu d'un atome d'hydrogène ou d'un substituant, une ou plusieurs liaisons sont présentes avec le polymère, l'oligomère ou le dendrimère.

**18.** Formulation comprenant un ou plusieurs composés selon la revendication 14 où 15, un oligomère, polymère ou dendrimère selon la revendication 17 ou une composition selon la revendication 13, et au moins un solvant.

**19.** Dispositif électronique contenant au moins un composé dont l'utilisation est définie selon l'une ou plusieurs parmi les revendications 1 à 12, un composé selon l'une ou plusieurs parmi les revendications 14 à 16, un oligomère, polymère ou dendrimère selon la revendication 17 ou une composition selon la revendication 13, le dispositif électronique étant préférablement choisi dans le groupe constitué par les dispositifs électroluminescents organiques, les circuits intégrés organiques, les transistors organiques à effet de champ, les transistors organiques en couche mince, les transistors organiques émetteurs de lumière, les cellules solaires organiques, les détecteurs optiques organiques, les photorécepteurs organiques, les dispositifs organiques à extinction de champ, les cellules électrochimiques émettrices de lumière ou les diodes laser organiques.

**20.** Dispositif électronique selon la revendication 19, qui est un dispositif électroluminescent, préférablement choisi dans le groupe constitué par les diodes électroluminescentes organiques (OLED), les diodes électroluminescentes polymères (PLED) et les cellules électrochimiques organiques émettrices de lumière (OLEC).

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 2010151006 A1
- EP 842208 A
- WO 2000022026 A
- EP 707020 A
- EP 894107 A
- WO 2006061181 A
- WO 9218552 A
- WO 2004070772 A
- WO 2004113468 A
- EP 1028136 A
- WO 2005014689 A
- WO 2004041901 A
- WO 2004113412 A
- WO 2005040302 A
- WO 2005104264 A
- WO 2007017066 A
- US 7294849 B
- WO 0070655 A
- WO 200141512 A
- WO 200202714 A
- WO 200215645 A
- EP 1191613 A
- EP 1191612 A
- EP 1191614 A
- WO 05033244 A
- WO 05019373 A
- US 20050258742 A
- WO 2009146770 A
- WO 2010015307 A
- WO 2010031485 A
- WO 2010054731 A
- WO 2010054728 A
- WO 2010086089 A
- WO 2010099852 A
- WO 2010102709 A
- WO 2011032626 A
- WO 2011066898 A
- WO 2011157339 A
- WO 2012007086 A
- WO 2014008982 A
- WO 2014023377 A
- WO 2014094961 A
- WO 2014094960 A
- WO 2015036074 A
- WO 2015104045 A
- WO 2015117718 A
- WO 2016015815 A
- WO 2016124304 A
- WO 2017032439 A
- WO 2018011186 A
- WO 2018001990 A
- WO 2018019687 A
- WO 2018019688 A
- WO 2018041769 A
- WO 2018054798 A
- WO 2018069196 A
- WO 2018069197 A
- WO 2018069273 A
- WO 2018178001 A
- WO 2018177981 A
- WO 2019020538 A
- WO 2019115423 A
- WO 2019158453 A
- WO 2019179909 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- WO 2013041176 A
- WO 2007063754 A
- WO 2008056746 A
- WO 2010136109 A
- WO 2011000455 A
- WO 2013056776 A
- EP 1617710 A
- EP 1617711 A
- EP 1731584 A
- JP 2005347160 A
- WO 2007137725 A
- WO 2005111172 A
- WO 2006117052 A
- WO 2010015306 A
- WO 2011057706 A
- WO 2011060859 A
- WO 2011060877 A
- EP 652273 A
- WO 2009062578 A
- WO 2010054729 A
- WO 2010054730 A

- WO 2011042107 A
- WO 2011060867 A
- WO 2011088877 A
- WO 2012143080 A
- WO 2012048781 A
- WO 2015169412 A
- WO 2016015810 A
- WO 2016023608 A
- WO 2017148564 A
- WO 2017148565 A
- JP 3139321 B
- WO 2011116865 A
- WO 2011137951 A
- WO 2013064206 A
- WO 2014094963 A
- WO 2015192939 A
- WO 2010108579 A
- WO 2009124627 A
- WO 2005053051 A
- WO 2009030981 A
- WO 2004058911 A
- WO 2004037887 A
- WO 2010045729 A
- WO 2020182779 A

**In der Beschreibung aufgeführte Nicht-Patentliteratur**

- **D. M. KOLLER et al.** *Nature Photonics,* 2008, 1-4
- **Z. B. M. S. ARNOLD et al.** *Appl. Phys. Lett.,* 2008, vol. 92, 053301